# EUROPEAN PATENT APPLICATION

(11) **EP 3 522 219 A1**
(43) Date of publication of application: **07.08.2019**
(21) Application number: 17855686.6
(22) Date of filing: 11.09.2017
(51) Int. Cl.: H01L 27/146, G02B 7/34, G03B 13/36, H04N 5/369

(54) **IMAGING DEVICE AND FOCUS ADJUSTMENT DEVICE**

(30) Priority: 30.09.2016 JP 2016194623
(71) Applicant: Nikon Corporation, Tokyo 108-6290 (JP)
(72) Inventor: SEO, Takashi, Tokyo 108-6290 (JP); TAKAGI, Toru, Tokyo 108-6290 (JP); NAKAYAMA, Satoshi, Tokyo 108-6290 (JP); ANDO, Ryoji, Tokyo 108-6290 (JP); KATO, Shutaro, Tokyo 108-6290 (JP)
(74) Representative: Hoffmann Eitle
(86) International application number: PCT/JP2017/032644
(87) International publication number: WO 2018/061729

(57) **Abstract**

An image sensor includes a plurality of pixels each including: a photoelectric conversion unit that photoelectrically converts incident light and generates electric charge; a reflective unit that reflects light that has passed through the photoelectric conversion unit back to the photoelectric conversion unit; and an output unit that outputs the electric charge generated by the photoelectric conversion unit, wherein: a position of the reflective unit possessed by each of the plurality of pixels varies.

## Description

### TECHNICAL FIELD

The present invention relates to an image sensor and a focus adjustment device.

### BACKGROUND ART

An imaging device is per se known (refer to PTL1) in which a reflecting layer is provided underneath a photoelectric conversion unit, and in which light that has passed through the photoelectric conversion unit is reflected back to the photoelectric conversion unit by this reflecting layer. In the prior art, similar structures have been employed for a plurality of pixels.

### CITATION LIST

### PATENT LITERATURE

PTL1: Japanese Laid-Open Patent Publication 2010-177704.

### SUMMARY OF INVENTION

According to the 1st aspect of the present invention, an image sensor comprises a plurality of pixels each comprising: a photoelectric conversion unit that photoelectrically converts incident light and generates electric charge; a reflective unit that reflects light that has passed through the photoelectric conversion unit back to the photoelectric conversion unit; and an output unit that outputs the electric charge generated by the photoelectric conversion unit, wherein: a position of the reflective unit possessed by each of the plurality of pixels varies.

According to the 2nd aspect of the present invention, an image sensor comprises a plurality of pixels each comprising: a photoelectric conversion unit that photoelectrically converts incident light and generates electric charge; a reflective unit that reflects light that has passed through the photoelectric conversion unit back to the photoelectric conversion unit; and an output unit that is provided outside an optical path along which light that has passed through the photoelectric conversion unit is incident upon the reflective unit, and that outputs electric charge generated by the photoelectric conversion unit.

According to the 3rd aspect of the present invention, a focus adjustment device comprises: an image sensor according to the 1st or 2nd aspect; and an adjustment unit that adjusts a focused position of an imaging optical system from a signal based upon electric charge outputted from the output unit.

According to the 4th aspect of the present invention, an image sensor comprises: a first pixel including a first photoelectric conversion unit that photoelectrically converts light that has passed through a first micro lens and generates electric charge, a first reflective unit, provided at a first distance from an optical axis of the first micro lens in a direction that intersects the optical axis, and that reflects light that has passed through the first photoelectric conversion unit back to the first photoelectric conversion unit, a first output unit that outputs electric charge generated by the first photoelectric conversion unit; and a second pixel including a second photoelectric conversion unit that photoelectrically converts light that has passed through a second micro lens and generates electric charge, a second reflective unit provided at a second distance, that is different from the first distance, from an optical axis of the second micro lens in a direction intersecting the optical axis, and that reflects light that has passed through the second photoelectric conversion unit back to the second photoelectric conversion unit, and a second output unit that outputs electric charge generated by the second photoelectric conversion unit.

According to the 5th aspect of the present invention, an image sensor comprises: a first pixel including a first photoelectric conversion unit that photoelectrically converts incident light and generates electric charge, a first reflective unit, provided at a first distance from a center of the first photoelectric conversion unit, and that reflects light that has passed through the first photoelectric conversion unit back to the first photoelectric conversion unit, and a first output unit that outputs electric charge generated by the first photoelectric conversion unit; and a second pixel including a second photoelectric conversion unit that photoelectrically converts incident light and generates electric charge, a second reflective unit, provided at a second distance, which is different from the first distance, from a center of the second photoelectric conversion unit, and that reflects light that has passed through the second photoelectric conversion unit back to the second photoelectric conversion unit, and a second output unit that outputs electric charge generated by the second photoelectric conversion unit.

According to the 6th aspect of the present invention, an image sensor comprises: a first pixel comprising a first photoelectric conversion unit that photoelectrically converts light that has passed through a first micro lens and generates electric charge, a first reflective unit that reflects light that has passed through the first photoelectric conversion unit back to the first photoelectric conversion unit, and a first output unit that is provided outside an optical path along which light that has passed through the first photoelectric conversion unit is incident upon the first reflective unit, and that outputs electric charge generated by the first photoelectric conversion unit; and a second pixel comprising a second photoelectric conversion unit that photoelectrically converts light that has passed through a second micro lens and generates electric charge, a second reflective unit that reflects light that has passed through the second photoelectric conversion unit back to the second photoelectric conversion unit, and a second output unit that is provided outside an optical path along which light that has passed through the second photoelectric conversion unit is incident upon the second reflective unit, and that outputs electric charge generated by the second photoelectric conversion unit.

According to the 7th aspect of the present invention, a focus adjustment device comprises: an image sensor according to any one of the 4th through the 6th aspects; and an adjustment unit that adjusts a focused position of an imaging optical system based upon a signal based upon electric charge outputted from the first output unit, and a signal based upon electric charge outputted from the second output unit.

### BRIEF DESCRIPTION OF DRAWINGS

Fig. 1 is a figure showing the structure of principal portions of a camera;
Fig. 2 is a figure showing an example of focusing areas;
Fig. 3 is an enlarged view of a portion of an array of pixels on an image sensor;
Fig. 4(a) is an enlarged sectional view of an imaging pixel, Fig. 4(b) is an enlarged sectional view of a first focus detection pixel, and Fig. 4(c) is an enlarged sectional view of a second focus detection pixel;
Fig. 5(a) is a figure for explanation of ray bundles incident upon first focus detection pixels, and Fig. 5(b) is a figure for explanation of ray bundles incident upon second focus detection pixels;
Fig. 6(a) is an enlarged sectional view of an imaging pixel of a second variant embodiment, Fig. 6(b) is an enlarged sectional view of a first focus detection pixel of this second variant embodiment, and Fig. 6(c) is an enlarged sectional view of a second focus detection pixel of this second variant embodiment;
Fig. 7 is an enlarged view of a portion of a pixel array upon an image sensor according to a fourth variant embodiment;
Fig. 8 is an enlarged view of a portion of a pixel array upon an image sensor according to a fifth variant embodiment;
Fig. 9 is an enlarged view of a portion of a pixel array upon an image sensor according to a sixth variant embodiment;
Fig. 10 is an enlarged view of a portion of a pixel array upon an image sensor according to a seventh variant embodiment;
Fig. 11 is an enlarged view of a portion of a pixel array upon an image sensor according to a eighth variant embodiment;
Fig. 12 is an enlarged view of a portion of a pixel array upon an image sensor according to a ninth variant embodiment;
Fig. 13 is an enlarged view of a portion of a pixel array upon an image sensor according to a tenth variant embodiment;
Fig. 14 is an enlarged view of a portion of a pixel array upon an image sensor according to a eleventh variant embodiment;
Fig. 15 is an enlarged view of a portion of a pixel array upon an image sensor according to a twelfth variant embodiment;
Fig. 16 is an enlarged view of a portion of a pixel array upon an image sensor according to a thirteenth variant embodiment;
Fig. 17 is an enlarged view of a portion of a pixel array upon an image sensor according to a fourteenth variant embodiment;
Fig. 18 is an enlarged view of a portion of a pixel array upon an image sensor according to a fifteenth variant embodiment;
Fig. 19 is an enlarged sectional view of first and second focus detection pixels of Fig. 18;
Fig. 20 is an enlarged sectional view of first and second focus detection pixels of an image sensor according to a sixteenth variant embodiment;
Fig. 21 is an enlarged view of a portion of a pixel array upon an image sensor;
Figs. 22(a) and 22(b) are sectional views of first focus detection pixels of Fig. 21;
Fig. 23 is an enlarged view of a portion of a pixel array upon an image sensor;
Fig. 24(a) through Fig. 24(i) are figures showing examples of the positions of images of the exit pupil of the imaging optical system as projected upon first focus detection pixels;
Fig. 25(a) through Fig. 25(i) are figures showing examples of the positions of images of the exit pupil of the imaging optical system as projected upon first focus detection pixels;
Fig. 26(a) through Fig. 26(f) are figures showing examples of the positions of images of the exit pupil of the imaging optical system as projected upon first focus detection pixels, in a first variant embodiment of the second embodiment;
Fig. 27(a) through Fig. 27(f) are figures showing other examples of the positions of images of the exit pupil of the imaging optical system as projected upon first focus detection pixels, in the first variant embodiment of the second embodiment;

### DESCRIPTION OF EMBODIMENTS

### Embodiment One

An image sensor (an imaging element), a focus detection device, and an imaging device (an image-capturing device) according to an embodiment will now be explained with reference to the drawings. An interchangeable lens type digital camera (hereinafter termed the "camera 1") will be shown and described as an example of an electronic device to which the image sensor according to this embodiment is mounted, but it would also be acceptable for the device to be an integrated lens type camera in which the interchangeable lens 3 and the camera body 2 are integrated together.

Moreover, the electronic device is not limited to being a camera 1; it could also be a smart phone, a wearable terminal, a tablet terminal or the like that is equipped with an image sensor.

### Structure of the Principal Portions of the Camera

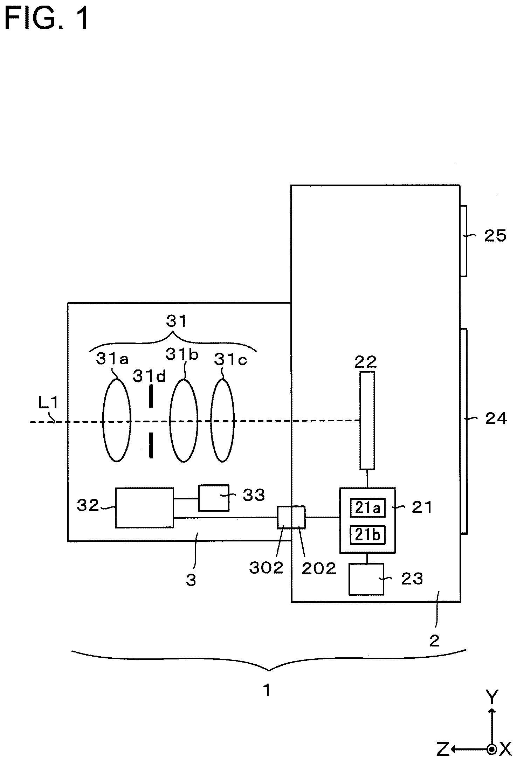

Fig. 1 is a figure showing the structure of principal portions of the camera 1. The camera 1 comprises a camera body 2 and an interchangeable lens 3. The interchangeable lens 3 is installed to the camera body 2 via a mounting portion not shown in the figures. When the interchangeable lens 3 is installed to the camera body 2, a connection portion 202 on the camera body 2 side is connected to a connection portion 302 on the interchangeable lens 3 side, and communication between the camera body 2 and the interchangeable lens 3 becomes possible.

Referring to Fig. 1, light from the photographic subject is incident in the -Z axis direction in Fig. 1. Moreover, as shown by the coordinate axes, the direction orthogonal to the Z axis and outward from the drawing paper will be taken as being the +X axis direction, and the direction orthogonal to the Z axis and to the X axis and upward will be taken as being the +Y axis direction. In the various subsequent figures, coordinate axes that are referred to the coordinate axes of Fig. 1 will be shown, so that the orientations of the various figures can be understood.

### The Interchangeable Lens

The interchangeable lens 3 comprises an imaging optical system (i.e. an image formation optical system) 31, a lens control unit 32, and a lens memory 33. The imaging optical system 31 may include, for example, a plurality of lenses 31a, 31b and 31c that include a focus adjustment lens (i.e. a focusing lens) 31c, and an aperture 31d, and forms an image of the photographic subject upon an image formation surface of an image sensor 22 that is provided to the camera body 2.

On the basis of signals outputted from a body control unit 21 of the camera body 2, the lens control unit 32 adjusts the position of the focal point of the imaging optical system 31 by shifting the focus adjustment lens 31c forwards and backwards along the direction of the optical axis L1. The signals outputted from the body control unit 21 during focus adjustment include information specifying the shifting direction of the focus adjustment lens 31c and its shifting amount, its shifting speed, and so on.

Moreover, the lens control unit 32 controls the aperture diameter of the aperture 31d on the basis of a signal outputted from the body control unit 21 of the camera body 2.

The lens memory 33 is, for example, built by a non-volatile storage medium and so on. Information relating to the interchangeable lens 3 is recorded in the lens memory 33 as lens information. For example, information related to the position of the exit pupil of the imaging optical system 31 is included in this lens information. The lens control unit 32 performs recording of information into the lens memory 33 and reading out of lens information from the lens memory 33.

### The Camera Body

The camera body 2 comprises the body control unit 21, the image sensor 22, a memory 23, a display unit 24, and a actuation unit 25. The body control unit 21 is built by a CPU, ROM, RAM and so on, and controls the various sections of the camera 1 on the basis of a control program.

The image sensor 22 is built by a CCD image sensor or a CMOS image sensor. The image sensor 22 receives a ray bundle (a light flux) that has passed through the exit pupil of the imaging optical system 31 upon its image formation surface, and an image of the photographic subject is photoelectrically converted (image capture). In this photoelectric conversion process, each of a plurality of pixels that are disposed at the image formation surface of the image sensor 22 generates an electric charge corresponding to the amount of light that it receives. And signals due to the electric charges that are generated are read out from the image sensor 22 and sent to the body control unit 21.

It should be understood that both image signals and signals for focus detection are included in the signals generated by the image sensor 22. The details of these image signals and of these focus detection signals will be described hereinafter.

The memory 23 is, for example, built by a recording medium such as a memory card or the like. Image data and audio data and so on are recorded in the memory 23. The recording of data into the memory 23 and the reading out of data from the memory 23 are performed by the body control unit 21. According to commands from the body control unit 21, the display unit 24 displays an image based upon the image data and information related to photography such as the shutter speed, the aperture value and so on, and also displays a menu actuation screen and so on. The actuation unit 25 includes a release button, a video record button, setting switches of various types and so on, and outputs actuation signals respectively corresponding to these actuations to the body control unit 21.

Moreover, the body control unit 21 described above includes a focus detection unit 21a and an image generation unit 21b. The focus detection unit 21a performs focus detection processing required for automatic focus adjustment (AF) of the imaging optical system 31. A simple explanation of the flow of focus detection processing will now be given. First, on the basis of the focus detection signals read out from the image sensor 22, the focus detection unit 21a calculates the amount of defocusing by a pupil-split type phase difference detection method. In concrete terms, an amount of image deviation of images due to a plurality of ray bundles that have passed through different regions of the pupil of the imaging optical system 31 is detected, and the defocusing amount is calculated on the basis of the amount of image deviation that has thus been detected.

And the focus detection unit 21a makes a decision as to whether or not the amount of defocusing is within a permitted value. If the amount of defocusing is within the permitted value, then the focus detection unit 21a determines that the system is adequately focused, and the focus detection process terminates. On the other hand, if the defocusing amount is greater than the permitted value, then the focus detection unit 21 determines that the system is not adequately focused, and sends the defocusing amount and a command for shifting the lens to the lens control unit 32 of the interchangeable lens 3, and then the focus detection process terminates. And, upon receipt of this command from the focus detection unit 21a, the lens control unit 32 performs focus adjustment automatically by causing the focus adjustment lens 31c to shift according to the defocusing amount.

On the other hand, the image generation unit 21b of the body control unit 21 generates image data related to the image of the photographic subject on the basis of the image signal read out from the image sensor 22. Moreover, the image generation unit 21b performs predetermined image processing upon the image data that it has thus generated. This image processing may, for example, include per se known image processing such as tone conversion processing, color interpolation processing, contour enhancement processing, and so on.

### Explanation of the Image Sensor

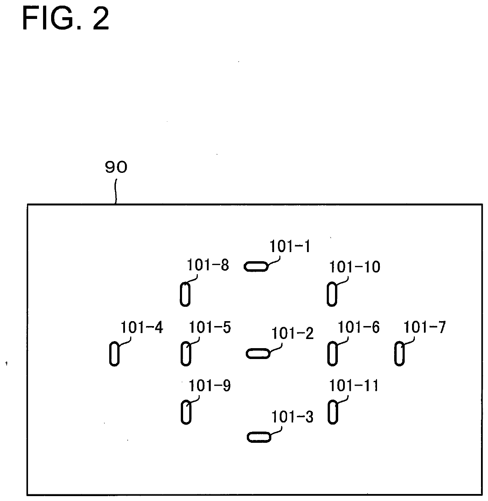

Fig. 2 is a figure showing an example of focusing areas defined on a photographic area 90. These focusing areas are areas for which the focus detection unit 21a detects amounts of image deviation described above as phase difference information, and they may also be termed "focus detection areas", "range-finding points", or "auto focus (AF) points". In this embodiment, eleven focusing areas 101-1 through 110-11 are provided in advance within the photographic area 90, and the camera is capable of detecting the amounts of image deviation in these eleven areas. It should be understood that this number of focusing areas 101-1 through 101-11 is only an example; there could be more than eleven such areas, or fewer. It would also be acceptable to set the focusing areas 101-1 through 101-11 over the entire photographic area 90.

The focusing areas 101-1 through 101-11 correspond to the positions at which first focus detection pixels 11, 13 and second focus detection pixels 14, 15 are disposed, as will be described hereinafter.

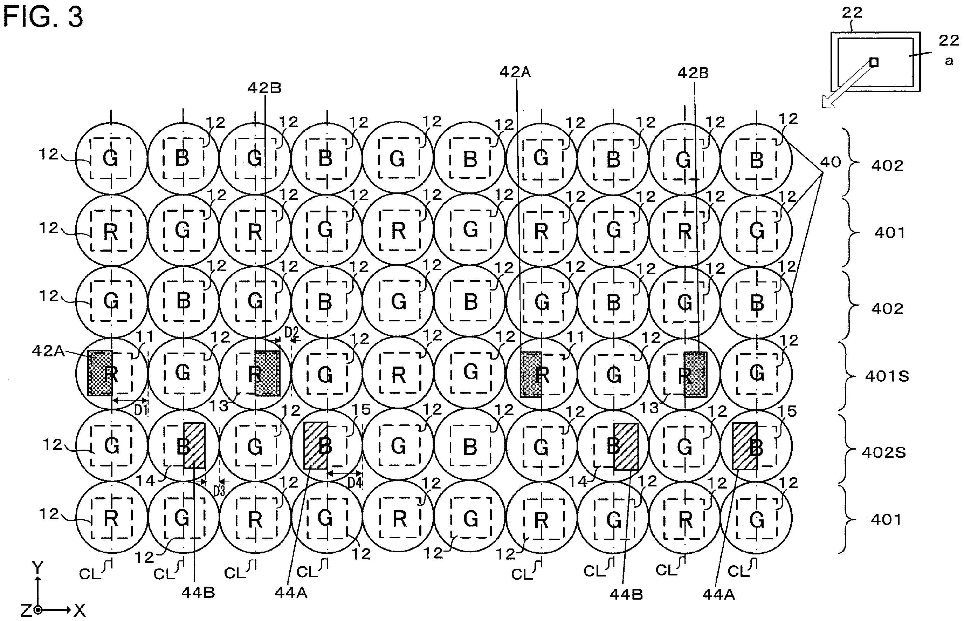

Fig. 3 is an enlarged view of a portion of an array of pixels on the image sensor 22. A plurality of pixels that include photoelectric conversion units are arranged on the image sensor 22 in a two dimensional configuration (for example, in a row direction and a column direction), within a region 22a that generates an image. To each of the pixels is provided one of three color filters having different spectral sensitivities, for example R (red), G (green), and B (blue). The R color filters principally pass light in a red colored wavelength region. Moreover, the G color filters principally pass light in a green colored wavelength region. And the B color filters principally pass light in a blue colored wavelength region. Due to this, the various pixels have different spectral sensitivity characteristics, according to the color filters with which they are provided.

On the image sensor 22, pixel rows 401 in which pixels having R and G color filters (hereinafter respectively termed "R pixels" and "G pixels") are arranged alternately, and pixel rows 402 in which pixels having G and B color filters (hereinafter respectively termed "G pixels" and "B pixels") are arranged alternately, are arranged repeatedly in a two dimensional pattern. In this manner, for example, the R pixels, G pixels, and B pixels are arranged according to a Bayer array.

The image sensor 22 includes imaging pixels 12 that are R pixels, G pixels, and B pixels arrayed as described above, first focus detection pixels 11, 13 that are disposed so as to replace some of the R imaging pixels 12, and second focus detection pixels 14, 15 that are disposed so as to replace some of the B imaging pixels 12. Among the pixel rows 401, the reference symbol 401S is appended to the pixel rows in which first focus detection pixels 11, 13 are disposed. Furthermore, among the pixel rows 402, the reference symbol 402S is appended to the pixel rows in which second focus detection pixels 14, 15 are disposed.

In Fig. 3, a case is shown by way of example in which the first focus detection pixels 11, 13 and the second focus detection pixels 14, 15 are arranged along the row direction (the X axis direction), in other words in the horizontal direction. A plurality of pairs of the first focus detection pixels 11, 13 are disposed in each of the pixel rows 401S. Similarly, a plurality of pairs of the second focus detection pixels 14, 15 are disposed in each of the pixel rows 402S. The first focus detection pixels 11, 13 are focus detection pixels that are suitable for the long wavelength region, among the wavelength regions of the light that has been photoelectrically converted by the image sensor 22. Moreover, the second focus detection pixels 14, 15 are focus detection pixels that are suitable for the short wavelength region, among the wavelength regions of the light that has been photoelectrically converted by the image sensor 22. The first focus detection pixels 11, 13 and the second focus detection pixels 14, 15 differ by the following feature: the first focus detection pixels 11, 13 have respective reflective units 42A, 42B, while by contrast the second focus detection pixels 14, 15 have respective light interception units 44B, 44A.

Furthermore there is the feature of difference that the first focus detection pixels 11, 13 are disposed in positions for R pixels, while, by contrast, the second focus detection pixels 14, 15 are disposed in positions for B pixels.

The pixel configuration shown by way of example in Fig. 3 is repeated along the row direction (i.e. the X axis direction) and along the column direction (i.e. the Y axis direction).

The signals that are read out from the imaging pixels 12 of the image sensor 22 are employed as image signals by the body control unit 21.

Moreover, the signals that are read out from the first focus detection pixels 11, 13 and from the second focus detection pixels 14, 15 of the image sensor 22 are employed as focus detection signals by the body control unit 21.

It should be understood that the signals that are read out from the first focus detection pixels 11, 13 of the image sensor 22 may also be employed as image signals by being corrected.

Next, the imaging pixels 12, the first focus detection pixels 11 and 13, and the second focus detection pixels 14 and 15 will be explained in detail.

### The Imaging Pixels

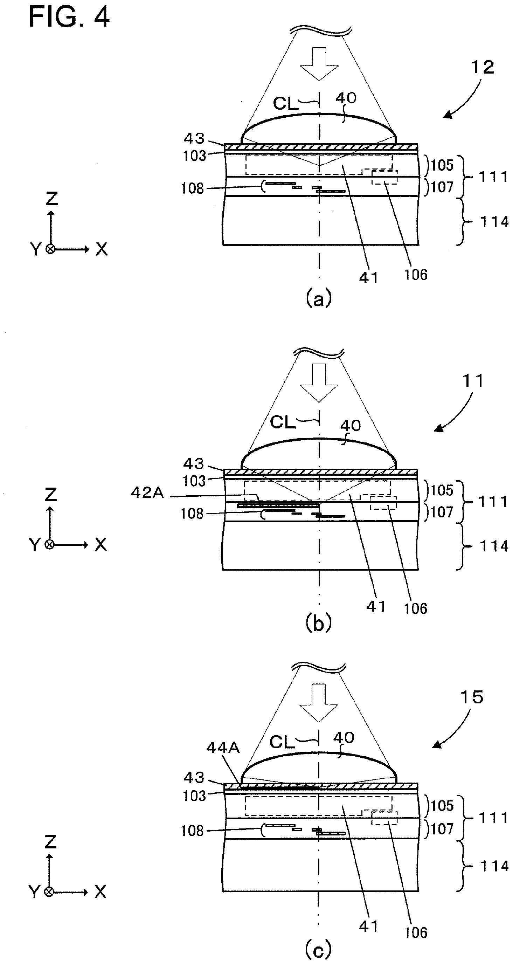

Fig. 4(a) is an enlarged sectional view of one of the imaging pixels 12 of Fig. 3. The line CL is a line through the center of this imaging pixel 12.

The image sensor 22, for example, is of the backside illumination type, with a first substrate 111 and a second substrate 114 being laminated together therein via an adhesion layer, not shown in the figures. The first substrate 111 is made as a semiconductor substrate. Moreover, the second substrate 114 is made as a semiconductor substrate or as a glass substrate, and functions as a support substrate for the first substrate 111.

A color filter 43 is provided over the first substrate 111 (on its side in the +Z axis direction) via a reflection prevention layer 103. Moreover, a micro lens 40 is provided over the color filter 43 (on its side in the +Z axis direction). Light is incident upon the imaging pixel 12 in the direction shown by the white arrow sign from above the micro lens 40 (i.e. from the +Z axis direction). The micro lens 40 condenses the incident light onto a photoelectric conversion unit 41 on the first substrate 111.

In relation to the micro lens 40 of this imaging pixel 12, the optical characteristics of the micro lens 40, for example its optical power, are determined so as to cause the intermediate position in the thickness direction (i.e. in the Z axis direction) of the photoelectric conversion unit 41 and the position of the pupil of the imaging optical system 31 (i.e. an exit pupil 60 that will be explained hereinafter) to be conjugate. The optical power may be adjusted by varying the curvature or varying the refractive index of the micro lens 40. Varying the optical power of the micro lens 40 means changing the focal length of the micro lens 40. Moreover, it would also be acceptable to arrange to adjust the focal length by changing the shape or the material of the micro lens 40. For example, if the curvature of the micro lens 40 is reduced, then its focal length becomes longer. Moreover, if the curvature of the micro lens 40 is increased, then its focal length becomes shorter. If the micro lens 40 is made from a material whose refractive index is low, then its focal length becomes long. Moreover, if the micro lens 40 is made from a material whose refractive index is high, then its focal length becomes short. If the thickness of the micro lens 40 (i.e. its dimension in the Z axis direction) becomes small, then its focal length becomes long. Moreover, if the thickness of the micro lens 40 (i.e. its dimension in the Z axis direction) becomes large, then its focal length becomes short. It should be understood that, when the focal length of the micro lens 40 becomes longer, then the position at which the light incident upon the photoelectric conversion unit 41 is condensed shifts in the direction to become deeper (i.e. shifts in the -Z axis direction). Moreover, when the focal length of the micro lens 40 becomes shorter, then the position at which the light incident upon the photoelectric conversion unit 41 is condensed shifts in the direction to become shallower (i.e. shifts in the +Z axis direction).

According to the structure described above, it is avoided that any part of the ray bundle that has passed through the pupil of the imaging optical system 31 is incident upon any region outside the photoelectric conversion unit 41, and leakage of the ray bundle to neighboring pixels is prevented, so that the amount of light incident upon the photoelectric conversion unit 41 is increased. To put it in another manner, the amount of electric charge generated by the photoelectric conversion unit 41 is increased.

A semiconductor layer 105 and a wiring layer 107 are laminated together in the first substrate 111, and these are provided with the photoelectric conversion unit 41 and with an output unit 106. The photoelectric conversion unit 41 is built, for example, by a photodiode (PD), and light incident upon the photoelectric conversion unit 41 is photoelectrically converted and generates electric charge. Light that has been condensed by the micro lens 40 is incident upon the upper surface of the photoelectric conversion unit 41 (i.e. from the +Z axis direction). The output unit 106 includes a transfer transistor and an amplification transistor and so on, not shown in the figures. The output unit 106 outputs a signal generated by the photoelectric conversion unit 41 to the wiring layer 107. For example, n+ regions are formed on the semiconductor layer 105, and respectively constitute a source region and a drain region for the transfer transistor. Moreover, a gate electrode of the transfer transistor is formed on the wiring layer 107, and this electrode is connected to wiring 108 that will be described hereinafter.

The wiring layer 107 includes a conductor layer (i.e. a metallic layer) and an insulation layer, and a plurality of wires 108 and vias and contacts and so on not shown in the figure are disposed therein. For example, copper or aluminum or the like may be employed for the conductor layer. And the insulation layer may, for example, consist of an oxide layer or a nitride layer or the like. The signal of the imaging pixel 22 that has been outputted from the output unit 106 to the wiring layer 107 is, for example, subjected to signal processing such as A/D conversion and so on by peripheral circuitry not shown in the figures provided on the second substrate 114, and is read out by the body control unit 21 (refer to Fig. 1).

As shown by way of example in Fig. 3, a plurality of the imaging pixels 12 of Fig. 4(a) are arranged in the X axis direction and the Y axis direction, and these are R pixels, G pixels, and B pixels. These R pixels, G pixels, and B pixels all have the structure shown in Fig. 4(a), but with the spectral characteristics of their respective color filters 43 being different from one another.

### The First Focus Detection Pixels

Fig. 4(b) is an enlarged sectional view of one of the first focus detection pixels 11 of Fig. 3. To structures that are similar to structures of the imaging pixel 12 of Fig. 4(a), the same reference symbols are appended, and explanation thereof will be curtailed. The line CL is a line through the center of this first focus detection pixel 11, in other words along the optical axis of the micro lens 40 and through the center of the photoelectric conversion unit 41. The fact that this first focus detection pixel 11 is provided with a reflective unit 42A below the lower surface of its photoelectric conversion unit 41 (i.e. below the surface thereof in the -Z axis direction) is a feature that is different, as compared with the imaging pixel 12 of Fig. 4(a). It should be understood that it would also be acceptable for this reflective unit 42A to be provided as separated in the -Z axis direction from the lower surface of the photoelectric conversion unit 41. The lower surface of the photoelectric conversion unit 41 is its surface on the opposite side from its upper surface upon which the light is incident via the micro lens 40. The reflective unit 42A may, for example, be built as a multi-layered structure including a conductor layer made from copper, aluminum, tungsten or the like provided in the wiring layer 107, or an insulation layer made from silicon nitride or silicon oxide or the like. The reflective unit 42A covers almost half of the lower surface of the photoelectric conversion unit 41 (on the left side of the line CL (i.e. the -X axis direction)). Due to the provision of the reflective unit 42A, at the left half of the photoelectric conversion unit 41, light that has passed through the photoelectric conversion unit 41 and that is proceeding in the downward direction (i.e. in the -Z axis direction) from the photoelectric conversion unit 41 is reflected back upward by the reflective unit 42A, and is again incident upon the photoelectric conversion unit 41 for a second time. Since this light that is again incident upon the photoelectric conversion unit 41 is photoelectrically converted thereby, accordingly the amount of electric charge that is generated by the photoelectric conversion unit 41 is increased, as compared to an imaging pixel 12 to which no reflective unit 42A is provided.

In relation to the micro lens 40 of this first focus detection pixel 11, the optical power of the micro lens 40 is determined so that the position of the lower surface of the photoelectric conversion unit 41, in other words the position of the reflective unit 42A, is conjugate to the position of the pupil of the imaging optical system 31 (in other words, to the exit pupil 60 that will be explained hereinafter).

Accordingly, as will be explained in detail hereinafter, along with first and second ray bundles that have passed through first and second regions of the pupil of the imaging optical system 31 being incident upon the photoelectric conversion unit 41, also, among the light that has passed through the photoelectric conversion unit 41, this second ray bundle that has passed through the second pupil region is reflected by the reflective unit 42A, and is again incident upon the photoelectric conversion unit 41 for a second time.

Due to the provision of the structure described above, it is avoided that any part of the first and second ray bundles that has passed through the pupil of the imaging optical system 31 should be incident upon any region outside the photoelectric conversion unit 41 or should leak to a neighboring pixel, so that the amount of light incident upon the photoelectric conversion unit 41 is increased. To put this in another manner, the amount of electric charge generated by the photoelectric conversion unit 41 is increased.

It should be understood that it would also be acceptable for a part of the wiring 108 formed in the wiring layer 107, for example a part of a signal line connected to the output unit 106, to be also employed as the reflective unit 42A. In this case, the reflective unit 42A would serve both as a reflective layer that reflects light that has passed through the photoelectric conversion unit 41 and is proceeding in the direction downward from the photoelectric conversion unit 41 (i.e. in the -Z axis direction), and also as a signal line that transmits a signal.

In a similar manner to the case with the imaging pixel 12, the signal of the first focus detection pixel 11 that has been outputted from the output unit 106 to the wiring layer 107 is subjected to signal processing such as, for example, A/D conversion and so on by peripheral circuitry not shown in the figures provided on the second substrate 114, and is then read out by the body control unit 21 (refer to Fig. 1).

It should be understood that, in Fig. 4(b), it is shown that the output unit 106 of the first focus detection pixel 11 is provided at a region of the first focus detection pixel 11 at which the reflective unit 42A is not present (i.e. at a region more toward the +X axis direction than the line CL). It would also be acceptable for the output unit 106 to be provided at a region of the first focus detection pixel 11 at which the reflective unit 42A is present (i.e. at a region more toward the -X axis direction than the line CL).

As shown in Fig. 3, first focus detection pixels 13 that pair with the first focus detection pixels 11 are present in the pixel row 401S. These first focus detection pixels 13 have reflective units 42B in different positions from the reflective units 42A of the first focus detection pixels 11 of Fig. 4(b). The reflective units 42B cover almost half of the lower surfaces of their photoelectric conversion units 41 (their portions more toward the right sides (in the +X axis direction) than the lines CL). Although no enlarged sectional view of a first focus detection pixel 13 is shown in the figures, due to the provision of each of these reflective units 42B, in the right side halves of their photoelectric conversion units 41, the light proceeding in the downward direction through the photoelectric conversion unit 41 (the -Z axis direction) and that has passed through the photoelectric conversion unit 41 is reflected by the reflective unit 42B, and is again incident upon the photoelectric conversion unit 41 for a second time. Since this light that is again incident upon the photoelectric conversion unit 41 is photoelectrically converted thereby, accordingly the amount of electric charge that is generated by the photoelectric conversion unit 41 is increased, as compared to an imaging pixel 12 to which no reflective unit 42B is provided.

In other words, as will be explained hereinafter in detail, in the first focus detection pixel 13, along with first and second ray bundles that have passed through the first and second regions of the pupil of the imaging optical system 31 being incident upon the photoelectric conversion unit 41, also, among the light that has passed through the photoelectric conversion unit 41, this first ray bundle that has passed through the first region is reflected by the reflective unit 42B, and is again incident upon the photoelectric conversion unit 41 for a second time.

As has been described above, with the first focus detection pixels 11, 13, among the first and second ray bundles that have passed through the first and second regions of the pupil of the imaging optical system 31, for example the first ray bundle is reflected by the reflective unit 42B of the first focus detection pixel 13, while for example the second ray bundle is reflected by the reflective unit 42A of the first focus detection pixel 11.

In relation to the micro lens 40 of this first focus detection pixel 13, the optical power of the micro lens 40 is determined so that the position of the reflective unit 42B that is provided on the lower surface of the photoelectric conversion unit 41 is conjugate to the position of the pupil of the imaging optical system 31 (in other words, to the exit pupil 60 that will be explained hereinafter).

Due to the provision of the structure described above, incidence of the first and second ray bundles upon regions other than the photoelectric conversion unit 41, and leakage thereof to neighboring pixels, are prevented, so that the amount of light incident upon the photoelectric conversion unit 41 is increased. To put this in another manner, the amount of electric charge generated by the photoelectric conversion unit 41 is increased.

In the first focus detection pixel 13, in a similar manner to the case with the first focus detection pixel 11, it would also be acceptable for a part of the wiring 108 formed in the wiring layer 107, for example a part of a signal line connected to the output unit 106, to be also employed as the reflective unit 42B. In this case, the reflective unit 42B would serve both as a reflective layer that reflects light that has passed through the photoelectric conversion unit 41 and is proceeding in the direction downward from the photoelectric conversion unit 41 (i.e. in the -Z axis direction), and also as a signal line that transmits a signal.

Furthermore, it would also be acceptable for a part of the insulation layer used in the output unit 106 to be also employed as the reflective unit 42B. In this case, the reflective unit 42B would serve both as a reflective layer that reflects light that has passed through the photoelectric conversion unit 41 and is proceeding in the direction downward from the photoelectric conversion unit 41 (i.e. in the -Z axis direction), and also as an insulation layer.

In a similar manner to the case with the first focus detection pixel 11, the signal of the first focus detection pixel 13 that has been outputted from the output unit 106 to the wiring layer 107 is subjected to signal processing such as, for example, A/D conversion and so on by peripheral circuitry not shown in the figures provided on the second substrate 114, and is then read out by the body control unit 21 (refer to Fig. 1).

It should be understood that, in a similar manner to the case with the first focus detection pixel 11, it will be acceptable for the output unit 106 of the first focus detection pixel 13 to be provided at a region at which the reflective unit 42B is not present (i.e. at a region more toward the -X axis direction than the line CL), or, alternatively, it would also be acceptable for the output unit to be provided at a region at which the reflective unit 42B is present (i.e. at a region more toward the +X axis direction than the line CL).

Generally, with a semiconductor substrate such as a silicon substrate or the like, the transmittance exhibits different characteristics according to the wavelength of the incident light. The transmittance through the silicon substrate is generally higher for light of long wavelength than for light of short wavelength. For example, among the light that has been photoelectrically converted by an image sensor 22, the red color light whose wavelength is longer passes more easily through the semiconductor layer 105 (i.e. through the photoelectric conversion unit 41) as compared to the light of the other colors (i.e. of green color and of blue color).

In this embodiment, since the transmittance of the red color light is higher, accordingly the first focus detection pixels 11, 13 are disposed in positions for R pixels. When the light that proceeds through the photoelectric conversion units 41 in the downward direction (i.e. in the -Z axis direction) is red color light, it can easily pass through the photoelectric conversion units 41 and arrive at the reflective units 42A, 42B. Due to this, it is possible for the red color light that passes through the photoelectric conversion units 41 to be reflected by the reflective units 42A, 42B, and to be again incident upon the photoelectric conversion units 41 for a second time. As a result, the amount of electric charge that is generated by the photoelectric conversion units 41 in the first focus detection pixels 11, 13 is increased. In this manner, the first focus detection pixels 11, 13 may be said to be focus detection pixels suitable for the long wavelength region (in this example, for red color) among the wavelength regions of the light that is photographically converted by the image sensor 22,

As described above, the position of the reflective unit 42A of the first focus detection pixel 11 with respect to the photoelectric conversion unit 41 of that first focus detection pixel 11, and the position of the reflective unit 42B of the first focus detection pixel 13 with respect to the photoelectric conversion unit 41 of that first focus detection pixel 13, are mutually different. Moreover, the position of the reflective unit 42A of the first focus detection pixel 11 with respect to the optical axis of the micro lens 40 of that first focus detection pixel 11, and the position of the reflective unit 42B of the first focus detection pixel 13 with respect to the optical axis of the micro lens 40 of that first focus detection pixel 13, are mutually different.

The reflective unit 42A of each first focus detection pixel 11 is provided at a region more toward the -X axis direction than the center of the photoelectric conversion unit 41 of the first focus detection pixel 11 in a plane (i.e. the XY plane) that intersects at right angles the direction in which the light is incident (i.e. the -Z axis direction). Moreover, in the XY plane, at least a part of the reflective unit 42A of the first focus detection pixel 11 is provided in a region that is more toward the -X axis direction, among the regions that are divided by a line parallel to a line extending in the Y axis direction through the center of the photoelectric conversion unit 41 of the first focus detection pixel 11. To put it in another manner, in the XY plane, at least a part of the reflective unit 42A of the first focus detection pixel 11 is provided in a region that is more toward the -X axis direction, among the regions that are divided by a line parallel to the Y axis intersecting the line CL in Fig. 4.

On the other hand, the reflective unit 42B of each first focus detection pixel 13 is provided at a region more toward the +X axis direction than the center of the photoelectric conversion unit 41 of the first focus detection pixel 13 in a plane (i.e. the XY plane) that intersects at right angles the direction in which the light is incident (i.e. the -Z axis direction). Moreover, in the XY plane, at least a part of the reflective unit 42B of the first focus detection pixel 13 is provided in a region that is more toward the +X axis direction, among the regions that are divided by a line parallel to a line extending in the Y axis direction through the center of the photoelectric conversion unit 41 of the first focus detection pixel 13. To put it in another manner, in the XY plane, at least a part of the reflective unit 42B of the first focus detection pixel 13 is provided in a region that is more toward the +X axis direction, among the regions that are divided by a line parallel to the Y axis intersecting the line CL in Fig. 4.

The explanation of the relationship of the positions of the reflective units 42A and 42B to the adjacent pixels is as follows. That is, the respective reflective units 42A and 42B of the first focus detection pixels 11, 13 are provided at different gaps from the neighboring pixels, in a direction (in the example of Fig. 3, the X axis direction or the Y axis direction) that intersects at right angles the direction in which light is incident. In concrete terms, the reflective unit 42A of the first focus detection pixel 11 is provided at a distance D1 from the neighboring imaging pixel 12 on its right in the X axis direction. On the other hand, the reflective unit 42B of the first focus detection pixel 13 is provided at a second distance D2, which is different from the first distance D1, from the neighboring imaging pixel 12 on its right in the X axis direction.

It should be understood that a case would also be acceptable in which the first distance D1 and the second distance D2 are substantially zero. Moreover, it would also be acceptable to arrange to express the position in the XY plane of the reflective unit 42A of the first focus detection pixel 11 and the position in the XY plane of the reflective unit 42B of the first focus detection pixel 13 by the distances from the central positions on each of these reflective units to the other pixels (for example the neighboring imaging pixels on their right), instead of expressing them by the distances from the side edge portions of these reflective units to the neighboring imaging pixels on their right.

Still further, it would also be acceptable to arrange to express the positions of the reflective units of the first focus detection pixel 11 and the first focus detection pixel 13 in the XY plane by the distances from the central positions of these reflective units to the central positions of each pixel (for example, the centers of their photoelectric conversion units 41). Yet further, it would also be acceptable to arrange to express them by the distances from the central positions of these reflective units to the optical axis of the micro lens 40 of each pixel.

### The Second Focus Detection Pixels

Fig. 4(c) is an enlarged sectional view of one of the second focus detection pixels 15 of Fig. 3. To structures that are similar to structures of the imaging pixel 12 of Fig. 4(a), the same reference symbols are appended, and explanation thereof will be curtailed. The line CL is a line through the center of this second focus detection pixel 15. The fact that this second focus detection pixel 15 is provided with a light interception unit 44A upon the upper surface of its photoelectric conversion unit 41 (i.e. upon the surface thereof in the +Z axis direction) is a feature that is different, as compared with the imaging pixel 12 of Fig. 4(a). The upper surface of the photoelectric conversion unit 41 is its surface upon which the light is incident via the micro lens 40. The light interception unit 44A may, for example, be built as a intercepting layer or the like, and covers almost half of the upper surface of the photoelectric conversion unit 41 (on the left side of the line CL (i.e. the -X axis direction)). Due to the provision of this light interception unit 44A, at the left half of the photoelectric conversion unit 41, light is prevented from being incident upon the photoelectric conversion unit 41.

It should be understood that it would also be acceptable to arrange to build the light interception unit 44A with, for example, an electrically conductive layer such as a tungsten layer or the like, or with a black colored filter.

In relation to the micro lens 40 of this second focus detection pixel 15, the optical power of the micro lens 40 is determined so that the position where the light interception unit 44A is provided upon the upper surface of the photoelectric conversion unit 41 is conjugate to the position of the pupil of the imaging optical system 31 (in other words, to the exit pupil 60 that will be explained hereinafter).

Due to the provision of the structure described above, incidence of the first and second ray bundles upon regions other than the photoelectric conversion unit 41, and leakage thereof to neighboring pixels, are prevented.

In a similar manner to the case with the imaging pixel 12, the signal of the second focus detection pixel 15 that has been outputted from the output unit 106 to the wiring layer 107 is subjected to signal processing such as, for example, A/D conversion and so on by peripheral circuitry not shown in the figures provided on the second substrate 114, and is then read out by the body control unit 21 (refer to Fig. 1).

As shown in Fig. 3, second focus detection pixels 14 that pair with the second focus detection pixels 15 are present in the pixel row 402S. These second focus detection pixels 14 have light interception units 44B in different positions from the light interception units 44A of the second focus detection pixels 15 of Fig. 4(c). The light interception units 44B cover almost half of the upper surfaces of their photoelectric conversion units 41 (their portions more toward the right sides (in the +X axis direction) than the lines CL). Although no enlarged sectional view of a second focus detection pixel 14 is shown in the figures, due to the provision of each of these reflective units 42B, by providing the light interception unit 44B in the right side half of its photoelectric conversion unit 41, light is prevented from being incident upon its photoelectric conversion unit 41.

In the second focus detection pixel 14, in a similar manner to the case with the second focus detection pixel 15, it would also be acceptable to arrange to build the light interception unit 44B with, for example, an electrically conductive layer such as a tungsten layer or the like, or with a black colored filter.

In relation to the micro lens 40 of this second focus detection pixel 14, the optical power of the micro lens 40 is determined so that the position of the light interception unit 44B that is provided on the upper surface of the photoelectric conversion unit 41 is conjugate to the position of the pupil of the imaging optical system 31 (in other words, to the exit pupil 60 that will be explained hereinafter).

Due to the provision of the structure described above, incidence of the first and second ray bundles upon regions other than the photoelectric conversion unit 41, and leakage thereof to neighboring pixels, are prevented.

In a similar manner to the case with the second focus detection pixel 15, the signal of the second focus detection pixel 14 that has been outputted from the output unit 106 to the wiring layer 107 is subjected to signal processing such as, for example, A/D conversion and so on by peripheral circuitry not shown in the figures provided on the second substrate 114, and is then read out by the body control unit 21 (refer to Fig. 1).

As miniaturization of the pixels of the image sensor 22 progresses, the apertures of the pixels become smaller. Accordingly, in particular, as miniaturization of the pixels of the image sensor 22 progresses, the apertures of the second focus detection pixels 14, 15 become smaller. In this embodiment, the apertures become small in the left halves of the second focus detection pixels 14 (i.e. in the -X axis direction) and in the right halves of the second focus detection pixels 15 (i.e. in the +X axis direction). Since the respective light interception units 44B and light interception units 44A are provided in the second focus detection pixels 14, 15, accordingly their apertures are smaller as compared to those of the first focus detection pixels 11, 13. Generally, when the size of an aperture becomes as small as the wavelength of light, it may sometimes occur that light is not properly incident upon the second focus detection pixels 14, 15 due to wavelength cutoff taking place. Since, among the light that is photoelectrically converted by the image sensors 22, the red color light has a longer wavelength as compared to the light of other colors (i.e. of green color and of blue color), accordingly it can easily happen that no such red light is incident upon the photoelectric conversion units 41 of the second focus detection pixels 14. In other words, it becomes difficult to perform focus detection by photoelectrically converting the red color light with the second focus detection pixels 14, 15 whose apertures are small. When, due to miniaturization of the pixels, the size of the aperture becomes smaller (shorter) than the wavelength of the incident light (in this example, than the wavelength of red color light), it becomes impossible to perform focus detection with the focus detection pixels that employ light interception units, since no light is incident upon their photoelectric conversion units 41. On the other hand, since the apertures of the first focus detection pixels 11, 13 are larger as compared to those of the second focus detection pixels 14, 15, accordingly some red color light is still incident upon their photoelectric conversion units.

In this embodiment it becomes possible to perform focus detection by photoelectrically converting red color light, by arranging the first focus detection pixels 11, 13 but not the second focus detection pixels 14, 15 in positions for R pixels.

Among the light that is photoelectrically converted by the image sensor 22, since the wavelength of the blue color light is shorter as compared with the wavelength of the red color light, accordingly it is more difficult for such light not to be incident upon the photoelectric conversion units 41, as compared with the red color light. In other words, the second focus detection pixels 14, 15 are able to perform focus detection by photoelectrically converting the light of blue color even though their apertures are smaller than those of the first focus detection pixels 11, 13. The second focus detection pixels 14 and 15 perform focus detection by photoelectrically converting the short wavelength light among the wavelength regions of the light that is photoelectrically converted by the image sensors 22 (in this example, the blue color light).

It should be noted that it would be acceptable to dispose the first focus detection pixels 11, 13 at positions for R pixels, and to dispose the second focus detection pixels 14, 15 at positions for G pixels. Moreover, it would also be acceptable to dispose the first focus detection pixels 11, 13 at positions for G pixels, and to dispose the second focus detection pixels 14, 15 at positions for B pixels.

The positions of the light interception units 44B and of the light interception units 44A of the second focus detection pixels 14, 15 will now be explained in the following in terms of their relationships with adjacent pixels. That is, the light interception units 44B and the light interception units 44A of the second focus detection pixels 14, 15 are provided at different gaps from neighboring pixels in the direction perpendicular to the direction in which light is incident thereupon (in the Fig. 3 example, the X axis direction or the Y axis direction). In concrete terms, the light interception units 44B of the second focus detection pixels 14 are provided at a third distance D3 from the adjacent imaging pixels 12 on their right sides in the X axis direction. And the light interception units 44a of the second focus detection pixels 15 are provided at a fourth distance D4, which is different from the third distance D3, from the adjacent imaging pixels 12 on their right sides in the X axis direction.

It should be understood that, in some cases, it would be possible for the third distance D3 and the fourth distance D4 to be substantially zero. Moreover, it would also be acceptable to arrange to express the positions in the XY plane of the light interception units 44B of the second focus detection pixels 14 and the positions in the XY plane of the light interception units 44A of the second focus detection pixels 15 by the distances from the central positions of each of these light interception units to the other pixels (for example the neighboring imaging pixels on their right), instead of expressing them by the distances from the side edge portions of these light interception units to the neighboring imaging pixels on their right.

Even further, it would also be acceptable to arrange to express the positions of the light interception units of the second focus detection pixels 14 and the second focus detection pixels 15 by the distances from the central positions on their light interception units to the central portions of each pixel (for example, the centers of their photoelectric conversion units 41). Still further, it would be possible to express these positions by the distances from the central positions on their light interception units to the optical axis of the micro lens 40 of each of the pixels.

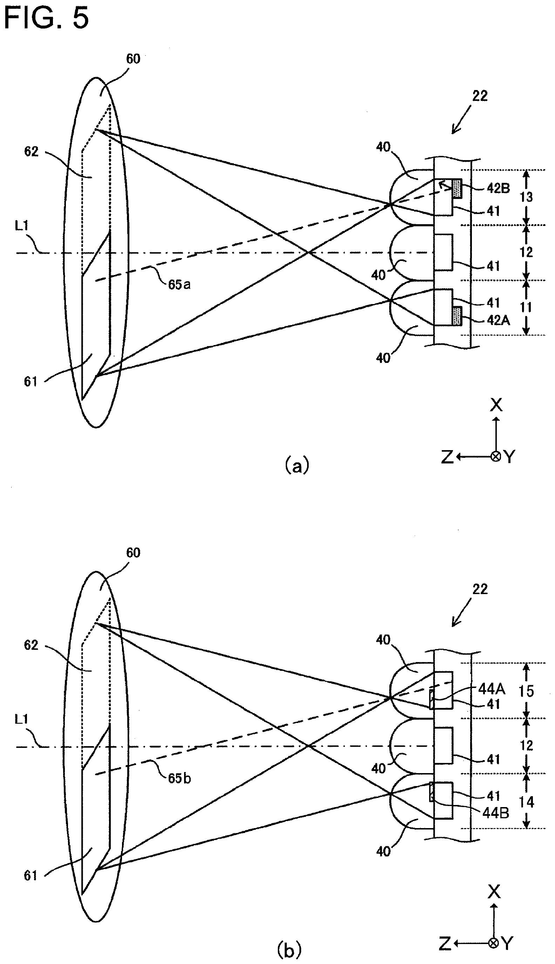

Fig. 5(a) is a figure for explanation of ray bundles that are incident upon the first focus detection pixels 11, 13. An individual unit consisting of the first focus detection pixels 11, 13 described above and an imaging pixel 12 sandwiched between them is shown in the figure.

First, directing attention to the first focus detection pixel 13 of Fig. 5(a), a first ray bundle that has passed through a first pupil region 61 of the exit pupil 60 of the imaging optical system of Fig. 1 and a second ray bundle that has passed through a second pupil region 62 thereof are incident via the micro lens 40 of the first focus detection pixel 13 upon its photoelectric conversion unit 41. Moreover, among the first and second ray bundles incident upon the photoelectric conversion unit 41, the first ray bundle passes through the photoelectric conversion unit 41 and is reflected by the reflective unit 42B, to be again incident upon the photoelectric conversion unit 41 for a second time. In this manner, the first focus detection pixel 13 outputs a signal (S1+S3) that is obtained by adding a signal S1 based upon the electric charges resulting from photoelectric conversion of both the first and second ray bundles that have respectively passed through the first pupil region 61 and the second pupil region 62 and are incident upon the photoelectric conversion unit 41, to a signal S3 based upon the electric charge resulting from photoelectric conversion of the first ray bundle that is reflected by the reflective unit 42B and is again incident upon the photoelectric conversion unit 41.

It should be understood that, in Fig. 5(a), the first ray bundle that passes through the first pupil region 61 and then passes through the micro lens 40 of the first focus detection pixel 13 and through its photoelectric conversion unit 41, and is reflected back by its reflective unit 42B and is again incident upon the photoelectric conversion unit 41, is schematically shown by a broken line 65a.

On the other hand, directing attention to the first focus detection pixel 11 of Fig. 5(a), a first ray bundle that has passed through the first pupil region 61 of the exit pupil 60 of the imaging optical system of Fig. 1 and a second ray bundle that has passed through a second pupil region 62 thereof are incident via the micro lens 40 of the first focus detection pixel 11 upon its photoelectric conversion unit 41. Moreover, among the first and second ray bundles incident upon the photoelectric conversion unit 41, the second ray bundle passes through the photoelectric conversion unit 41 and is reflected by the reflective unit 42A, to be again incident upon the photoelectric conversion unit 41 for a second time. In this manner, the first focus detection pixel 11 outputs a signal (S1+S2) that is obtained by adding a signal S1 based upon the electric charges resulting from photoelectric conversion of both the first and second ray bundles that have respectively passed through the first pupil region 61 and the second pupil region 62 and are incident upon the photoelectric conversion unit 41, to a signal S2 based upon the electric charge resulting from photoelectric conversion of the second ray bundle that is reflected by the reflective unit 42A and is again incident upon the photoelectric conversion unit 41.

Next, directing attention to the imaging pixel 12 of Fig. 5(a), ray bundles that have passed through both the first pupil region 61 and the second pupil region 62 of the exit pupil 60 of the imaging optical system of Fig. 1 are incident via its micro lens 40 upon its photoelectric conversion unit 41. In this manner, the imaging pixel 12 outputs a signal S1 based upon the electric charges resulting from photoelectric conversion of both the ray bundles that have respectively passed through the first pupil region 61 and the second pupil region 62 and are incident upon the photoelectric conversion unit 41.

Fig. 5(b) is a figure for explanation of ray bundles that are incident upon the second focus detection pixels 14, 15. An individual unit consisting of the second focus detection pixels 14, 15 described above and an imaging pixel 12 sandwiched between them is shown in the figure.

First, directing attention to the second focus detection pixel 15 of Fig. 5(b), a first ray bundle that has passed through the first pupil region 61 of the exit pupil 60 of the imaging optical system of Fig. 1 is incident via the micro lens 40 of the second focus detection pixel 15 upon its photoelectric conversion unit 41. Moreover, a second ray bundle that has passed through the second pupil region 62 of the exit pupil 60 described above is intercepted by the light interception unit 44A and is not incident upon the photoelectric conversion unit 41. In this manner, the second focus detection pixel 15 outputs a signal S5 based upon the electric charge resulting from photoelectric conversion of the first ray bundle that has passed through the first pupil region 61 and been incident upon the photoelectric conversion unit 41.

It should be understood that, in Fig. 5(b), the first ray bundle that passes through the first pupil region 61 and then passes through the micro lens 40 of the second focus detection pixel 15 and is incident upon its photoelectric conversion unit 41 is schematically shown by a broken line 65b.

On the other hand, directing attention to the second focus detection pixel 14 of Fig. 5(b), a second ray bundle that has passed through the second pupil region 62 of the exit pupil 60 of the imaging optical system of Fig. 1 is incident via the micro lens 40 of the second focus detection pixel 14 upon its photoelectric conversion unit 41. Moreover, a first ray bundle that has passed through the first pupil region 61 of the exit pupil 60 described above is intercepted by the light interception unit 44B and is not incident upon the photoelectric conversion unit 41. In this manner, the second focus detection pixel 14 outputs a signal S4 based upon the electric charge resulting from photoelectric conversion of the second ray bundle that has passed through the second pupil region 62 and been incident upon the photoelectric conversion unit 41.

Next, directing attention to the imaging pixel 12 of Fig. 5(b), ray bundles that have passed through both the first pupil region 61 and the second pupil region 62 of the exit pupil 60 of the imaging optical system of Fig. 1 are incident via its micro lens 40 upon its photoelectric conversion unit 41. In this manner, the imaging pixel 12 outputs a signal S1 based upon the electric charges resulting from photoelectric conversion of both the ray bundles that have respectively passed through the first pupil region 61 and the second pupil region 62 and are incident upon the photoelectric conversion unit 41.

### Generation of the Image Data

The image generation unit 21b of the body control unit 21 generates image data related to the photographic subject image on the basis of the signals S1 from the imaging pixels 12 and the signals (S1+S2) and (S1+S3) from the first focus detection pixels 11, 13.

It should be understood that when generating this image data, in order to suppress negative influence of the signals S2 and S3, or, to put it in another manner, in order to suppress negative influence due to the difference between the amount of electric charge generated by the photoelectric conversion unit 41 of the imaging pixel 12 and the amounts of electric charge generated by the photoelectric conversion units 41 of the first focus detection pixels 11, 13, it will be acceptable to provide a difference between a gain applied to the signal S1 from the imaging pixel 12 and gains applied to the respective signals (S1+S2), (S1+S3) from the first focus detection pixels 11, 13. For example, the gains applied to the respective signals (S1+S2), (S1+S3) of the first focus detection pixels 11, 13 may be made to be smaller, as compared to the gain applied to the signal S1 of the imaging pixel 12.

### Detection of the Amounts of Image Deviation

The focus detection unit 21a of the body control unit 21 detects an amount of image deviation in the following manner, on the basis of the signal S1 from the imaging pixel 12, the signal (S1+S2) from the first focus detection pixel 11, and the signal (S1+S3) from the first focus detection pixel 13. That is to say, the focus detection unit 21a obtains the difference diff2 between the signal S1 from the imaging pixel 12 and the signal (S1+S2) from the first focus detection pixel 11, and also obtains the difference diff3 between the signal S1 from the imaging pixel 12 and the signal (S1+S3) from the first focus detection pixel 13. The difference diff2 corresponds to the signal S2 based upon the electric charge obtained by photoelectric conversion of the second ray bundle that was reflected by the reflective unit 42A of the first focus detection pixel 11. In a similar manner, the difference diff3 corresponds to the signal S3 based upon the electric charge obtained by photoelectric conversion of the first ray bundle that was reflected by the reflective unit 42B of the first focus detection pixel 13.

On the basis of these differences diff3 and diff2 that have thus been obtained, the focus detection unit 21a obtains the amount of image deviation between the image due to the first ray bundle that has passed through the first pupil region 61, and the image due to the second ray bundle that has passed through the second pupil region 62. In other words, by collecting together the group of differences diff3 of signals obtained from each of the plurality of units described above, and the group of differences diff2 of signals obtained from each of the plurality of units described above, the focus detection unit 21a is able to obtain information representing the intensity distributions of a plurality of images formed by a plurality of focus detection ray bundles that have passed through the first pupil region 61 and the second pupil region 62 respectively.

The focus detection unit 21a calculates the amounts of image deviation of the plurality of images by performing image deviation detection calculation processing (i.e. correlation calculation processing and phase difference detection processing) upon the intensity distributions of the plurality of images described above. Moreover, the focus detection unit 21a also calculates a defocusing amount by multiplying this amount of image deviation by a predetermined conversion coefficient. This type of defocusing amount calculation according to a pupil-split type phase difference detection method is per se known, and therefore detailed explanation thereof will be omitted.

Furthermore, on the basis of the signal S4 from the second focus detection pixel 14 and the signal S5 from the second focus detection pixel 15, the focus detection unit 21a of the body control unit 21 detects an amount of image deviation as described below. That is, by collecting together the group of signals S5 obtained from each of the plurality of units described above and the group of signals S4 obtained from each of the plurality of units described above, the focus detection unit 21a is able to obtain information representing the intensity distributions of a plurality of images formed by a plurality of focus detection ray bundles that have passed through the first pupil region 61 and the second pupil region 62 respectively.

The feature that the amounts of image deviation of the plurality of images described above are calculated from the intensity distributions of the plurality of images, and the feature that the defocusing amount is calculated by multiplying the amount of image deviation by a predetermined conversion coefficient, are the same as when the first focus detection pixels 11, 13 are employed.

Whether the focus detection unit 21a calculates the defocusing amount by employing the first focus detection pixels 11, 13 and the imaging pixel 12 provided in the pixel row 401S or calculates the defocusing amount by employing the second focus detection pixels 14, 15 and the imaging pixel 12 provided in the pixel row 402S may, for example, be decided on the basis of the color of the photographic subject that is the subject for focus adjustment. Moreover, it would also be acceptable to arrange for the focus detection unit 21a to decide whether to employ the first focus detection pixels 11, 13 or the second focus detection pixels 14, 15 on the basis of the color of the photographic scene, or on the basis of the color of a photographic subject that has been selected by the photographer.

Even further, it would also be acceptable to arrange for the focus detection unit 21a to calculate the defocusing amount by employing the first focus detection pixels 11, 13 and the imaging pixel 12 provided in the pixel row 401S and also the second focus detection pixels 14, 15 and the imaging pixel 12 provided in the pixel row 402S.

According to the first embodiment as described above, the following operations and effects are obtained.
(1) The image sensor 22 includes, for example: first focus detection pixels 11, 13 including photoelectric conversion units 41 that photoelectrically convert light of a first wavelength region, and reflective units 42A, 42B that reflect portions of the light that passes through the photoelectric conversion units 41 back to the photoelectric conversion units 41; and second focus detection pixels 14, 15 including photoelectric conversion units 41 that photoelectrically convert light of a second wavelength region that is shorter in wavelength than the first wavelength region, and light interception units 44B, 44A that intercept portions of the light incident upon the photoelectric conversion units 41. Since a portion of the light of the first wavelength region is photoelectrically converted in the first focus detection pixels 11, 13, accordingly it is possible to take advantage of the characteristic of long wavelength light (i.e. red color light) that its transmittance through a semiconductor substrate is high. Furthermore, it is possible to take advantage of the characteristic of short wavelength light (i.e. blue color light) that negative influence is not easily experienced due to being miniaturized in the second focus detection pixels 14, 15. By providing pixels that are of different types due to their wavelength regions, it is possible to obtain an image sensor 22 that is suitable for focus detection at several different wavelengths.
(2) The first focus detection pixels 11, 13 of the image sensor 22 have, for example, color filters 43 that pass light of a first wavelength region, and their photoelectric conversion units 41 photoelectrically convert light that has passed through their color filters 43, while their respective reflective units 42A, 42B reflect portions of the light that has passed through their photoelectric conversion units 41 back to the photoelectric conversion units 41 again for a second time. And the second focus detection pixels 14, 15 of the image sensor 22 have, for example, color filters 43 that pass light of a second wavelength region whose wavelength is shorter than that of the first wavelength region, and their respective light interception units 44B, 44A intercept portions of the light that is incident upon their photoelectric conversion units 41. Due to this, it is possible to take advantage of the characteristic of long wavelength light (i.e. red color light) that its transmittance through the semiconductor substrate is high in the focus detection pixels 11, 13. Furthermore, it is possible to take advantage of the characteristic of short wavelength light (i.e. blue color light) in which negative influence is not easily experienced from miniaturization, in the second focus detection pixels 14, 15.
(3) The image sensor 22 includes, for example: first focus detection pixels 11, 13 including color filters 43 that pass light of a first wavelength region, photoelectric conversion units 41 that photoelectrically convert light that has passed through the color filters 43, and reflective units 42A, 42B that reflect some light that passes through the photoelectric conversion units 41; and second focus detection pixels 14, 15 including color filters 43 that pass light of a second wavelength region that is shorter in wavelength than the first wavelength region, photoelectric conversion units 41 that photoelectrically convert light that has passed through the color filters 43, and light interception units 44B, 44A that intercept and block off portions of the light incident upon the photoelectric conversion units 41. Since a portion of the transmitted light of the first wavelength region is photoelectrically converted by the first focus detection pixels 11, 13, accordingly it is possible to utilize the characteristic of long wavelength light (i.e. red color light) that its transmittance through a semiconductor substrate is high. Furthermore, it is possible to utilize the characteristic of short wavelength light (i.e. blue color light) that negative influence is not easily experienced due to miniaturization, in the second focus detection pixels 14, 15. By providing pixels that are of different types because of their wavelength regions, it is possible to obtain an image sensor 22 that is suitable for photoelectric conversion at different wavelengths.
(4) The image sensor 22 includes, for example: first focus detection pixels 11, 13 that include color filters 43 that pass light of a first wavelength region, and in which photoelectric conversion units 41 that photoelectrically convert light that has passed through the color filters 43 are disposed between the color filters 43 and reflective units 42A, 42B that reflect some of the light that passes through the photoelectric conversion units 41 back to the photoelectric conversion units 41; and second focus detection pixels 14, 15 including light interception units 44B, 44A, between color filters 43 that pass light of a second wavelength region that is shorter in wavelength than the first wavelength region and photoelectric conversion units 41 that photoelectrically convert light that has passed through the color filters 43, that intercept and block off portions of the light incident upon the photoelectric conversion units 41. Due to this, it is possible to utilize the characteristic of long wavelength light (i.e. red color light) that its transmittance through the semiconductor substrate is high, in the first focus detection pixels 11, 13. Furthermore, it is possible to utilize the characteristic of short wavelength light (i.e. blue color light) that negative influence is not easily experienced due to being miniaturized, in the second focus detection pixels 14, 15. By providing pixels that are of different types because of their wavelength regions, it is possible to obtain an image sensor 22 that is suitable for photoelectric conversion at different wavelengths.
(5) The photoelectric conversion units 41 of the first focus detection pixels 11, 13 of the image sensor 22 generate electric charge by photoelectrically converting light that has been reflected by the reflective units 42A, 42B, and the photoelectric conversion units 41 of the second focus detection pixels 14, 15 photoelectrically convert the light that has not been intercepted by the light interception units 44B, 44A. Due to this, it is possible to provide the image sensor 22 with pixels whose types are different.
(6) The image sensor 22 includes the plurality of first focus detection pixels 11, 13, and has the first focus detection pixels 11 whose reflective units 42A are provided at the first distance D1 from neighboring pixels, and the first focus detection pixels 13 whose reflective units 42B are provided at the second distance D2 from neighboring pixels, which is different from the first distance D1. Due to this, it is possible to provide the first focus detection pixels 11, 13 of the reflection type in pairs to the image sensor 22.
(7) The image sensor 22 includes the plurality of second focus detection pixels 14, 15, and has the second focus detection pixels 14 whose light interception units 44B are provided at the third distance D3 from neighboring pixels, and the second focus detection pixels 15 whose light interception units 44A are provided at the fourth distance D4 from neighboring pixels, which is different from the fourth distance D3. Due to this, it is possible to provide the second focus detection pixels 14, 15 of the light intercepting type in pairs to the image sensor 22.
(8) The image sensor 22 includes: first focus detection pixels 11, 13 including micro lenses 40, photoelectric conversion units 41 that photoelectrically convert light passing through the micro lenses 40, and reflective units 42A, 42B that reflect light that has passed through the photoelectric conversion units 41 back to the photoelectric conversion units 41; and imaging pixels 12 including micro lenses 40 and photoelectric conversion units 41 that photoelectrically convert light passing through the micro lenses 40; and the positions of condensation of light incident upon the first focus detection pixels 11, 13 and upon the imaging pixels 12 are made to be different. For example, it is possible to prevent light that has passed through the micro lenses 40 of the first focus detection pixels 11, 13 from being incident upon regions other than the photoelectric conversion units 41, and it is possible to prevent light that has passed through the micro lenses 40 of the first focus detection pixels 11, 13 from leaking to the other imaging pixels 12. Due to this, an image sensor 22 is obtained with which the amounts of electric charge generated by the photoelectric conversion units 41 are increased.
(9) Furthermore, the image sensor 22 includes: first focus detection pixels 11, 13 including micro lenses 40, photoelectric conversion units 41 that photoelectrically convert light that has passed through the micro lenses 40, and reflective units 42A, 42B that reflect some of the light that passes through the photoelectric conversion units 41 back to the photoelectric conversion units 41; and second focus detection pixels 14, 15 including micro lenses 40, photoelectric conversion units 41 that photoelectrically convert light that has passed through the micro lenses 40, and light interception units 44B, 44A that intercept and block off portions of the light incident upon the photoelectric conversion units 41; and the positions where incident light is condensed upon the first focus detection pixels 11, 13 and upon the second focus detection pixels 14, 15 are made to be different. For example, in the case of the first focus detection pixels 11, 13, incident light is condensed upon the reflective units 42A, 42B, whereas in the case of the second focus detection pixels 14, 15, incident light is condensed upon the light interception units 44B, 44A. Since, due to this, it is possible to condense the incident light upon the pupil splitting structures for the focus detection pixels (in the case of the first focus detection pixels 11, 13, upon the reflective units 42A, 42B, and in the case of the second focus detection pixels 14, 15, upon the light interception units 44B, 44A), accordingly the accuracy of pupil splitting is enhanced, as compared to the case when the light is not condensed upon a pupil splitting structure. As a result, an image sensor 22 is obtained in which the accuracy of focus detection by pupil-split type phase difference detection is enhanced.
(10) Since the focal lengths of the micro lenses 40 of the first focus detection pixels 11, 13 of the image sensor 22 are made to be longer than the focal lengths of the micro lenses 40 of the second focus detection pixels 14, 15 of the image sensor 22, accordingly it is possible appropriately to condense the incident light upon the pupil splitting structures for the focus detection pixels (in the case of the first focus detection pixels 11, 13, upon the reflective units 42A, 42B, and in the case of the second focus detection pixels, upon the light interception units 44B, 44A). Due to this, the accuracy of pupil splitting is increased, and an image sensor 22 is obtained in which the accuracy of detection by pupil-split type phase difference detection is enhanced.
(11) The focus detection device of the camera 1 includes: the plurality of first focus detection pixels 13 that include the photoelectric conversion units 41 that receive first and second ray bundles that have respectively passed through the first and second pupil regions 61, 62 of the exit pupil 60 of the imaging optical system 31, and the reflective units 42B that reflect the first ray bundles that have passed through the photoelectric conversion units 41 back to the photoelectric conversion units 41; the plurality of first focus detection pixels 11 that include the photoelectric conversion units 41 that receive first and second ray bundles that have respectively passed through the first and second pupil regions 61, 62 of the exit pupil 60 of the imaging optical system 31, and the reflective units 42A that reflect the second ray bundles that have passed through the photoelectric conversion units 41 back to the photoelectric conversion units 41; the focus detection unit 21a that performs focus detection of the imaging optical system 31 on the basis of the focus detection signals of the first focus detection pixels 13 and on the basis of the focus detection signals of the first focus detection pixels 11; the plurality of second focus detection pixels 15 that include the photoelectric conversion units 41 that receive one of first and second ray bundles that have respectively passed through the first and second pupil regions 61, 62 of the exit pupil 60 of the imaging optical system 31; the plurality of second focus detection pixels 14 that include the photoelectric conversion units 41 that receive the other of first and second ray bundles that have respectively passed through the first and second pupil regions 61, 62 of the exit pupil 60 of the imaging optical system 31; and the focus detection unit 21a that performs focus detection of the imaging optical system 31 on the basis of the focus detection signals of the second focus detection pixels 15 and on the basis of the focus detection signals of the second focus detection pixels 14. It is possible to perform focus detection in an appropriate manner on the basis of the focus detection signals from these focus detection pixels whose types are different.
(12) The image sensor 22 includes R, G, and B imaging pixels 12 that respectively have color filters 43 that pass spectral components in the different R, G, and B wavelength bands, and the first focus detection pixels 11, 13 are provided in positions to replace some of the R imaging pixels 12 and moreover have R color filters 43, while the second focus detection pixels 14, 15 are provided in positions to replace some of the B imaging pixels 12 and moreover have B color filters 43. Since the first focus detection pixels 11, 13 are provided in positions for R pixels, accordingly it is possible for them to take advantage of the characteristic of long wavelength light (i.e. of red color light) that the transmittance through the semiconductor substrate is high. Moreover, since the second focus detection pixels 14, 15 are provided in positions for B pixels, accordingly it is possible for them to avoid the positions for R pixels where negative influence could easily be experienced due to miniaturization.
(13) The wavelength of R light is longer than that of G light, and the wavelength of G light is longer than that of B light. On the image sensor 22, pixel rows 401 in which R imaging pixels 12 and G imaging pixels 12 are, for example, arranged alternately in the X axis direction, and pixel rows 402 in which G imaging pixels 12 and B imaging pixels 12 are, for example, arranged alternately in the X axis direction, are arranged, for example, alternately in the Y axis direction. On such an image sensor 22 upon which R pixels, G pixels, and B pixels are provided according to a so-called Bayer array, it is possible to provide focus detection pixels whose types, as described above, are different.
(14) In the image sensor 22, since the pixel row 401S in which the first focus detection pixels 11, 13 are provided and the pixel row 402S in which the second focus detection pixels 14, 15 are provided mutually approach one another in the direction of the Y axis as described above, accordingly even though, for example, it is not possible to obtain blue color phase difference information at the pixel row 401S, it is still possible to obtain blue color phase difference information at the adjacent pixel row 402S. Conversely even though, for example, it is not possible to obtain red color phase difference information at the pixel row 402S, it is still possible to obtain red color phase difference information at the adjacent pixel row 401S. In this manner, due to complementary effects, this structure can make a contribution to improvement of phase difference detection accuracy.
(15) Since the first focus detection pixels 11, 13 are not provided with any light interception layers upon their light incident surfaces for phase difference detection, unlike the second focus detection pixels 14, 15 which do have the light intercepting layers 44B, 44A, accordingly it is possible to avoid the apertures of these pixels becoming smaller. Furthermore since, in the first focus detection pixels 11, 13, the light that has passed through the photoelectric conversion units 41 is reflected by the reflective units 42A, 42B back to the photoelectric conversion units 41, accordingly it is possible to increase the amount of electric charge generated by the photoelectric conversion units 41 of these pixels.
(16) Since, as with the focusing areas 101-1 through 101-3 of Fig. 2 for example, the focusing areas arranged in the vertical direction are arranged separately, accordingly the pixel rows 401S in which the first focus detection pixels 11, 13 are arranged and the pixel rows 402S in which the second focus detection pixels 15, 14 are arranged are disposed in separate positions within the alternate repetitions of pixel rows 401 in which only imaging pixels 12 are arrayed, and pixel rows 402 in which only imaging pixels 12 are arrayed.
   For example, if the pixel row 401S in which the first focus detection pixels 11, 13 are arranged and the pixel row 402S in which the second focus detection pixels 15, 14 are arranged are included in rows for which reading out for motion imaging in a video mode (a moving image mode) is not performed, then, during such a video mode, then it will be possible to omit interpolation processing for the image signals at the positions of the first focus detection pixels 11, 13, and/or to omit interpolation processing for the image signals at the positions of the second focus detection pixels 14, 15.
(17) Since image signals are not obtained at the positions of the first focus detection pixels 11, 13, accordingly interpolation processing may be performed by employing the signals from the surrounding imaging pixels 12. Since, in this embodiment, imaging pixels 12 are present between the first focus detection pixels 11, 13 at positions of the same color as the first focus detection pixels 11, 13 (in this embodiment, R pixels), accordingly it is possible to interpolate the image signals at the positions of the first focus detection pixels 11, 13 in an appropriate manner.

In a similar manner, since image signals of imaging pixels 12 at the positions of the second focus detection pixels 14, 15 cannot be obtained, accordingly interpolation is performed by employing image signals from surrounding imaging pixels 12. Since, in this embodiment, imaging pixels 12 are present between the second focus detection pixels 14, 15 at positions of the same color as the second focus detection pixels 14, 15 (in this embodiment, B pixels), accordingly it is possible to interpolate the image signals at the positions of the second focus detection pixels 14, 15 in an appropriate manner.

Variants of the following types also come within the range of the present invention, and moreover it would be possible to combine one or a plurality of these variant embodiments with the embodiment described above.

### The First Variant Embodiment

As in the case of the first embodiment, it is desirable for the position of the exit pupil 60 of the imaging optical system 31 and the positions in the Z axis direction of the pupil splitting structure of the focus detection pixels (i.e., in the case of the first focus detection pixels 11, 13, the reflective units 42A, 42B, and, in the case of the second focus detection pixels 14, 15, the light interception units 44B, 44A) to be made to be mutually conjugate. However, if the phase difference detection accuracy of the photographic subject image is acceptable, then it would also be acceptable to provide a structure of the following type. For example, for the first focus detection pixels 11, 13, in relation to the micro lenses 40, the position of the exit pupil 60 of the imaging optical system 31 and positions intermediate in the thickness direction (i.e. in the Z axis direction) of the photoelectric conversion units 40 may be made to be mutually conjugate. And, for the second focus detection pixels 14, 15, in relation to the micro lenses 40, the position of the exit pupil 60 of the imaging optical system 31 and positions intermediate in the thickness direction of the photoelectric conversion units 40 may be made to be mutually conjugate. By providing a structure of this type it is possible to make the optical powers of the micro lenses 40 for the imaging pixels 12, the first focus detection pixels 11, 13, and the second focus detection pixels 14, 15 be the same, and accordingly it is possible to keep down the manufacturing cost, as compared with a case of providing micro lenses 40 whose optical powers are different.

### The Second Variant Embodiment

It would also be possible to vary the positions of condensation of the incident light upon the various pixels by employing optical characteristic adjustment layers, while keeping the optical powers of the micro lenses 40 of the imaging pixels 12, of the first focus detection pixels 11, 13, and of the second focus detection pixels 14, 15 all the same. In other words it would also be acceptable to arrange, in this manner, for the position of the exit pupil 60 of the imaging optical system 31, and the intermediate positions in the Z axis direction of the photoelectric conversion units 41 of the imaging pixels 12 and the positions of the pupil splitting structures of the focus detection pixels in the Z axis direction (in the case of the first focus detection pixels 11, 13, the positions of the reflective units 42A, 42B, and in the case of the second focus detection pixels 14, 15, the positions of the light interception units 44B, 44A) to be mutually conjugate. Such an optical characteristic adjustment layer is a member for adjusting the length of the optical path; for example, it may include an inner lens or the like having a higher refractive index or a lower refractive index than the material of the micro lens 40.

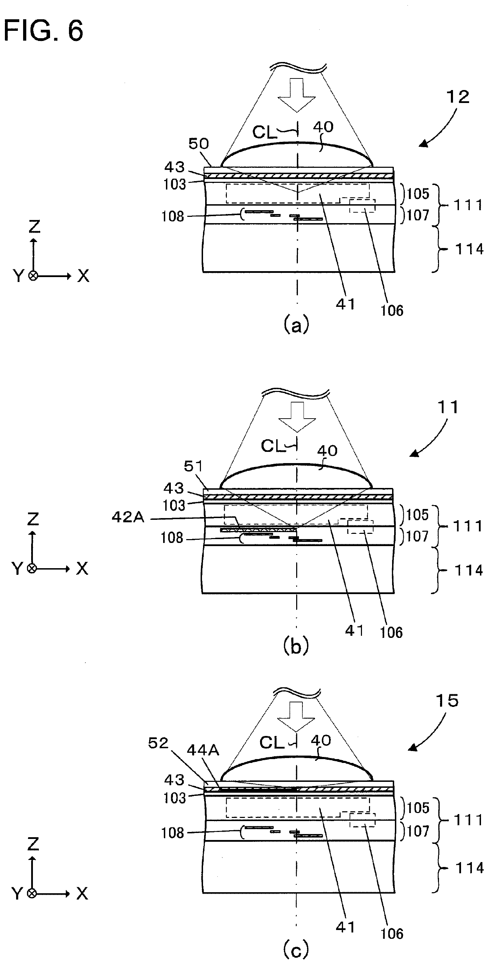

Fig. 6(a) is an enlarged sectional view of an imaging pixel 12 in this second variant embodiment, and Fig. 6(b) is an enlarged sectional view of a first focus detection pixel 11 of this second variant embodiment. Moreover, Fig. 6(c) is an enlarged sectional view of a second focus detection pixel 15 of this second variant embodiment. To structures in Figs. 6(a), 6(b), and 6(c) that are similar to ones of Figs. 4(a), 4(b), and 4(c), the same reference symbols are appended, and explanation thereof is curtailed.

To compare the imaging pixels 12 of Fig. 6(a) and Fig. 4(a), the feature of difference is that the imaging pixel 12 in Fig. 6(a) is provided with an optical characteristic adjustment layer 50 between its micro lens 40 and its photoelectric conversion unit 41. In Fig. 6(a), as an example, the optical characteristic adjustment layer 50 is provided above the color filter 43 (i.e. in the +Z axis direction therefrom). By the provision of this optical characteristic adjustment layer 50, the focal length of the micro lens 40 is substantially adjusted. The configuration of this second variant embodiment is such that a position in the photoelectric conversion unit 41 of the imaging pixel 12 intermediate in its thickness direction and the position of the exit pupil 60 of the imaging optical system 31 are mutually conjugate with respect to the micro lens 40.

It should be understood that it would also be acceptable to provide the optical characteristic adjustment layer 50 below the color filter 43 (i.e. in the -Z axis direction therefrom).

And, to compare the first focus detection pixels 11 of Fig. 6(b) and Fig. 4(b), the feature of difference is that the first focus detection pixel 11 in Fig. 6(b) is provided with an optical characteristic adjustment layer 51 between its micro lens 40 and its photoelectric conversion unit 41. In Fig. 6(b), as an example, the optical characteristic adjustment layer 51 is provided above the color filter 43 (i.e. in the +Z axis direction therefrom). By the provision of this optical characteristic adjustment layer 51, the focal length of the micro lens 40 is substantially adjusted. In this manner, the configuration of this second variant embodiment is set up so that the position of the reflective unit 42A of the first focus detection pixel 11 and the position of the exit pupil 60 of the imaging optical system 31 are mutually conjugate with respect to the micro lens 40.

It should be understood that it would also be acceptable to provide the optical characteristic adjustment layer 51 below the color filter 43 (i.e. in the -Z axis direction therefrom).

Moreover, to compare the second focus detection pixels 15 of Fig. 6(c) and Fig. 4(c), the feature of difference is that the second focus detection pixel 15 in Fig. 6(c) is provided with an optical characteristic adjustment layer 52 between its micro lens 40 and its photoelectric conversion unit 41. In Fig. 6(c), as an example, the optical characteristic adjustment layer 52 is provided above the color filter 43 (i.e. in the +Z axis direction therefrom). By the provision of this optical characteristic adjustment layer 52, the focal length of the micro lens 40 is substantially adjusted. In this manner, the configuration of this second variant embodiment is set up so that the position of the light interception unit 44A of the second detection pixel 15 and the position of the exit pupil 60 of the imaging optical system 31 are mutually conjugate with respect to the micro lens 40.

It should be understood that it would also be acceptable to provide the optical characteristic adjustment layer 52 below the color filter 43 (i.e. in the -Z axis direction therefrom).

While, with reference to Figs. 6(a), 6(b), and 6(c) that have been employed for explanation of this second variant embodiment, it has been explained that the optical characteristic adjustment layer 50 was provided to the imaging pixel 12, the optical characteristic adjustment layer 51 was provided to the first focus detection pixel 11, and the optical characteristic adjustment layer 52 was provided to the second focus detection pixel 15; but it would also be acceptable to arrange to provide an optical characteristic adjustment layer to only one, at least, among the imaging pixel 12, the first focus detection pixel 11, and the second focus detection pixel 15.

Furthermore, although the description has referred to the first focus detection pixel 11 and the second focus detection pixel 15, the same remarks hold for the first focus detection pixel 13 and the second focus detection pixel 14.

According to this second variant embodiment as explained above, it is possible to prevent the light transmitted through the micro lenses 40 of the pixels from being incident upon regions of the pixels other than their photoelectric conversion units 41, and it is possible to prevent leakage of the light that has passed through the micro lenses 40 of the pixels to other pixels. Due to this, an image sensor 22 is obtained with which the amounts of electric charge generated by the photoelectric conversion units 41 are increased.

Further, according to this second variant embodiment, due to the light being condensed onto the pupil splitting structures in the focus detection pixels (in the case of the first focus detection pixels 11, 13, the reflective units 42A, 42B, and in the case of the second focus detection pixels 14 and 15, the light interception units 44B, 44A), the accuracy of pupil splitting is improved, as compared to a case in which the light is not condensed onto a pupil splitting structure. As a result, an image sensor 22 can be obtained in which the accuracy of detection by pupil-split type phase difference detection is enhanced.

It should be understood that, among the imaging pixels 12, the first focus detection pixels 11, 13, and the second focus detection pixels 14, 15, in addition to providing optical characteristic adjustment layers to, at least, the imaging pixels 12, or the first focus detection pixels 11, 13, or the second focus detection pixels 14, 15, it would also be acceptable to arrange to make the position of the exit pupil 60 of the imaging optical system 31, and the positions intermediate in the Z axis direction of the photoelectric conversion units 41 of the imaging pixels 12 and the positions in the Z axis direction of the pupil splitting structures of the focus detection pixels (in the case of the first focus detection pixels 11, 13, the reflective units 42A, 42B, and in the case of the second focus detection pixels 14 and 15, the light interception units 44B, 44A) be mutually conjugate by varying the optical powers of the micro lenses 40.

### The Third Variant Embodiment

Generally, when focus detection pixels are arranged along the row direction (i.e. along the X axis direction), in other words in the horizontal direction, this is appropriate when performing focus detection upon a photographic subject pattern that extends in the vertical direction. Moreover, when focus detection pixels are arranged in the column direction (i.e. along the Y axis direction), in other words in the vertical direction, this is appropriate when performing focus detection upon a photographic subject pattern that extends in the horizontal direction. Due to this, it is desirable to have focus detection pixels that are arranged in the horizontal direction and also to have focus detection pixels that are arranged in the vertical direction, so that focus detection can be performed irrespective of the pattern on the photographic subject.

Accordingly, in the third variant embodiment, in the focusing areas 101-1 through 101-3 of Fig. 2 for example, first focus detection pixels 11, 13 and second focus detection pixels 14, 15 are arranged in the horizontal direction. Furthermore, in the focusing areas 101-4 through 101-11 of Fig. 2 for example, first focus detection pixels 11, 13 and second focus detection pixels 14, 15 are arranged in the vertical direction. By providing this structure, the focus detection pixels in the image sensor 22 are arranged both in the horizontal direction and also in the vertical direction.

It should be understood that, if the first focus detection pixels 11, 13 are arranged in the vertical direction, then the reflective units 42A, 42B of the first focus detection pixels 11, 13 should respectively be arranged to correspond to the regions in almost the lower halves (on the -Y axis direction sides), and in almost the upper halves (on the +Y axis direction sides), of their respective photoelectric conversion units 41. In the XY plane, at least a part of the reflective unit 42A of each of the first focus detection pixels 11 is provided in a region toward the side in the -Y axis direction, among the regions subdivided by a line intersecting the line CL in Fig. 4 and parallel to the X axis. And, in the XY plane, at least a part of the reflective unit 42B of each of the first focus detection pixels 13 is provided in a region toward the side in the +Y axis direction, among the regions subdivided by a line intersecting the line CL in Fig. 4 and parallel to the X axis.

Furthermore, if the second focus detection pixels 14, 15 are arranged in the vertical direction, then the light interception units 44B, 44A of the second focus detection pixels 14, 15 should respectively be arranged to correspond to the regions in almost the upper halves (on the +Y axis direction sides), and in almost the lower halves (on the -Y axis direction sides), of their respective photoelectric conversion units 41. In the XY plane, at least a part of the light interception unit 44B of each of the second focus detection pixels 14 is provided in a region toward the side in the +Y axis direction, among the regions subdivided by a line intersecting the line CL in Fig. 4 and parallel to the X axis. And, in the XY plane, at least a part of the light interception unit 44A of each of the second focus detection pixels 14 is provided in a region toward the side in the -Y axis direction, among the regions subdivided by a line intersecting the line CL in Fig. 4 and parallel to the X axis.

By arranging the focus detection pixels in the horizontal direction and in the vertical direction as described above, it becomes possible to perform focus detection, irrespective of the direction of any pattern of the photographic subject.

It should be understood that, in the focusing areas 101-1 through 101-11 of Fig. 2, it would also be acceptable to arrange the first focus detection pixels 11, 13 and the second focus detection pixels 14, 15 respectively in the horizontal direction and in the vertical direction. By providing this structure, it becomes possible to perform focus detection with any of the focusing areas 101-1 through 101-11, whatever may be the direction of the pattern upon the photographic subject.

### The Fourth Variant Embodiment

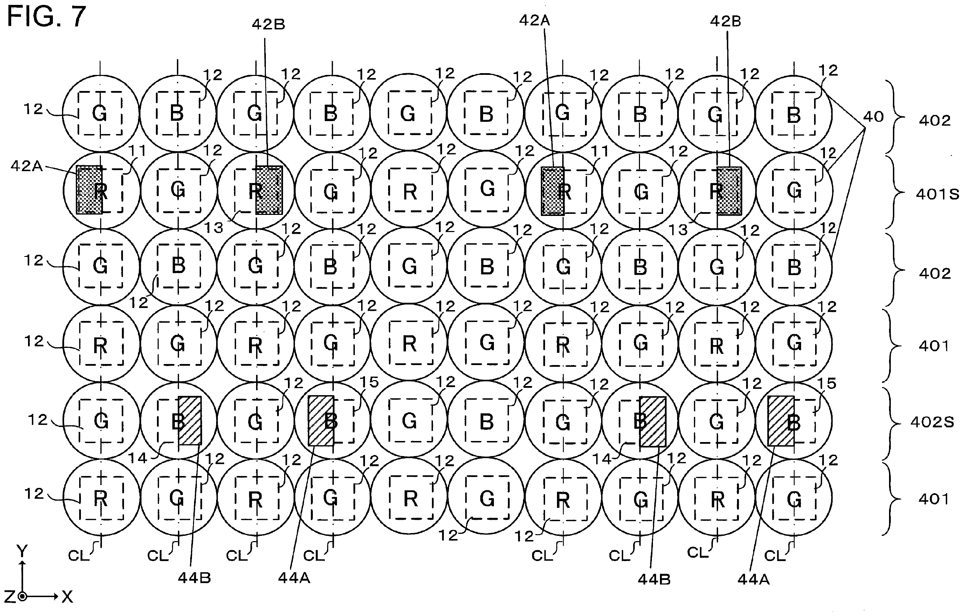

It would also be possible to arrange individual units made up from first focus detection pixels 11, 13 and an imaging pixel 12 sandwiched between them, and individual units made up from second focus detection pixels 14, 15 and an imaging pixel 12 sandwiched between them, at any desired intervals in the column direction (i.e. in the Y axis direction). Specifically, the interval in the column direction between a pixel row 401S in which first focus detection pixels 11, 13 are disposed and a pixel row 402S in which second focus detection pixels 15, 14 are disposed may be set to be wider than the interval of the first embodiment (refer to Fig. 3). Fig. 7 is an enlarged figure showing a portion of the arrangement of pixels on the image sensor 22 according to this fourth variant embodiment, and shows an example of a case in which the first focus detection pixels 11, 13 and the second focus detection pixels 14, 15 are arranged along the row direction (i.e. in the X axis direction), in other words in the horizontal direction. In a similar manner to the case shown in Fig. 3, each of the first focus detection pixels 11, 13 is disposed at a position where otherwise an R pixel would be, and each of the second focus detection pixels 14, 15 is disposed at a position where otherwise a B pixel would be.

When the interval between the pixel row 401S in which the first focus detection pixels 11, 13 are disposed and the pixel row 402S in which the second focus detection pixels 14, 15 are disposed is widened as shown in Fig. 7, then the beneficial feature is obtained that the density of the focus detection pixels in the column direction (i.e. in the Y axis direction), from which it is not possible to obtain image signals, is kept low, as compared to the case of Fig. 3 in which they are adjacent to one another.

Moreover, if the color of the photographic subject is only red, then it is possible to perform phase difference detection with the first focus detection pixels 11, 13, while, if the color of the photographic subject is only blue, then it is possible to perform phase difference detection with the second focus detection pixels 15, 14.

According to this fourth variant embodiment explained above, in the image sensor 22, it is arranged to separate the pixel row 401S in which the first focus detection pixels 11, 13 are provided and the pixel row 402S in which the second focus detection pixels 14, 15 are provided from one another in the direction of the Y axis, as described above. Due to this, it is possible to prevent the pixel positions at which image signals cannot be obtained from being too densely packed together, as compared to the case in which the pixel row 401S and the pixel row 402S are adjacent in the Y axis direction.

### The Fifth Variant Embodiment

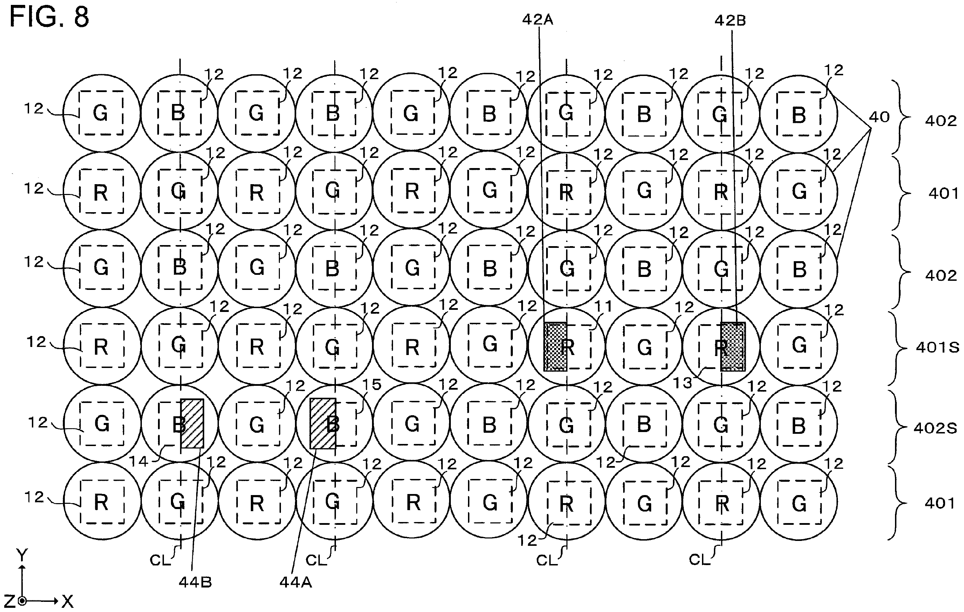

Individual units composed of first focus detection pixels 11, 13 and single imaging pixels 12 sandwiched between them may be arranged at any desired intervals along the row direction (the X axis direction). In a similar manner, individual units composed of second focus detection pixels 14, 15 and single imaging pixels 12 sandwiched between them may be arranged at any desired intervals along the row direction (the X axis direction). Fig. 8 is an enlarged view of a portion of a pixel array upon an image sensor 22 according to this fifth variant embodiment, and shows an example of a case in which the first focus detection pixels 11, 13 and the second focus detection pixels 14, 15 are arranged along the row direction (the X axis direction), in other words in the horizontal direction. In a similar manner to the case in the first embodiment (refer to Fig. 3), the first focus detection pixels 11, 13 are each disposed in a position for an R pixel, and the second focus detection pixels 14, 15 are each disposed in a position for a B pixel.

In Fig. 8, the intervals along the row direction (the X axis direction) between individual units each composing first focus detection pixels 11, 13 and an imaging pixel 12 sandwiched between them are longer than in the case of Fig. 3, and include imaging pixels 12 of the same color (in this example, R pixels) as the first focus detection pixels 11, 13.

Moreover, the intervals along the row direction (the X axis direction) between individual units each composing second focus detection pixels 14, 15 and an imaging pixel 12 sandwiched between them are also longer than in the case of Fig. 3, and include imaging pixels 12 of the same color (in this example, B pixels) as the second focus detection pixels 14, 15.

Furthermore, the positions along the row direction (the X axis direction) of the individual units including the first focus detection pixels 11, 13 described above and the positions of the individual units including the second focus detection pixels 14, 15 described above are shifted sidewise apart (i.e. are displaced from one another) along the row direction (the X axis direction). Since this displacement of position along the row direction (the X axis direction) is present between the individual units including the first focus detection pixels 11, 13 described above and the individual units including the second focus detection pixels 14, 15 described above, accordingly, as compared to the case of Fig. 3, there is the benefit that the density of the focus detection pixels, from which image signals cannot be obtained, is kept down.

Yet further, if the color of the photographic subject is only red, then phase difference detection can be performed by the first focus detection pixels 11, 13, while if the color of the photographic subject is only blue, then phase difference detection can be performed by the second focus detection pixels 14, 15.

According to this fifth variant embodiment explained above, in the image sensor 22, it is arranged for the positions of the first focus detection pixels 11, 13 in the pixel row 401S in which the first focus detection pixels 11, 13 are provided and the positions of the second focus detection pixels 14, 15 in the pixel row 402S in which the second focus detection pixels 14, 15 are provided to be displaced sideways from one another in the X axis direction described above. Due to this, it is possible to avoid over-dense packing of the pixel positions from which image signals cannot be obtained, as compared with the case of Fig. 3 in which the positions of the first focus detection pixels 11, 13 and the positions of the second focus detection pixels 14, 15 are not displaced from one another.

### The Sixth Variant Embodiment

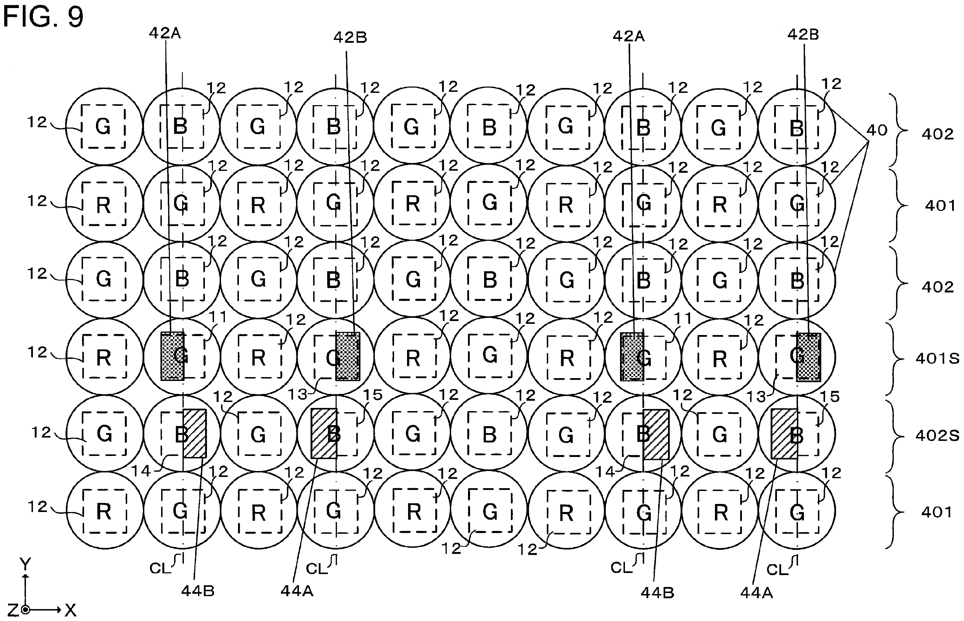

Fig. 9 is an enlarged view of a portion of a pixel array upon an image sensor 22 according to a sixth variant embodiment, and shows an example of a case in which first focus detection pixels 11, 13 and second focus detection pixels 14, 15 are arranged along the row direction (the X axis direction), in other words in the horizontal direction. As compared with the first embodiment (refer to Fig. 3), the first focus detection pixels 11, 13 are different, in the feature that each of them is disposed in a position for a G pixel, and the second focus detection pixels 14, 15 are the same as in the first embodiment, in the feature that each of them is arranged in a position for a B pixel.

When the R pixels, the G pixels, and the B pixels are arranged according to the arrangement of a Bayer array, the number of G pixels is larger than the number of R pixels or the number of B pixels. On the other hand, at the positions of the first focus detection pixels 11, 13, no image signal can be obtained from any imaging pixel 12. Accordingly it is possible to minimize the negative influence upon image quality by disposing the first focus detection pixels 11, 13 at positions for G pixels of which there are a larger number, as opposed to it not being possible to obtain image signals at positions for B pixels and/or R pixels, the number of which is lower.

According to this sixth variant embodiment as explained above, the image sensor 22 is provided with imaging pixels 12 that are R pixels, G pixels, and B pixels each having a color filter 43 for respective R, G, and B spectral components on different wavelength bands, and the first focus detection pixels 11, 13 are provided to replace some of the imaging pixels 12 that are G pixels and moreover have G color filters 43, while the second focus detection pixels 14, 15 are provided to replace some of the imaging pixels 12 that are B pixels and moreover have B color filters 43. Since the first focus detection pixels 11, 13 are provided at positions for G pixels of which the number is larger, accordingly it is possible to minimize the negative influence upon image quality, as compared to not being able to obtain image signals at positions for B pixels or R pixels of which the number is smaller. Moreover, it is also possible to take advantage of the characteristic of green color light, that the transmittance for green light of a semiconductor substrate is higher than for blue light. Even further, since the second focus detection pixels 14, 15 are provided at positions for B pixels, accordingly it is possible to avoid the positions for R pixels where negative influence due to miniaturization can most easily be experienced.

In the image sensor 22, since the pixel row 401S in which the first focus detection pixels 11, 13 are provided and the pixel row 402S in which the second focus detection pixels 14, 15 are provided close to one another in the direction of the Y axis mentioned above, accordingly even although, for example, it is not possible to obtain phase difference information for blue color in the pixel row 401S, still it is possible to obtain phase difference information for blue color in the adjacent pixel row 402S. Conversely even although, for example, it is not possible to obtain phase difference information for green color in the pixel row 402S, still it is possible to obtain phase difference information for green color in the adjacent pixel row 401S. In this manner, due to complementary effects, this can contribute to enhancement of the accuracy of phase difference detection.

### The Seventh Variant Embodiment

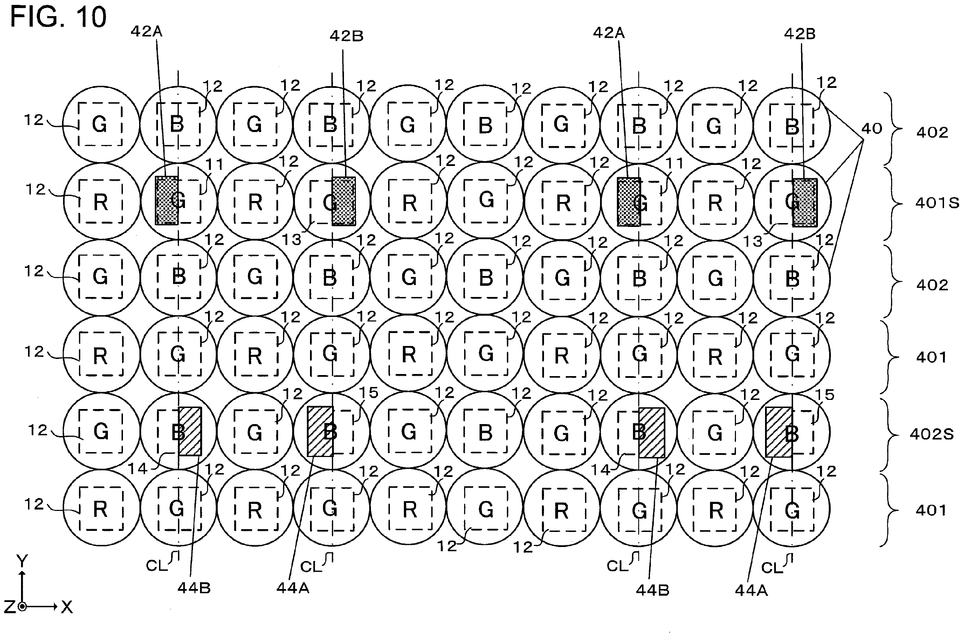

Even when the first focus detection pixels 11, 13 are disposed at positions for G pixels, it will still be acceptable to arrange to dispose the individual units consisting of first focus detection pixels 11, 13 and an imaging pixel 12 sandwiched between them, and the individual units consisting of the second focus detection pixels 14, 15 and an imaging pixel 12 sandwiched between them, at any desired intervals in the column direction (i.e. in the Y axis direction). In concrete terms, the interval in the column direction between the pixel row 401S in which the first focus detection pixels 11, 13 are disposed and the pixel row 402S in which the second focus detection pixels 14, 15 are disposed may be set to be wider than in the case of Fig. 9 (the sixth variant embodiment). Fig. 10 is an enlarged view of a portion of a pixel array upon an image sensor 22 according to a seventh variant embodiment, and shows an example of a case in which first focus detection pixels 11, 13 and second focus detection pixels 14, 15 are arranged along the row direction (the X axis direction), in other words in the horizontal direction. In a similar manner to the case with Fig. 9 (the sixth variant embodiment), each of the first focus detection pixels 11, 13 is disposed in a position for a G pixel, and each of the second focus detection pixels 14, 15 is disposed in a position for a B pixel.

When the interval between the pixel row 401S in which the first focus detection pixels 11, 13 are disposed and the pixel row 402S in which the second focus detection pixels 14, 15 are disposed is set to be wider, as in the case of Fig. 10, then, as compared to the case shown in Fig. 9 (the sixth variant embodiment) in which these rows are adjacent to one another in the column direction (i.e. in the Y axis direction), there is the benefit that the density in the column direction (i.e. in the Y axis direction) of the focus detection pixels, from which it is not possible to receive image signals, is kept lower.

According to this seventh variant embodiment explained above, in the image sensor 22, it is arranged mutually to separate the pixel row 401S in which the first focus detection pixels 11, 13 are provided and the pixel row 402S in which the second focus detection pixels 14, 15 are provided, in the Y axis direction mentioned above. Due to this, it is possible to prevent the pixel positions where no image signals can be received from being over-densely crowded together, as compared to the case in which the pixel row 401S and the pixel row 402S are adjacent to one another in the Y axis direction.

### The Eighth Variant Embodiment

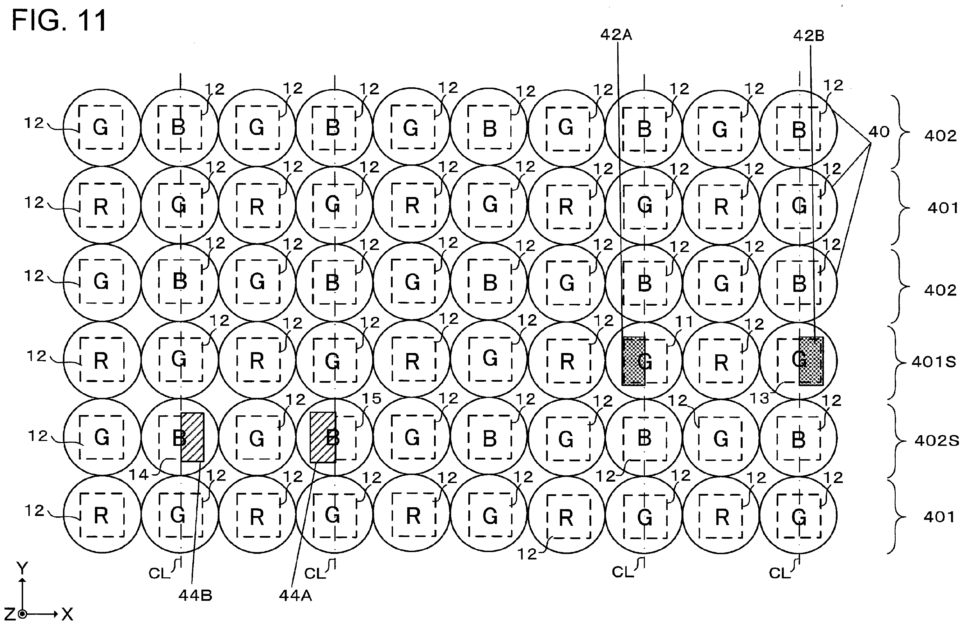

Even when the first focus detection pixels 11, 13 are disposed at positions for G pixels, it will still be acceptable to arrange to dispose the individual units consisting of first focus detection pixels 11, 13 and an imaging pixel 12 sandwiched between them, at any desired intervals along the row direction (i.e. in the X axis direction). In a similar manner, it will still be acceptable to arrange to dispose the individual units consisting of second focus detection pixels 14, 15 and an imaging pixel 12 sandwiched between them, at any desired intervals along the row direction (i.e. in the X axis direction). Fig. 11 is an enlarged view of a portion of a pixel array upon an image sensor 22 according to an eighth variant embodiment, and shows an example of a case in which first focus detection pixels 11, 13 and second focus detection pixels 14, 15 are arranged along the row direction (the X axis direction), in other words in the horizontal direction. In a similar manner to the case in Fig. 9 (the sixth variant embodiment), each of the first focus detection pixels 11, 13 is disposed at a position for a G pixel, and each of the second focus detection pixels 14, 15 is disposed at a position for a B pixel.

In Fig. 11, the intervals along the row direction (i.e. the X axis direction) between the units each consisting of first focus detection pixels 11, 13 and an imaging pixel 12 sandwiched between them are set to be wider than in the case of Fig. 9 (the sixth variant embodiment), and include imaging pixels 12 of the same color as the first focus detection pixels 11, 13 (in this embodiment, G pixels).

Furthermore, the intervals along the row direction (i.e. the X axis direction) between the units each consisting of second focus detection pixels 14, 15 and an imaging pixel 12 sandwiched between them are also set to be wider than in the case of Fig. 9 (the sixth variant embodiment), and include imaging pixels 12 of the same color as the second focus detection pixels 14, 15 (in this embodiment, B pixels).

Yet further, the positions along the row direction (the X axis direction) of the individual units including the first focus detection pixels 11, 13 described above and the positions of the individual units including the second focus detection pixels 14, 15 described above are shifted apart (i.e. are displaced from one another) along the row direction (the X axis direction). Since this displacement of position along the row direction (the X axis direction) is present between the individual units including the first focus detection pixels 11, 13 described above and the individual units including the second focus detection pixels 14, 15 described above, accordingly, as compared to the case of Fig. 9, there is the benefit that the density of the focus detection pixels, from which image signals cannot be obtained, is kept relatively low.

According to this eighth variant embodiment as explained above, in the image sensor 22, it is arranged to provide a displacement in the direction of the X axis mentioned above between the position of the first focus detection pixels 11, 13 in the pixel row 401 S in which the first focus detection pixels 11, 13 are provided, and the position of the second focus detection pixels 14, 15 in the pixel row 402S in which the second focus detection pixels 14, 15 are provided. Due to this, as compared with the case of Fig. 9 in which there is no deviation in the X axis direction between the positions of the first focus detection pixels 11, 13 and the positions of the second focus detection pixels 14, 15, it is possible to keep relatively low the density of the pixel positions at which it is not possible to obtain image signals.

### The Ninth Variant Embodiment

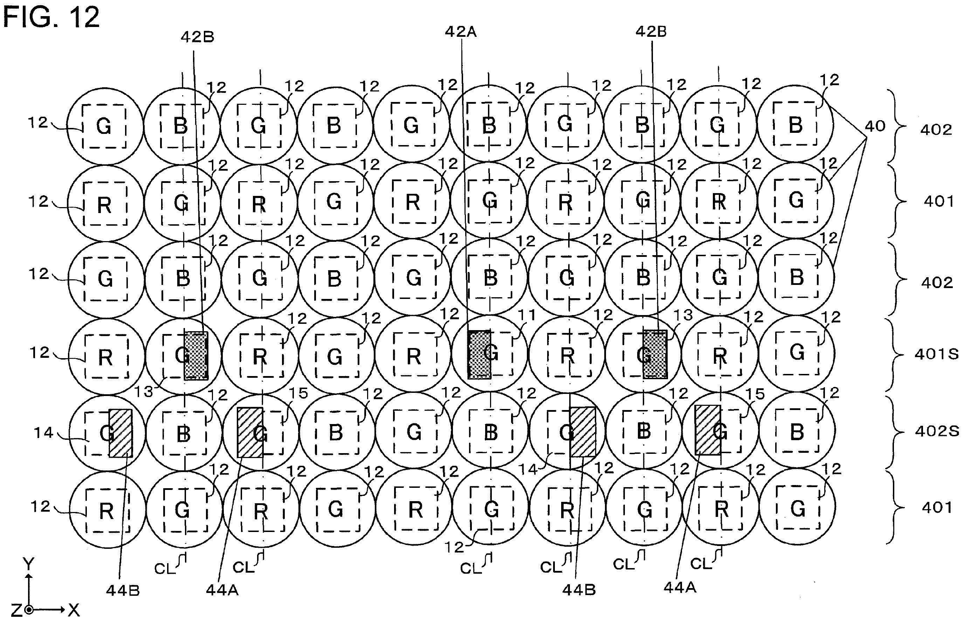

Fig. 12 is an enlarged view of a portion of a pixel array upon an image sensor 22 according to a ninth variant embodiment, and shows an example of a case in which first focus detection pixels 11, 13 and second focus detection pixels 14, 15 are arranged along the row direction (the X axis direction), in other words in the horizontal direction. As compared to the case of Fig. 9 (the sixth variant embodiment), there is the feature of similarity that each of the first focus detection pixels 11, 13 is disposed in a position for a G pixel, while there is the feature of difference that each of the second focus detection pixels 14, 15 is disposed in a position for a G pixel.

When the R pixels, the G pixels, and the B pixels are arranged according to the Bayer array configuration, by disposing the first focus detection pixels 11, 13 and the second focus detection pixels 14, 15 in positions for G pixels the number of which is larger, it is possible to reduce the negative influence upon image quality, as compared to the case if they were in positions for B pixels and for R pixels, the number of which is smaller.

Furthermore, since the first focus detection pixels 11, 13 and the second focus detection pixels 14, 15 are at positions for the same color, accordingly it is possible to enhance the accuracy of focus detection, because the occurrence of erroneous focus detection becomes less likely.

According to the ninth variant embodiment as explained above: the image sensor 22 comprises the imaging pixels 12 which are R pixels, G pixels, and B pixels having respective color filters 43 that pass spectral components of different R, G, and B wavelength bands; the first focus detection pixels 11, 13 are provided so as to replace some of the G imaging pixels 12 and moreover have G color filters; and the second focus detection pixels 14, 15 are provided so as to replace some of the G imaging pixels and moreover have G color filters 43. Since the first focus detection pixels 11, 13 and the second focus detection pixels 14, 15 are provided in positions for G pixels of which the number is larger, accordingly it is possible to avoid any negative influence upon image quality, as compared to a case in which it is not possible to obtain image signals at positions for B pixels or R pixels of which the number is smaller. Moreover, by disposing all the focus detection pixels at positions corresponding to the same color, it is possible to make it more difficult for erroneous focus detection to occur.

Since, in this image sensor 22, the pixel row 401S to which the first focus detection pixels 11, 13 are provided and the pixel row 402S to which the second focus detection pixels 14, 15 are provided are brought mutually to approach one another in the direction of the Y axis described above, accordingly the occurrence of erroneous focus detection becomes less likely.

### The Tenth Variant Embodiment

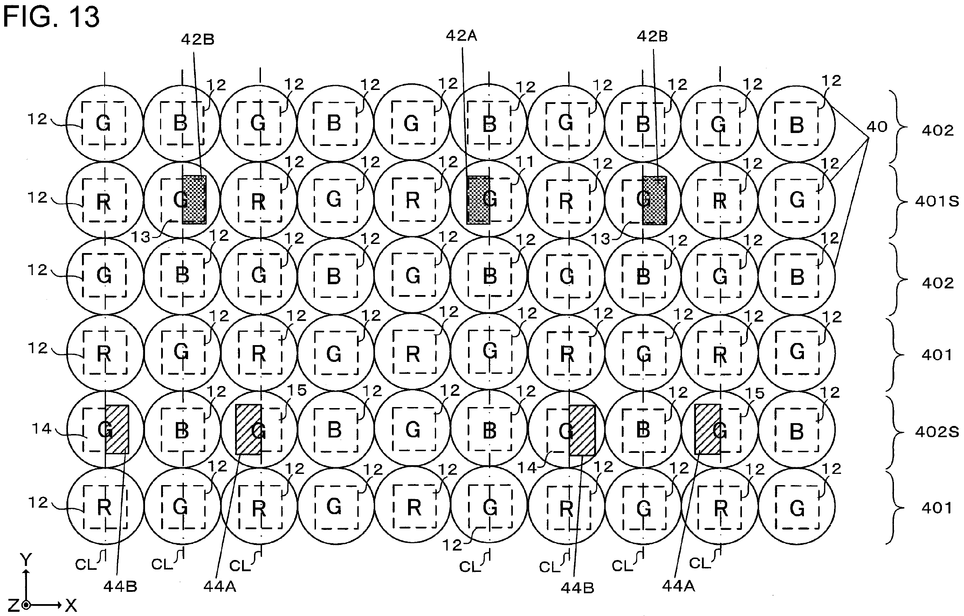

Even if the first focus detection pixels 11, 13 and the second focus detection pixels 14, 15 are disposed in positions for G pixels, it would also be acceptable to arrange to dispose the individual units consisting of first focus detection pixels 11, 13 and an imaging pixel sandwiched between them, and the individual units consisting of second focus detection pixels 14, 15 and an imaging pixel sandwiched between them, with any desired intervals between them in the column direction (i.e. in the Y axis direction). In concrete terms, the interval in the column direction between the pixel row 401S in which the first focus detection pixels 11, 13 are disposed and the pixel row 402S in which the second focus detection pixels 14, 15 are disposed may be made to be wider than the corresponding interval in the case of Fig. 12 (the ninth variant embodiment). Fig. 13 is an enlarged view of a portion of a pixel array upon an image sensor 22 according to a tenth variant embodiment, and shows an example of a case in which first focus detection pixels 11, 13 and second focus detection pixels 14, 15 are arranged along the row direction (the X axis direction), in other words along the horizontal direction. In a similar manner to the case of Fig. 12 (the ninth variant embodiment), each of the first focus detection pixels 11, 13 is disposed in a position for a G pixel, and each of the second focus detection pixels 14, 15 is also disposed in a position for a G pixel.

When, as in Fig. 13, the interval between the pixel row 401S in which the first focus detection pixels 11, 13 are disposed and the pixel row 402S in which the second focus detection pixels 14, 15 are disposed is made to be wider, then there is the benefit that excessive density in the column direction (i.e. the Y axis direction) of the focus detection pixels from which image signals cannot be obtained is avoided, as compared to the case of Fig. 12 (the ninth variant embodiment) in which these pixel rows are adjacent to one another in the column direction (the Y axis direction).

According to the tenth variant embodiment as explained above, it is arranged mutually to separate from one another the pixel row 401S in which the first focus detection pixels 11, 13 are disposed and the pixel row 402S in which the second focus detection pixels 14, 15 are disposed. Due to this, it is possible to avoid improperly high density of the pixel positions from which image signals cannot be obtained, as compared to the case in which the pixel row 401S and the pixel row 402S are adjacent to one another in the Y axis direction.

### The Eleventh Variant Embodiment

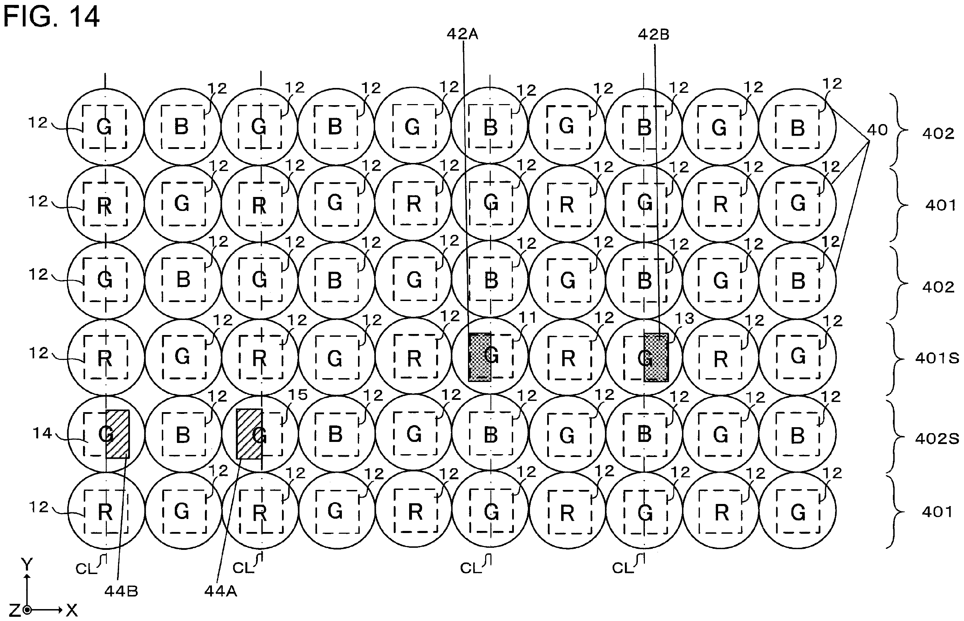

Even when the first focus detection pixels 11, 13 are disposed in positions for G pixels, it will still be acceptable to arrange for the individual units composed of first focus detection pixels 11, 13 and an imaging pixel sandwiched between them to be disposed at any desired intervals along the row direction (i.e. along the X axis direction). In a similar manner, it will be acceptable to arrange for the individual units composed of second focus detection pixels 14, 15 and an imaging pixel sandwiched between them to be disposed at any desired intervals along the row direction (i.e. along the X axis direction). Fig. 14 is an enlarged view of a portion of a pixel array upon an image sensor 22 according to this eleventh variant embodiment, and shows an example of a case in which first focus detection pixels 11, 13 and second focus detection pixels 14, 15 are arranged along the row direction (the X axis direction), in other words along the horizontal direction. In a similar manner to the case of Fig. 12 (the ninth variant embodiment), each of the first focus detection pixels 11, 13 is disposed in a position for a G pixel, and each of the second focus detection pixels 14, 15 is disposed in a position for a G pixel.

In Fig. 14, the intervals along the row direction (i.e. in the X axis direction) between the individual units composed of first focus detection pixels 11, 13 and an imaging pixel 12 sandwiched between them are wider than in the case of Fig. 12 (the ninth variant embodiment), and include imaging pixels of the same color as the first focus detection pixels 11, 13 (in this embodiment, G pixels).

Moreover, the intervals along the row direction (i.e. in the X axis direction) between the individual units composed of second focus detection pixels 14, 15 and an imaging pixel 12 sandwiched between them are also wider than in the case of Fig. 12 (the ninth variant embodiment), and include imaging pixels of the same color as the second focus detection pixels 14, 15 (in this embodiment, G pixels).

Furthermore, the individual units described above including the first focus detection pixels 11, 13 and the individual units described above including the second focus detection pixels 14, 15 are displaced (i.e. shifted) from one another along the row direction (i.e. the X axis direction). Since the positions along the row direction (the X axis direction) between the individual units including the first focus detection pixels 11, 13 and the individual units including the second focus detection pixels 14, 15 are displaced from one another, accordingly there is the benefit that excessive density of the focus detection pixels from which image signals cannot be obtained is avoided, as compared to the case of Fig. 12 (the ninth variant embodiment).

Moreover, since the first focus detection pixels 11, 13 and the second focus detection pixels 14, 15 are provided in positions for the same color, accordingly the occurrence of erroneous focus detection becomes less likely, and it is possible to enhance the accuracy of focus detection.

According to the eleventh variant embodiment as explained above, in this image sensor 22, it is arranged for the positions of the first focus detection pixels 11, 13 in the pixel rows 401S in which the first focus detection pixels 11, 13 are provided and the positions of the second focus detection pixels 14, 15 in the pixel rows 402S in which the second focus detection pixels 14, 15 are provided to be spaced apart from one another along the X axis direction, as described above. Due to this, it is possible to avoid excessive density of the pixel positions from which image signals cannot be obtained, as compared with the case of Fig. 12 in which the positions of the first focus detection pixels 11, 13 and the positions of the second focus detection pixels 14, 15 are not spaced apart along the X axis direction.

### The Twelfth Variant Embodiment

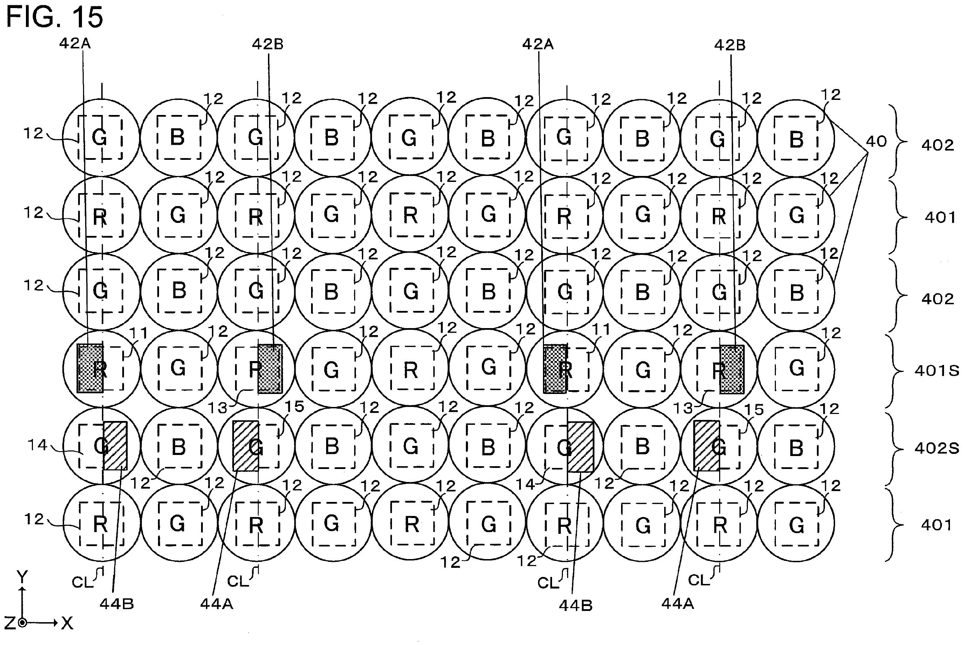

Fig. 15 is an enlarged view of a portion of a pixel array upon an image sensor 22 according to a twelfth variant embodiment, and shows an example of a case in which first focus detection pixels 11, 13 and second focus detection pixels 14, 15 are arranged along the row direction (the X axis direction), in other words in the horizontal direction. As compared to the first embodiment (refer to Fig. 3), there is the feature of similarity that each of the first focus detection pixels 11, 13 is disposed in a position for a R pixel, while there is the feature of difference that each of the second focus detection pixels 14, 15 is disposed in a position for a G pixel.

According to this twelfth variant embodiment, the following operations and effects are obtained.
(1) By disposing the second focus detection pixels 14, 15 in Bayer array positions for G pixels of which the number is greater, it is possible to suppress the negative influence upon image quality, as compared to the case of disposing them in positions for B pixels of which the number is smaller.
(2) With this image sensor 22 according to the twelfth variant embodiment, imaging pixels 12 which are R pixels, G pixels, and B pixels are provided and have respective color filters 43 that pass R, G, and B spectral components of different wavelength bands, and the first focus detection pixels 11, 13 are provided to replace some of the R imaging pixels 12, and have R color filters 43. Moreover, the second focus detection pixels 14, 15 are provided to replace some of the G imaging pixels 12, and have G color filters 43. Since the first focus detection pixels 11, 13 are provided in positions for R pixels, accordingly they can utilize the characteristic of long wavelength light (red color light) that the transmittance through a semiconductor substrate is high. Moreover, since the second focus detection pixels 14, 15 are provided in positions of G pixels, accordingly they are able to avoid the positions of R pixels that can easily suffer a negative influence due to miniaturization.
(3) Since, in this image sensor 22, the pixel row 401S in which the first focus detection pixels 11, 13 are provided and the pixel row 402S in which the second focus detection pixels 14, 15 are provided are close to one another in the Y axis direction described above, accordingly, even if for example it is not possible to obtain phase difference information for green color from the pixel row 401S, still it is possible to obtain phase difference information for green color from the adjacent pixel row 402S. Conversely, even if for example it is not possible to obtain phase difference information for red color from the pixel row 402S, still it is possible to obtain phase difference information for red color from the adjacent pixel row 401S. In this manner, due to such complementary effects, it is possible to obtain a contribution to the accuracy of phase difference detection.

### The Thirteenth Variant Embodiment

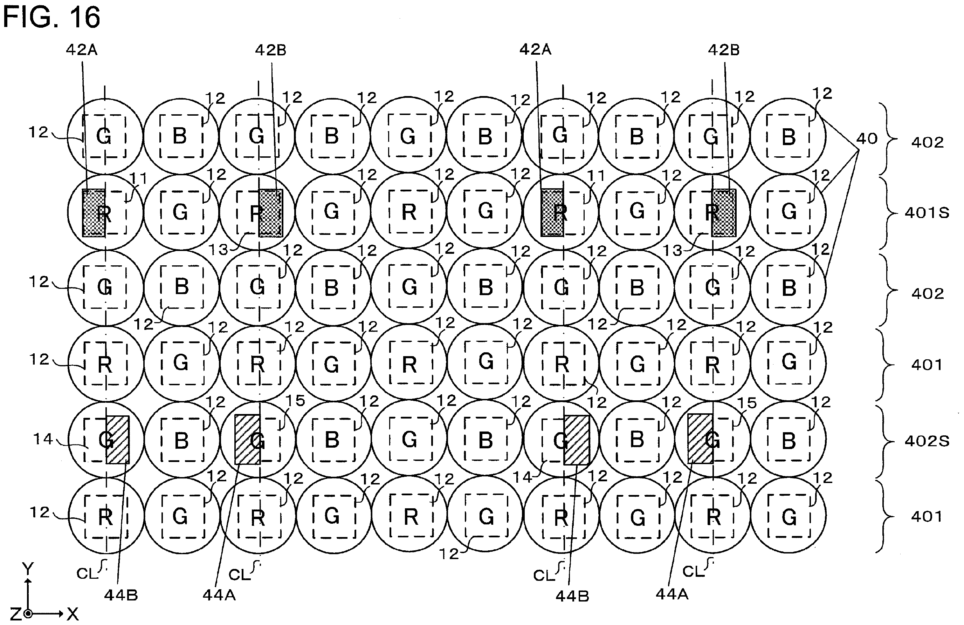

Even in a case in which the first focus detection pixels 11, 13 are disposed in positions for R pixels and the second focus detection pixels 14, 15 are disposed in positions for G pixels, it would still be acceptable to arrange to dispose the individual units consisting of first focus detection pixels 11, 13 and an imaging pixel 12 sandwiched between them, and the individual units consisting of second focus detection pixels 14, 15 and an imaging pixel 12 sandwiched between them, at any desired intervals in the column direction (i.e. in the Y axis direction). In concrete terms, the interval between the pixel row 401S in which the first focus detection pixels 11, 13 are disposed and the pixel row 402S in which the second focus detection pixels 14, 15 are disposed is set to be wider than the interval in the case of Fig. 15 (the twelfth variant embodiment). Fig. 16 is an enlarged view of a portion of a pixel array upon an image sensor 22 according to this thirteenth variant embodiment, and shows an example of a case in which first focus detection pixels 11, 13 and second focus detection pixels 14, 15 are arranged along the row direction (the X axis direction), in other words in the horizontal direction. In a similar manner to the case of Fig. 15 (the twelfth variant embodiment), each of the first focus detection pixels 11, 13 is disposed in a position for a R pixel and each of the second focus detection pixels 14, 15 is disposed in a position for a G pixel.

When the interval between the pixel row 401S in which the first focus detection pixels 11, 13 are disposed and the pixel row 402S in which the second focus detection pixels 14, 15 are disposed is set to be wider as shown in Fig. 16, then, as compared to the case of Fig. 15 (the twelfth variant embodiment) in which these rows are adjacent in the column direction (i.e. the Y axis direction), there is the benefit that it is possible to avoid improperly high density of the focus detection pixels, from which it is not possible to receive image signals, in the column direction (the Y axis direction).

According to this thirteenth variant embodiment as explained above, it is arranged to separate from one another the pixel row 401S in which the first focus detection pixels 11, 13 are provided and the pixel row 402S in which the second focus detection pixels 14, 15 are provided in the direction of the Y axis mentioned above. Due to this, it is possible to avoid improperly high density of the pixel positions from which no image signals can be obtained, as compared to the case when the pixel row 401S and the pixel row 402S are adjacent to one another in the Y axis direction.

### The Fourteenth Variant Embodiment

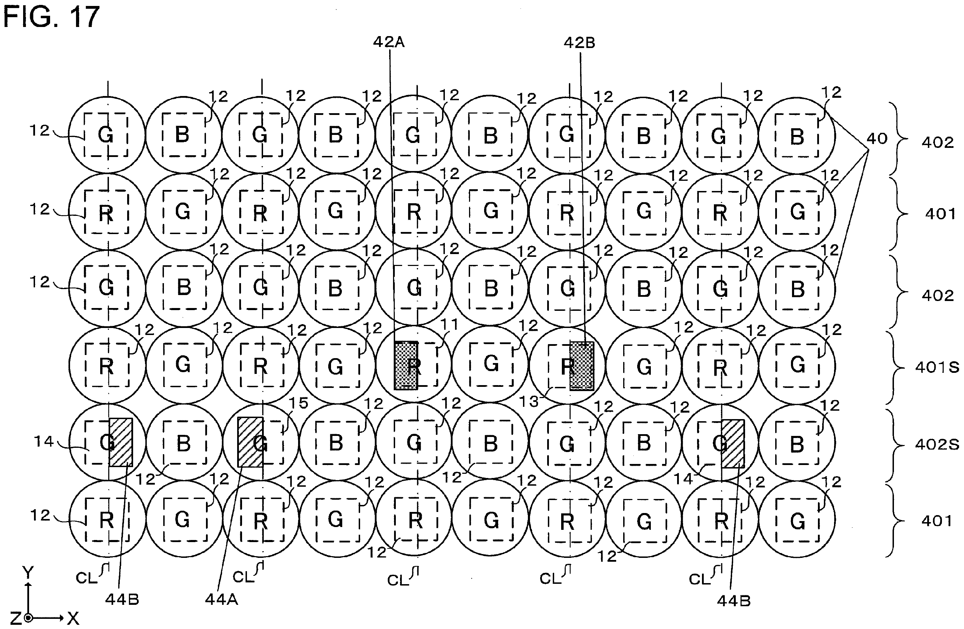

Even in a case in which the first focus detection pixels 11, 13 are disposed in positions for R pixels and the second focus detection pixels 14, 15 are disposed in positions for G pixels, it would still be acceptable to dispose the individual units consisting of the first focus detection pixels 11, 13 and an imaging pixel 12 sandwiched between them at any desired intervals along the row direction (i.e. the X axis direction). In a similar manner, it would also be acceptable to dispose the individual units consisting of second focus detection pixels 14, 15 and an imaging pixel 12 sandwiched between them at any desired intervals along the row direction (the X axis direction). Fig. 17 is an enlarged view of a portion of a pixel array upon an image sensor 22 according to this fourteenth variant embodiment, and shows an example of a case in which first focus detection pixels 11, 13 and second focus detection pixels 14, 15 are arranged along the row direction (the X axis direction), in other words in the horizontal direction. In a similar manner to the case of Fig. 15 (the twelfth variant embodiment), each of the first focus detection pixels 11, 13 is disposed in a position for a R pixel and each of the second focus detection pixels 14, 15 is disposed in a position for a G pixel.

In Fig. 17, the intervals along the row direction (i.e. the X axis direction) between the individual units consisting of first focus detection pixels 11, 13 and an imaging pixel 12 sandwiched between them are set to be wider than in the case of Fig. 15 (the twelfth variant embodiment), and include the first focus detection pixels 11, 13 and imaging pixels 12 of the same color (in this embodiment, R pixels).

Moreover, the intervals along the row direction (i.e. the X axis direction) between the individual units consisting of second focus detection pixels 14, 15 and an imaging pixel 12 sandwiched between them are also set to be wider than in the case of Fig. 15 (the twelfth variant embodiment), and include the second focus detection pixels 14, 15 and imaging pixels 12 of the same color (in this embodiment, G pixels).

Furthermore, the individual units including the first focus detection pixels 11, 13 described above and the individual units including the second focus detection pixels 14, 15 described above are displaced from one another (i.e. staggered) along the row direction (i.e. the X axis direction). Since the positions of the individual units including the first focus detection pixels 11, 13 and the individual units including the second focus detection pixels 14, 15 are displaced from one another along the row direction (the X axis direction), accordingly there is the beneficial effect that it is possible to keep down the density of the focus detection pixels, from which image signals cannot be obtained, as compared with the case of Fig. 15.

According to this fourteenth variant embodiment, it is arranged for the positions of the first focus detection pixels 11, 13 in the pixel rows 401S in which the first focus detection pixels 11, 13 are provided and the positions of the second focus detection pixels 14, 15 in the pixel rows 402S in which the second focus detection pixels 14, 15 are provided to be displaced from one another in the direction of the X axis described above. Due to this, it is possible to avoid improperly high density of the pixel positions from which image signals cannot be obtained, as compared with the case of Fig. 15 in which the positions of the first focus detection pixels 11, 13 and the positions of the second focus detection pixels 14, 15 are not displaced from one another in the X axis direction.

### The Fifteenth Variant Embodiment

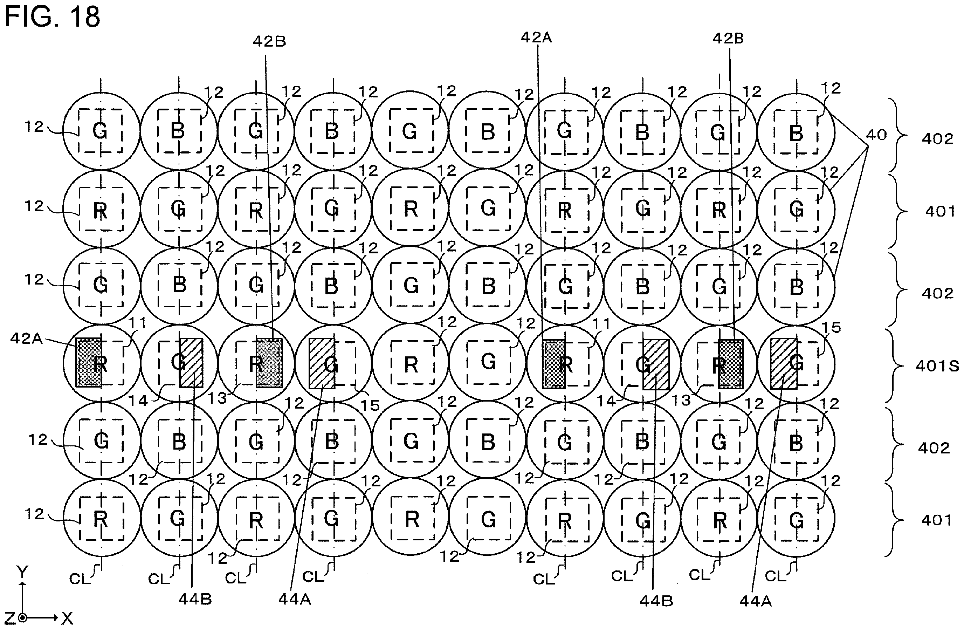

Fig. 18 is an enlarged view of a portion of a pixel array upon an image sensor 22 according to a fifteenth variant embodiment. As compared to the first embodiment (refer to Fig. 3), there is the feature of difference that first focus detection pixels 11, 13 and second focus detection pixels 14, 15 are disposed in the same row (a pixel row 401S). Each of the first focus detection pixels 11, 13 is disposed in a position for a R pixel, and each of the second focus detection pixels 14, 15 is disposed in a position for a G pixel.

By disposing the first focus detection pixels 11, 13 and the second focus detection pixels 14, 15 in the same row, the number of pixel rows 401S that include pixels from which image signals cannot be obtained is kept low, so that it is possible to suppress negative influence upon image quality.

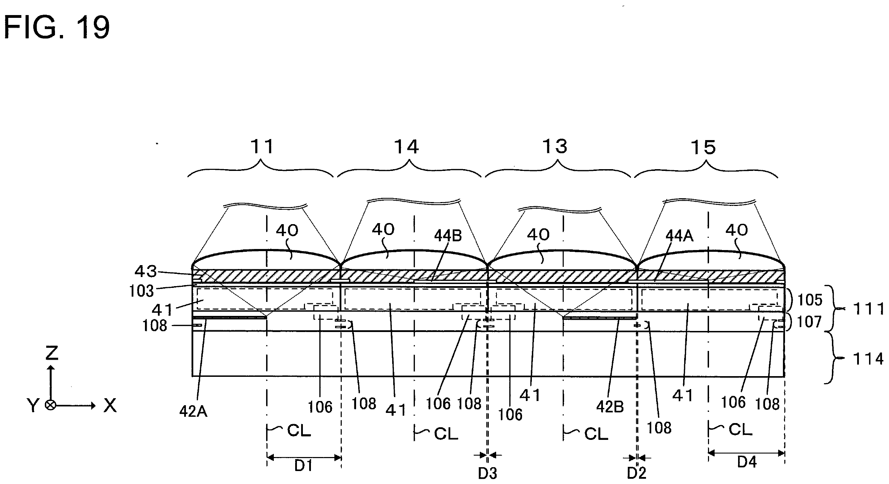

Fig. 19 is an enlarged sectional view showing the first focus detection pixels 11, 13 and the second focus detection pixels 14, 15 of Fig. 18. To structures that are the same as ones of the first focus detection pixel 11 and the second focus detection pixel 15 of Figs. 4(b) and 4(c), the same reference symbols are appended, and explanation thereof will be curtailed. The lines CL are lines that pass through the center of the pixels 11, 14, 13, and 15 (for example through the centers of their photoelectric conversion units 41).

The relationship of the positions of the reflective unit 42A and the respective unit 42B of the first focus detection pixels 11, 13 to the adjacent pixels will now be explained. That is, the respective reflective units 42A and 42B of the first focus detection pixels 11, 13 are provided to have different gaps from the neighboring pixels in a direction intersecting the direction in which light is incident (in the Fig. 19 example, the X axis direction). In concrete terms, the reflective unit 42A of the first focus detection pixel 11 is provided at a first distance D1 from the second focus detection pixel 14 adjacent to it on the right in the X axis direction. Moreover, the reflective unit 42B of the first focus detection pixel 13 is provided at a second distance D2, which is different from the first distance D1, from the second focus detection pixel 15 adjacent to it on the right in the X axis direction. It should be understood that a case would also be acceptable in which the first distance D1 and the second distance D2 are both substantially zero.

The relationship of the positions of the light interception unit 44B and the light interception unit 44A of the second focus detection pixels 14, 15 to the adjacent pixels will now be explained in a similar manner. That is, the respective light interception units 44B and 44A of the second focus detection pixels 14, 15 are provided to have different gaps from the neighboring pixels in the direction intersecting the direction in which light is incident (in the Fig. 19 example, the X axis direction). In concrete terms, the light interception unit 44B of the second focus detection pixel 14 is provided at a third distance D3 from the first focus detection pixel 13 adjacent to it on the right in the X axis direction. Moreover, the light interception unit 44A of the second focus detection pixel 15 is provided at a fourth distance D4, which is different from the third distance D3, from the imaging pixel 12 adjacent to it on the right in the X axis direction. It should be understood that a case would also be acceptable in which the third distance D3 and the fourth distance D4 are both substantially zero.

Moreover, the respective reflective units 42A and 42B of the first focus detection pixels 11, 13 are provided between the output units 106 of the first focus detection pixels 11, 13 and the output units 106 of other pixels (the imaging pixel 12 or the second focus detection pixels 14, 15). In concrete terms, the reflective unit 42A of the first focus detection pixel 11 is provided between the output unit 106 of the first focus detection pixel 11 and the output unit 106 of the adjacent imaging pixel 12 on its left in the X axis direction. The cross sectional structure of the imaging pixel 12 is the same as in Fig. 4(a).

On the other hand, the reflective unit 42B of the first focus detection pixel 13 is provided between the output unit 106 of the first focus detection pixel 13 and the output unit 106 of the adjacent second focus detection pixel 15 on its right in the X axis direction.

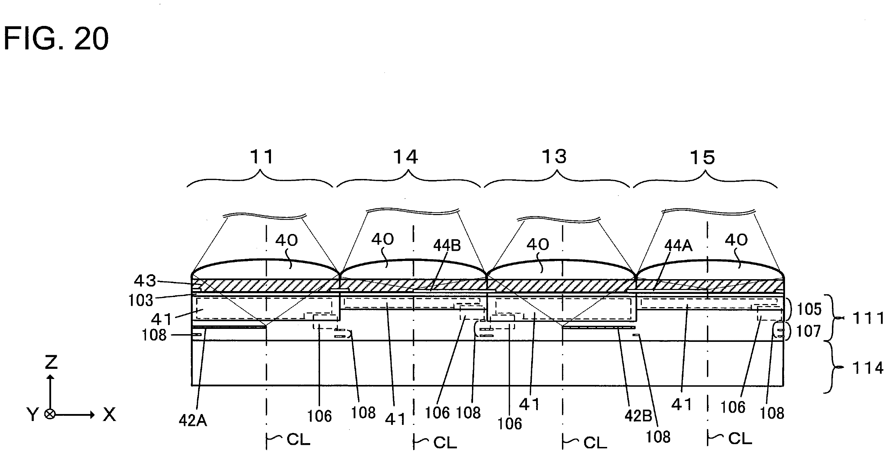

It should be understood that, in Fig. 19, the output unit 106 of the first focus detection pixel 11 is provided in a region where the reflective unit 42A of the first focus detection pixel 11 is not present (i.e. in a region more toward the +X axis direction than the line CL). Moreover, the output unit 106 of the first focus detection pixel 13 is provided in a region where the reflective unit 42B of the first focus detection pixel 13 is not present (i.e. in a region more toward the -X axis direction than the line CL). It would also be acceptable for the output unit 106 of the first focus detection pixel 11 to be provided in a region where the reflective unit 42A of the first focus detection pixel 11 is present (i.e. in a region more toward the -X axis direction than the line CL). In a similar manner, it would also be acceptable for the output unit 106 of the first focus detection pixel 13 to be provided in a region where the reflective unit 42B of the first focus detection pixel 13 is present (i.e. in a region more toward the +X axis direction than the line CL). The same holds in the case of a sixteenth variant embodiment that will be described hereinafter (refer to Fig. 20).

According to this fifteenth variant embodiment, the following operations and effects are obtained.
(1) With this image sensor 22, imaging pixels 12 which are R pixels, G pixels, and B pixels are provided and have respective color filters 43 that pass R, G, and B spectral components of different wavelength bands, and the first focus detection pixels 11, 13 are provided to replace some of the R imaging pixels 12, and have R color filters 43. Moreover, the second focus detection pixels 14, 15 are provided to replace some of the G imaging pixels 12, and moreover have G color filters 43. Since the first focus detection pixels 11, 13 are provided in positions for R pixels, accordingly they can utilize the characteristic of long wavelength light (red color light) that the transmittance through a semiconductor substrate is high. Moreover, since the second focus detection pixels 14, 15 are provided in positions of G pixels, accordingly they are able to avoid the positions of R pixels that can easily suffer a negative influence due to miniaturization.
(2) Furthermore, since the reflective unit 42B of the first focus detection pixel 13 of the image sensor 22 is provided between the output unit 106 that outputs a signal due to electric charge generated by the photoelectric conversion unit 41, and the output unit 106 that outputs a signal due to electric charge generated by the photoelectric conversion unit 41 of the second focus detection pixel 15 of the image sensor 22, accordingly it is possible to form the reflective unit 42B and the output unit 106 in an appropriate manner in the wiring layer 107, without newly providing any dedicated layer for the reflective unit 42B.

### The Sixteenth Variant Embodiment

In the image sensor 22 of the sixteenth variant embodiment, as compared to the photoelectric conversion units 41 of the first focus detection pixels 11, 13, the photoelectric conversion units 41 of the second focus detection pixels 14, 15 have the feature of difference that their depth (i.e. thickness) in the direction in which light is incident (in Fig. 20, the Z axis direction) is shallower. Fig. 20 is an enlarged sectional view of the first focus detection pixels 11, 13 and the second focus detection pixels 14, 15 of an image sensor 22 according to this sixteenth variant embodiment. To structures that are the same as ones in Fig. 19, the same reference symbols are appended, and explanation thereof will be curtailed. The lines CL are lines passing through the centers of the pixels 11, 14, 13, and 15 (for example through the centers of their photoelectric conversion units 41).

The second focus detection pixels 14, 15 are provided to replace some of the G pixels or B pixels. The depths in the semiconductor layers 105 to which the green color light or blue color light respectively photoelectrically converted by the G pixels or B pixels reaches are shallower, as compared to red color light. Due to this, the depths of the semiconductor layers 105 (i.e. of the photoelectric conversion units 41) is made to be shallower in the second focus detection pixels 14, 15, than in the first focus detection pixels 11, 13.

It should be understood that this construction is not to be considered as being limited to the second focus detection pixels 14, 15; it would also be acceptable to arrange to make the depths of the semiconductor layers 105 (i.e. of the photoelectric conversion units 41) in the G or B imaging pixels 12 shallower than in the first focus detection pixels 11, 13 or in the R imaging pixels 12.

Moreover, it would also be acceptable to apply the structure explained with reference to this sixteenth variant embodiment to the first embodiment described above and to its variant embodiments, and to the further embodiments and variant embodiments to be described hereinafter. In other words, it would also be acceptable to arrange to make the depths of the semiconductor layers 105 (i.e. of the photoelectric conversion units 41) of the second focus detection pixels 14, 15 and of the G and B imaging pixels of the image sensor 22 shallower than the depths of the first focus detection pixels 11, 13 and the R imaging pixels 12.

### The Seventeenth Variant Embodiment

In the first embodiment, an example was explained in which the first focus detection pixels 11, 13 were disposed in positions of R pixels, and, for focus detection, employed signals obtained by receiving light in the red color wavelength region. Since the first focus detection pixels are adapted for light in a long wavelength region, it would also be appropriate for them, for example, to be configured for infrared light or near infrared light or the like. Due to this, it would also be possible for an image sensor 22 that is provided with such first focus detection pixels to be applied in a camera for industrial use or for medical use with which images are photographed by infrared radiation or near infrared radiation. For example, the first focus detection pixels may be disposed at the positions of filters that pass light in the infrared light region, and the signals that are obtained by the focus detection pixels receiving light in the infrared light region may be employed for focus detection.

The first embodiment and the variant embodiments of the first embodiment described above include image sensors of the following types.
(1) Since, in the image sensor 22, the optical characteristics of the micro lenses 40 of the first focus detection pixels 11 (13) and of the micro lenses of the imaging pixels 12 are different, accordingly it is possible to make the positions of condensation of incident light different, as appropriate, between the first focus detection pixels 11 (13) and the imaging pixels 12.
(2) Since, in the image sensor 22 described above, the focal lengths of the micro lenses 40 of the first focus detection pixels 11 (13) and the focal lengths of the micro lenses 40 of the imaging pixels 12 are made to be different, accordingly it is possible to make the positions of condensation of the incident light be different, as appropriate, between the first focus detection pixels 11 (13) and the imaging pixels 12.
(3) Since, in the image sensor 22 described above, the micro lenses 40 of the first focus detection pixels 11 (13) and the micro lenses 40 of the imaging pixels 12 are made to be different in shape, accordingly it is possible to make the positions of condensation of the incident light be different, as appropriate, between the first focus detection pixels 11 (13) and the imaging pixels 12.
(4) Since, in the image sensor 22 described above, the micro lenses 40 of the first focus detection pixels 11 (13) and the micro lenses 40 of the imaging pixels 12 are made to have different refractive indexes, accordingly it is possible to make the positions of condensation of the incident light be different, as appropriate, between the first focus detection pixels 11 (13) and the imaging pixels 12.
(5) Since, in the image sensor 22 described above, an optical characteristic adjustment layer that changes the position of light condensation is provided at least between a micro lens 40 and a photoelectric conversion unit 41 of a first focus detection pixel 11 (13) or between a micro lens 40 and a photoelectric conversion unit 41 of an imaging pixel 12, accordingly it is possible to make the positions of condensation of the incident light be different, as appropriate, between the first focus detection pixels 11 (13) and the imaging pixels 12.
(6) In the image sensor 22 described above, it is arranged for the positions of condensation of incident light upon the photoelectric conversion units 41 of the first focus detection pixels 11 (13) via their micro lenses 40 to be upon their reflective units 42A (42B). Due to this, it is possible to obtain an image sensor 22 in which the accuracy of pupil-split type phase difference detection is enhanced, since the accuracy of pupil splitting is increased as compared to a case in which the light is not condensed upon the reflective units 42A (42B).
(7) In the image sensor 22 described above, it is arranged for the positions of condensation of the incident light via the micro lenses 40 upon the imaging pixels 12 to be upon the photoelectric conversion units 41. Due to this, it is possible to enhance the sensitivity (i.e. the quantum efficiency) of the photoelectric conversion unit 41, as compared to a case in which this light is not condensed upon the photoelectric conversion unit 41.
(8) In the image sensor 22 described above, there are provided the second focus detection pixels 14 (15) having micro lenses 40, photoelectric conversion units 41 that photoelectrically convert light that has passed through their respective micro lenses 40, and the light interception units 44B (44A) that intercept portions of the light incident upon their respective photoelectric conversion units 41, and the positions of condensation of incident light upon the first focus detection pixels 11 (13) and upon the second focus detection pixels 14 (15) are made to be different. For example, due to the light being condensed upon the pupil splitting structures of the focus detection pixels (in the case of the first focus detection pixels 11, 13, the reflective units 42A, 42B, and in the case of the second focus detection pixels 14, 15, the light interception units 44B, 44A), the accuracy of pupil splitting is enhanced, as compared to a case in which the light is not condensed upon any pupil splitting structure. As a result, an image sensor 22 can be obtained in which the accuracy of detection by the pupil-split type phase difference detection method is enhanced.
(9) In the image sensor 22 described above, it is arranged for the positions of condensation of incident light upon the second focus detection pixels 14 (15) via their micro lenses 40 to be upon their light interception units 44B (44A). Due to this, it is possible to obtain an image sensor 22 with which the accuracy of pupil-split type phase difference detection is enhanced, since the accuracy of pupil splitting is increased as compared to a case in which the light is not condensed upon the light interception units 44B (44A).
(10) In the image sensor 22 described above, the reflective units 42A (42B) of the first focus detection pixels 11 (13) are disposed in positions where they reflect one or the other of the first and second ray bundles that have passed through the first and second portions of the pupil of the imaging optical system 31, and their photoelectric conversion units 41 perform photoelectric conversion upon the first and second ray bundles and upon the ray bundles reflected by the reflective units 42A (42B). Due to this, it is possible to obtain an image sensor 22 that employs a pupil splitting structure of the reflection type, and with which the accuracy of detection according to the phase difference detection method is enhanced.
(11) In the image sensor 22 described above, the light interception units 44B (44A) of the second focus detection pixels 14 (15) are disposed in positions where they intercept one or the other of the first and second ray bundles that have passed through the first and second portions of the pupil of the imaging optical system 31, and their photoelectric conversion units 41 perform photoelectric conversion upon the others of the first and second ray bundles. Due to this, it is possible to obtain an image sensor 22 that employs a pupil splitting structure of the light interception type, and with which the accuracy of detection according to the phase difference detection method is enhanced.

### Embodiment Two

In the second embodiment, the plurality of focus detection pixels are provided with the positions of their pupil splitting structures (in the case of the first focus detection pixels 11, 13, the reflective units 42A, 42B, and in the case of the second focus detection pixels 14, 15, the light interception units 44B, 44A) being displaced in the X axis direction and/or in the Y axis direction.

### The Case of Displacement in the X Axis Direction

A plurality of focus detection pixels whose pupil splitting structures are displaced in the X axis direction are, for example, provided in positions corresponding to the focusing areas 101-1 through 101-3 of Fig. 2. As described in connection with the third variant embodiment of the first embodiment, the focus detection pixels are arranged along the X axis direction in these focusing areas 101-1 through 101-3 that perform focus detection adapted to a photographic subject bearing a pattern in the vertical direction. When performing phase difference detection in the X axis direction in this manner, the pupil splitting structures of the plurality of focus detection pixels are displaced in the X axis direction.

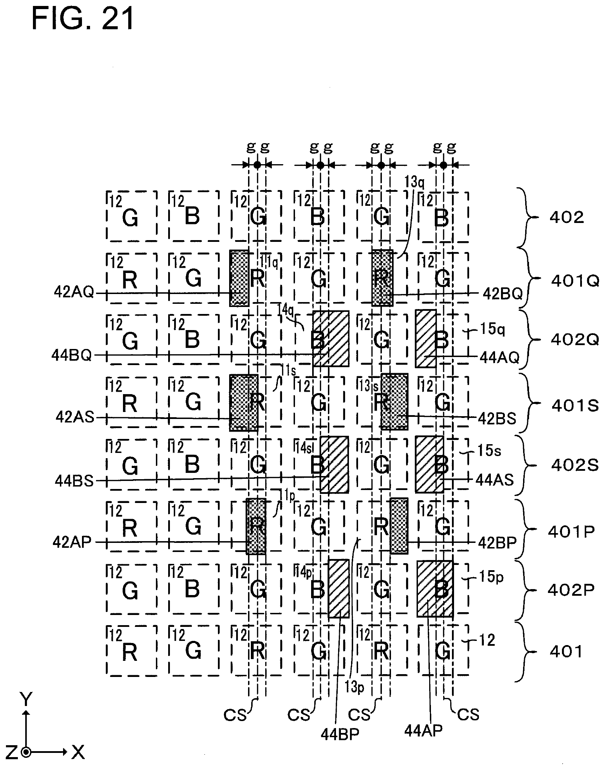

Fig. 21 is an enlarged view of a part of a pixel array provided at positions corresponding to the focusing areas 101-1 through 101-3 ofthe image sensor 22. In Fig. 21, to structures that are similar to ones in Fig. 3 (relating to the first embodiment) the same reference symbols are appended, and the micro lenses 40 are curtailed. In a similar manner to the case of Fig. 3, each of the pixels in this image sensor 22 is provided with one of three color filters having different spectral sensitivities of R (red), G (green), and B (blue).

According to Fig. 21, the image sensor 22 comprises R, G, and B imaging pixels 12, first focus detection pixels 11p, 11s, and 11q disposed so as to replace some ofthe R imaging pixels 12, first focus detection pixels 13p, 13s, and 13q disposed so as to replace some of the R imaging pixels 12, second focus detection pixels 14p, 14s, and 14q disposed so as to replace some of the B imaging pixels 12, and second focus detection pixels 15p, 15s, and 15q disposed so as to replace some of the B imaging pixels 12.

### The First Focus Detection Pixels

In the example of Fig. 21, the three first focus detection pixels 11p, 11s, and 11q are provided as first focus detection pixels 11. Among these, the first focus detection pixel 11s corresponds to the first focus detection pixel 11 of Figs. 3 and 4(b) in the first embodiment. Moreover, the three first focus detection pixels 13p, 13s, and 13q are provided as first focus detection pixels 13. Among these, the first focus detection pixel 13s corresponds to the first focus detection pixel 13 of Fig. 3 in the first embodiment.

A plurality of pairs of the first focus detection pixels 11p, 13p are disposed in a pixel row 401P. And a plurality of pairs of the first focus detection pixels 11s, 13s are disposed in a pixel row 401S. Moreover, a plurality of pairs of the first focus detection pixels 11q, 13q are disposed in a pixel row 401Q. In this embodiment, the plurality of pairs of the first focus detection pixels (11p, 13p), the plurality of pairs of the first focus detection pixels (11s, 13s), and the plurality of pairs of the first focus detection pixels (11q, 13q) each will be referred to as a group of first focus detection pixels 11, 13.

It should be understood that the plurality of pairs of first focus detection pixels (11p, 13p), (11s, 13s), or (11q, 13q) may have fixed intervals between pair and pair, or may have different intervals between the pairs.

In the first focus detection pixels 11p, 11s, and 11q, the positions and the widths in the X axis direction (in other words the areas in the XY plane) of their respective reflective units 42AP, 42AS, and 42AQ are different. It will be sufficient if at least one of the positions and the widths of the reflective units 42AP, 42AS, and 42AQ in the X axis direction is different. It will also be acceptable for the areas of the reflective units 42AP, 42AS, and 42AQ to be different from one another.

Moreover, in the first focus detection pixels 13p, 13s, and 13q, the positions and the widths in the X axis direction (in other words their areas in the XY plane) of their respective reflective units 42BP, 42BS, and 42BQ are different. It will be sufficient if at least one of the positions and the widths of the reflective units 42BP, 42BS, and 42BQ in the X axis direction is different. It will also be acceptable for the areas of the reflective units 42BP, 42BS, and 42BQ to be different from one another.

The reason will now be explained why, as shown in Fig. 21, a plurality of focus detection pixels having different positions in the pupil splitting structure are provided. In the process of manufacturing the image sensor 22, for example, after the color filters 43 have been formed (in the +Z axis direction) over the first substrate 111 shown in the Fig. 4 example, the micro lenses 40 are formed by an on-chip lens formation process. However, due to positional errors and so on in this on-chip lens formation process, sometimes it may happen that a slight deviation may occur between the center of a completed micro lens 40 and the center of its corresponding pixel upon the first substrate 111 (for example, the center of the corresponding photoelectric conversion unit 41). Since this deviation typically occurs in common for all of the pixels, accordingly, if for example the center of the micro lens 40 of one of the pixels deviates by just the length g in the +X axis direction with respect to the center of its pixel, then, in a similar manner, deviations in the +X axis direction of the length g will occur for the other pixels.

In general, in the case of an imaging pixel 12, even if the center of the micro lens 40 is slightly deviated with respect to the center of the pixel, there will be no problem provided that light condensed by the micro lens 40 is incident upon the photoelectric conversion unit 41. However, in the case of the first focus detection pixels 11, 13 and the second focus detection pixels 14, 15, if there is a deviation between the center of the micro lens 40 and the center of the pixel, then, since a deviation will also arise with respect to the pupil splitting structure (in the case of the first focus detection pixels 11, 13, the reflective units 42A, 42B, and in the case of the second focus detection pixels 14, 15, the light interception units 44B, 44A), accordingly sometimes it may happen that pupil splitting may no longer be appropriately performed, even if the deviation is slight.

Accordingly, in this second embodiment, in order for it to be possible to perform pupil splitting in an appropriate manner in such a state of deviation even if the center of a micro lens 40 is deviated with respect to the center of a pixel on the first substrate 111, a plurality of focus detection pixels are provided with the positions of their pupil splitting structures displaced in advance in the X axis direction and/or in the Y axis direction with respect to the centers of the pixels.

In this example if, in a plurality of the pairs of the first focus detection pixels (11s, 13s), the centers of the micro lenses 40 and the centers of the pixels (for example, their photoelectric conversion units 41) are in agreement with one another (i.e. are not deviated from one another), then it is arranged for these pixel pairs to be employed for pupil splitting. Furthermore if, in a plurality of the pairs of the first focus detection pixels (11p, 13p) or in a plurality of the pairs of the first focus detection pixels (11q, 13p), the centers of the micro lenses 40 and the centers of the pixels (for example, their photoelectric conversion units 41) are not in agreement with one another (i.e. a deviation between them is present), then it is arranged for these pixel pairs to be employed for pupil splitting.

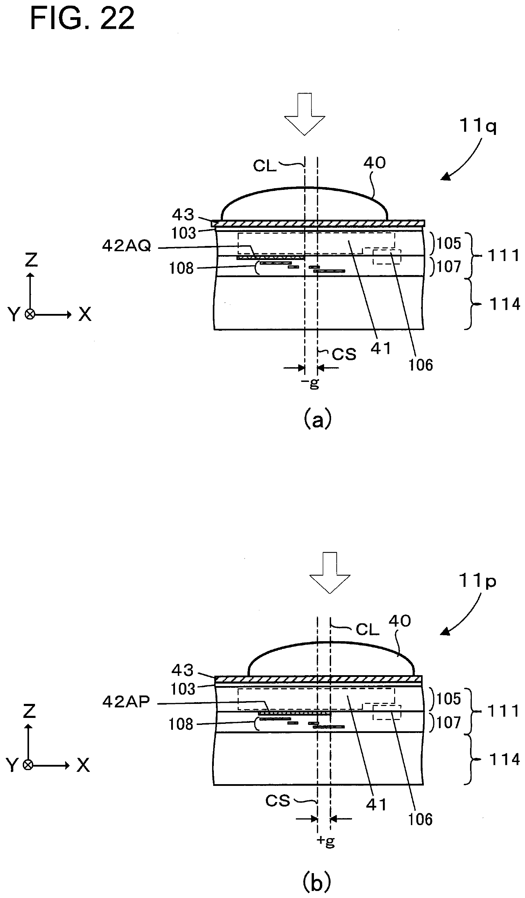

The first focus detection pixels 11p, 11q of Fig. 21 will now be explained in further detail with reference to Fig. 22. Fig. 22(a) is an enlarged sectional view of the first focus detection pixel 11q of Fig. 21. To structures that are the same as ones of the first focus detection pixel 11 of Fig. 4(b), the same reference symbols are appended, and explanation thereof is curtailed. The line CL is a line passing through the center of the micro lens 40. Furthermore, the line CS is a line passing through the center of the first focus detection pixel 11q (for example through the center of its photoelectric conversion unit 41).

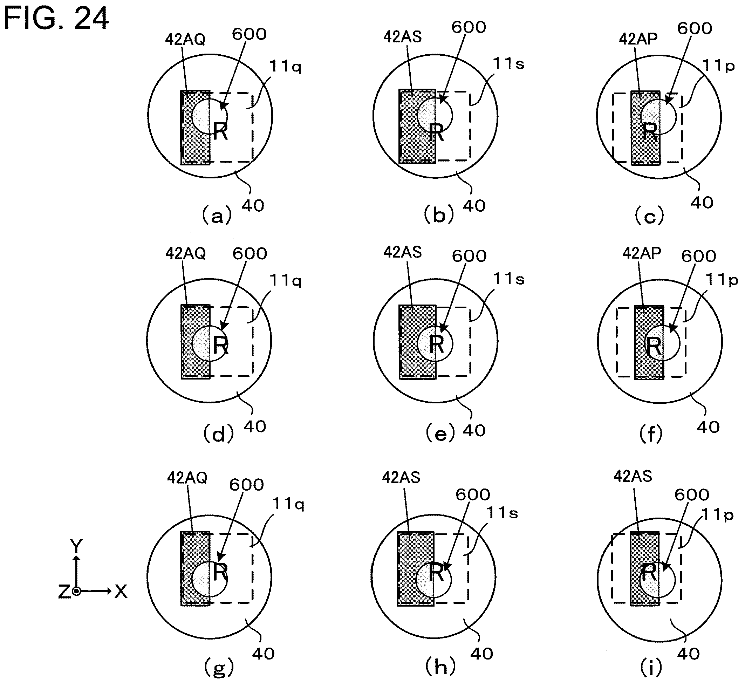

A case will now be discussed, in relation to the first focus detection pixel 11q of Fig. 22(a), in which the center of the micro lens 40 (i.e. the line CL) is displaced by -g in the direction of the X axis with respect to the center of the photoelectric conversion unit 41 (i.e. the line CS). That is, Fig. 22(a) shows a structure of the first focus detection pixel 11q with which it is possible to perform pupil splitting in an appropriate manner, in a case in which, due to an error in positional alignment or the like during the on-chip lens formation process, the micro lens 40 has been formed with a displacement amount of -g in the direction of the X axis with respect to the photoelectric conversion unit 41. The width in the X axis direction of the reflective unit 42AQ of the first focus detection pixel 11q is narrower than the width in the X axis direction of the reflective unit 42AS of the first focus detection pixel 11s, and is the same as the width of the reflective unit 42BQ of the first focus detection pixel 13q, as will be described hereinafter. The position of the reflective unit 42AQ of the focus detection pixel 11q is a position that covers the lower surface of the photoelectric conversion unit 41 more on the left side (i.e. toward the -X axis direction) than the position (the line CL) that is in the -X axis direction from the line CS by the displacement amount g. Due to this, the first focus detection pixel 11q is capable of performing pupil splitting in an appropriate manner in the state in which the center (i.e. the line CL) of the micro lens 40 is deviated by -g in the X axis direction with respect to the center of the photoelectric conversion unit 41 (i.e. the line CS). In a specific example, as shown in Fig. 24(d) which will be explained hereinafter, due to the reflective unit 42AQ of the first focus detection pixel 11q, the image 600 of the exit pupil 60 of the imaging optical system 31 is divided substantially symmetrically left and right.

If it is supposed that the width in the X axis direction and the position of the reflective unit 42AQ of the first focus detection pixel 11q are the same as those of the reflective unit 42AS of the first focus detection pixel 11s, then a part of the focus detection ray bundle that has passed through the first pupil region 61 (refer to Fig. 5) (i.e. the light that has passed through between the line CL of the photoelectric conversion unit 41 of Fig. 22(a) and the line CS) would be reflected by the reflective unit 42AQ and would become again incident upon the photoelectric conversion unit 41 for a second time, so that pupil splitting could no longer be performed in an appropriate manner.

However due to the fact that, as described above, the reflective unit 42AQ of the first focus detection pixel 11q at the lower surface of the photoelectric conversion unit 41 is provided more to the left side (i.e. toward the -X axis direction) than the line CL, accordingly only the focus detection ray bundle that has passed through the second pupil region 62 (refer to Fig. 5) is reflected by the reflective unit 42AQ and is incident back into the photoelectric conversion unit 41 for a second time, so that pupil splitting is performed in an appropriate manner.

Moreover, as shown by way of example in Fig. 21, a first focus detection pixel 13q is present in the pixel row 401Q that is paired with the first focus detection pixel 11q. While no enlarged sectional view of this first focus detection pixel 13q is shown in the drawings, the width in the X axis direction of the reflective unit 42BQ of the first focus detection pixel 13q is narrower than the width of the reflective unit 42BS of the first focus detection pixel 13s, and is the same as the width of the reflective unit 42AQ of the first focus detection pixel 11q. The fact that the width of the reflective unit 42BQ is the same as the width of the reflective unit 42AQ of the first focus detection pixel 11q which is in the pairwise relationship therewith is in order to avoid any light other than the focus detection ray bundle that carries the focus difference information from being reflected by the reflective unit 42BQ and being again incident upon the photoelectric conversion unit 41 for a second time.

In addition to the above, the position in the X axis direction of the reflective unit 42BQ of the first focus detection pixel 13q of Fig. 21 is a position that covers the lower surface of the photoelectric conversion unit 41 more to the right side (i.e. the +X axis direction) than a position (the line CL) which is shifted by the displacement amount g in the -X axis direction from the line CS. Due to this, the focus detection ray bundle that has passed through the first pupil region 61 (refer to Fig. 5) is reflected by the reflective unit 42BQ and is again incident upon the photoelectric conversion unit 41 for a second time, so that pupil splitting is performed in an appropriate manner.

Fig. 22(b) is an enlarged sectional view of the first focus detection pixel 11p of Fig. 21. To structures that are the same as ones of the first focus detection pixel 11q of Fig. 22(a) the same reference symbols are appended, and explanation thereof is curtailed. The line CL is a line passing through the center of the micro lens 40. Moreover, the line CS is a line passing through the center of the first focus detection pixel 11p (for example, through the center of the photoelectric conversion unit 41).

A case will now be discussed, in relation to the first focus detection pixel 11p of Fig. 22(b), in which the center of the micro lens 40 (i.e. the line CL) is displaced by +g in the direction of the X axis with respect to the center of the photoelectric conversion unit 41 (i.e. the line CS). That is, Fig. 22(b) shows a structure of the first focus detection pixel 11p with which it is possible to perform pupil splitting in an appropriate manner, in a case in which, due to an error in positional alignment or the like during the on-chip lens formation process, the micro lens 40 has suffered a displacement amount of +g in the direction of the X axis with respect to the photoelectric conversion unit 41. The width in the X axis direction of the reflective unit 42AP of the first focus detection pixel 11p is narrower than the width in the X axis direction of the reflective unit 42AS of the first focus detection pixel 11s, and is the same as the width of the reflective unit 42BP of the first focus detection pixel 13p, as will be described hereinafter. The position of the reflective unit 42AP of the focus detection pixel 11p is a position that covers the lower surface of the photoelectric conversion unit 41 more on the left side (i.e. the -X axis direction) than the position (the line CL) to the displacement amount g in the +X axis direction from the line CS. Due to this, the first focus detection pixel 11p is capable of performing pupil splitting in an appropriate manner in the state in which the center (i.e. the line CL) of the micro lens 40 is deviated by +g in the X axis direction with respect to the center of the photoelectric conversion unit 41 (i.e. the line CS). In a specific example, as shown in Fig. 24(f) which will be explained hereinafter, due to the reflective unit 42AP of the first focus detection pixel 11p, the image 600 of the exit pupil 60 of the imaging optical system 31 is divided substantially symmetrically left and right.

If it is supposed that the width in the X axis direction and the position of the reflective unit 42AP of the first focus detection pixel 11p are the same as those of the reflective unit 42AS of the first focus detection pixel 11s, then a part of the focus detection ray bundle that has passed through the first pupil region 61 (refer to Fig. 5) (i.e. the light that has passed through between the line CL of the photoelectric conversion unit 41 of Fig. 22(b) and the line CS) would be reflected by the reflective unit 42AP and would become again incident upon the photoelectric conversion unit 41 for a second time, so that pupil splitting could no longer be performed in an appropriate manner.

However due to the fact that, as described above, the reflective unit 42AP of the first focus detection pixel 11p is provided at the lower surface of the photoelectric conversion unit 41 and more to the left side (i.e. toward the -X axis direction) than the line CL, accordingly only the focus detection ray bundle that has passed through the second pupil region 62 (refer to Fig. 5) is reflected by the reflective unit 42AP and is incident back into the photoelectric conversion unit 41 for a second time, so that pupil splitting is performed in an appropriate manner.

Moreover, as shown in Fig. 21, a first focus detection pixel 13p that is paired with the first focus detection pixel 11p is present in the pixel row 401P. While no enlarged sectional view of this first focus detection pixel 13p is shown in the drawings, the width in the X axis direction of the reflective unit 42BP of the first focus detection pixel 13p of Fig. 21 is narrower than the width of the reflective unit 42BS of the first focus detection pixel 13s, and is the same as the width of the reflective unit 42AP of the first focus detection pixel 11p. The fact that the width of the reflective unit 42BP is the same as the width of the reflective unit 42AP of the first focus detection pixel 11p which is in the pairwise relationship therewith is in order to avoid any light other than the focus detection ray bundle that carries the focus difference information from being reflected by the reflective unit 42BP and being again incident upon the photoelectric conversion unit 41 for a second time.

In addition to the above, the position in the X axis direction of the reflective unit 42BP of the first focus detection pixel 13p of Fig. 21 is a position that covers the lower surface of the photoelectric conversion unit 41 more to the right side (i.e. the +X axis direction) than a position (the line CL) which is shifted by the displacement amount g in the +X axis direction from the line CS. Due to this, the focus detection ray bundle that has passed through the first pupil region 61 (refer to Fig. 5) is reflected by the reflective unit 42BP and is again incident upon the photoelectric conversion unit 41 for a second time, so that pupil splitting is performed in an appropriate manner.

As explained above, in the first focus detection pixels 11 of Fig. 21 (11p, 11s, and 11q), the widths and the positions of their respective reflective units 42AP, 42AS, and 42AQ are different. In a similar manner, in the first focus detection pixels 13 (13p, 13s, and 13q), the widths and the positions of their respective reflective units 42BP, 42BS, and 42BQ are different.

From among the groups of first focus detection pixels 11, 13 of Fig. 21, the focus detection unit 21 a of the body control unit 21 selects pairs of first focus detection pixels 11, 13 ((11p, 13p), or (11s, 13s) or (11q, 13q)), on the basis of the states of deviation in the X axis direction between the centers of the micro lenses 40 and the centers of the pixels (i.e. of the photoelectric conversion units 41). In other words, if the centers of the micro lenses 40 and the centers of the pixels (i.e. of the photoelectric conversion units 41) agree with one another, then the focus detection unit 21a of the body control unit 21 selects a plurality of pairs of first focus detection pixels (11s, 13s) from among the groups of first focus detection pixels 11, 13. But if the centers of the micro lenses 40 are deviated in the -X axis direction or in the +X axis direction with respect to the centers of the pixels (i.e. of the photoelectric conversion units 41), then the focus detection unit 21a of the body control unit 21 selects a plurality of pairs of the first focus detection pixels (11q, 13q), or a plurality of pairs of the first focus detection pixels (11p, 13p), from among the groups of first focus detection pixels 11, 13.

The state of deviation between the center of the micro lenses 40 and the centers of the pixels may, for example, be measured during testing of the image sensor 22 (before it is mounted to the camera body 2). Information specifying this deviation is stored in the body control unit 21 of the camera body 2 to which this image sensor 22 is mounted.

Examples of the first focus detection pixel 11 will now be explained with reference to Fig. 24. Fig. 24(a) through Fig. 24(i) are figures showing examples of images 600 of the exit pupil 60 of the imaging optical system 31 as projected upon the first focus detection pixel 11 by its micro lens 40. The center of the image 600 of the exit pupil 60 agrees with the center of the micro lens 40. When the center of the micro lens 40 deviates with respect to the center of the pixel (i.e. the center of its photoelectric conversion unit 41), the position of the image 600 deviates from the center of the pixel (i.e. from the center of the photoelectric conversion unit 41).

It should be understood that, in order clearly to demonstrate the positional relationship between the image 600 of the exit pupil 60 and the pixel (the photoelectric conversion unit 41), the exit pupil image 600 is shown when the aperture of the photographic optical system 31 is narrowed down to a small aperture.

In Fig. 24(a), the center of the micro lens 40 is deviated with respect to the center of the first focus detection pixel 11q toward the -X axis direction and also toward the +Y axis direction. And, in Fig. 24(b), the center of the micro lens 40 agrees with the center of the first focus detection pixel 11s in the X axis direction but is deviated with respect thereto toward the +Y axis direction. Moreover, in Fig. 24(c), the center of the micro lens 40 is deviated with respect to the center of the first focus detection pixel 11p toward the +X axis direction and also toward the +Y axis direction.

In Fig. 24(d), the center of the micro lens 40 is deviated with respect to the center of the first focus detection pixel 11q toward the -X axis direction but agrees with the center thereof in the Y axis direction. In Fig. 24(e), the center of the micro lens 40 agrees with the center of the first focus detection pixel 11s in the X axis direction and also in the Y axis direction. And in Fig. 24(f), the center of the micro lens 40 is deviated with respect to the center of the first focus detection pixel 11p toward the +X axis direction but agrees with the center thereof in the Y axis direction.

Furthermore, in Fig. 24(g), the center of the micro lens 40 is deviated with respect to the center of the first focus detection pixel 11q toward the -X axis direction and also toward the -Y axis direction. And, in Fig. 24(h), the center of the micro lens 40 agrees with the center of the first focus detection pixel 11s in the X axis direction but is deviated with respect thereto toward the -Y axis direction. Moreover, in Fig. 24(i), the center of the micro lens 40 is deviated with respect to the center of the first focus detection pixel 11p toward the +X axis direction and toward the -Y axis direction.

For example, if the amount of deviation g of the center of the micro lens 40 with respect to the center of the pixel (i.e. of its photoelectric conversion unit 41) exceeds a predetermined value in the -X axis direction, then the focus detection unit 21a selects the first focus detection pixel 11q and the first focus detection pixel 13q that is paired with that first focus detection pixel 11q. In this case, according to Fig. 24(d) which shows the first focus detection pixel 11q, the image 600 is divided substantially symmetrically to left and right, due to the reflective unit 42AQ of the first focus detection pixel 11q. This symmetry is not destroyed even if the center of the micro lens 40 described above deviates in the +Y axis direction as shown in Fig. 24(a) or in the - direction as shown in Fig. 24(g).

Yet further, if the amount of deviation g of the center of the micro lens 40 with respect to the center of the pixel (i.e. of its photoelectric conversion unit 41) does not exceed the predetermined value in the X axis direction, then the focus detection unit 21a selects the first focus detection pixel 11s and the first focus detection pixel 13s that is paired with that first focus detection pixel 11s. In this case, according to Fig. 24(e) which shows the first focus detection pixel 11s, the image 600 is divided substantially symmetrically to left and right, due to the reflective unit 42AS of the first focus detection pixel 11s. This symmetry is not destroyed even if the center of the micro lens 40 described above deviates in the +Y axis direction as shown in Fig. 24(b) or in the -Y axis direction as shown in Fig. 24(h).

Even further, if the amount of deviation g of the center of the micro lens 40 with respect to the center of the pixel (i.e. of its photoelectric conversion unit 41) exceeds the predetermined value in the +X axis direction, then the focus detection unit 21a selects the first focus detection pixel 11p and the first focus detection pixel 13p that is paired with that first focus detection pixel 11p. In this case, according to Fig. 24(f) which shows the first focus detection pixel 11p, the image 600 is divided substantially symmetrically to left and right, due to the reflective unit 42AP of the first focus detection pixel 11p. This symmetry is not destroyed even if the center of the micro lens 40 described above deviates in the +Y axis direction as shown in Fig. 24(c) or in the - direction as shown in Fig. 24(i).

The same holds for the first focus detection pixel 13 as for the first focus detection pixel 11 described above, but illustration and explanation thereof are omitted.

It should be understood that, in Figs. 22(a) and 22(b), the output units 106 of the first focus detection pixels 11q, 11p are provided in regions of the first focus detection pixels 11q, 11p in which their respective reflective units 42AQ, 42AP are not present (i.e. in regions more toward the +X axis direction than the lines CL). In this case, the output units 106 are removed from the optical paths along which light that has passed through the photoelectric conversion units 41 is incident upon the reflective units 42AQ, 42AP.

But it would also be acceptable for the output units 106 of the first focus detection pixels 11q, 11p to be provided in regions of the first focus detection pixels 11q, 11p in which their respective reflective units 42AQ, 42AP are present (i.e. in regions more toward the -X axis direction than the lines CL). In this case, the output units 106 are positioned upon the optical paths along which light that has passed through the photoelectric conversion units 41 is incident upon the reflective units 42AQ, 42AP.

It should be understood that, in a similar manner to the case with the output units 106 of the first focus detection pixels 11q, 11p, it would also be acceptable for the output units 106 of the first focus detection pixels 13q, 13p to be provided in regions of the first focus detection pixels 13q, 13p in which their respective reflective units 42BQ, 42BP are not present (i.e. in regions more toward the -X axis direction than the lines CL); and it would also be acceptable for them to be provided in regions in which their respective reflective units 42BQ, 42BP are present (i.e. in regions more toward the +X axis direction than the lines CL). However, if the output units 106 of the first focus detection pixels 11q, 11p are positioned remote from the optical paths of light incident upon their reflective units 42AQ, 42AP described above, then it is desirable for the output units 106 of the first focus detection pixels 13q, 13p also to be provided remote from the optical paths of light incident upon their reflective units 42BQ, 42BP described above. Conversely, if the output units 106 of the first focus detection pixels 11q, 11p are positioned upon the optical paths of light incident upon their reflective units 42AQ, 42AP described above, then it is desirable for the output units 106 of the first focus detection pixels 13q, 13p also to be provided upon the optical paths of light incident upon their reflective units 42BQ, 42BP described above.

The reason for this is as follows. When the output units 106 of the first focus detection pixels 11q, 11p are positioned upon the optical paths of light incident upon the reflective units 42AQ, 42AP described above, the amounts of electric charge generated by the photoelectric conversion units 41 change, as compared to a case in which the output units 106 are removed from the optical paths of light incident upon the reflective units 42AQ, 42AP described above, since light may be reflected or absorbed by the members incorporated in these output units 106 (such as the transfer transistors, amplification transistors, and so on). Due to this, preservation of the balance of the amounts of electric charge generated by the first focus detection pixels 11q, 11p and by the first focus detection pixels 13q, 13p (i.e. maintaining the symmetry of the photoelectric conversion signals) by regulating the positional relationship between the output units 106 and the reflective units (i.e., whether the output units 106 are provided outside the optical paths, or whether the output units 106 are provided in the optical paths) for the first focus detection pixels 11q, 11p and the first focus detection pixels 13q, 13p, is performed in order to implement pupil-split type phase difference detection with good accuracy.

### The Second Focus Detection Pixels

In the example of Fig. 21, the three second focus detection pixels 14p, 14s, and 14q are provided as second focus detection pixels 14. Among these, the second focus detection pixel 14s corresponds to the first focus detection pixel 14 of Fig. 3 in the first embodiment. Moreover, the three second focus detection pixels 15p, 15s, and 15q are provided as second focus detection pixels 15. Among these, the second focus detection pixel 15s corresponds to the second focus detection pixel 15 of Figs. 3 and 4(c) in the first embodiment.

A plurality of pairs of the second focus detection pixels 14p, 15p are disposed in the pixel row 402P. And a plurality of pairs of the second focus detection pixels 14s, 15s are disposed in the pixel row 402S. Moreover, a plurality of pairs of the second focus detection pixels 14q, 15q are disposed in the pixel row 402Q. In a similar manner to the case with the first focus detection pixels 11, 13, the plurality of pairs of the second focus detection pixels (14p, 15p), the plurality of pairs of the second focus detection pixels (14s, 15s), and the plurality of pairs of the second focus detection pixels (14q, 15q) each will be referred to as a group of the second focus detection pixels 14, 15.

It should be understood that the pair-to-pair intervals between the plurality of pairs of second focus detection pixels (14p, 15p), (14s, 15s), or (14q, 15q) maybe constant, or may be different.

The positions in the X axis direction and the widths (in other words their areas in the XY plane) of the light interception units 44BP, 44BS, and 44BQ of the respective second focus detection pixels 14p, 14s, and 14q are different. It is only required that at least one of the position in the X axis direction and the width and the area of the light interception units 44BP, 44BS, and 44BQ should be different.

Furthermore, the positions in the X axis direction and the widths (in other words the areas in the XY plane) of the light interception units 44AP, 44AS, and 44AQ of the respective second focus detection pixels 15p, 15s, and 15q are different. It is only required that at least one of the position in the X axis direction and the width and the area of the light interception units 44AP, 44AS, and 44AQ should be different.

In this example if, in the plurality of pairs of second focus detection pixels (14s, 15s), the centers of the micro lenses 40 and the centers of the pixels (for example, the centers of their photoelectric conversion units 41) agree (i.e. if they do not deviate from one another), then they are employed for pupil splitting. Furthermore if, in the plurality of pairs of second focus detection pixels (14p, 15p) or in the plurality of pairs of second focus detection pixels (14q, 15p), the centers of the micro lenses 40 and the centers of the pixels (for example, the centers of their photoelectric conversion units 41) do not agree with one another (i.e. if some deviation occurs between them), then they are employed for pupil splitting.

For the second focus detection pixel 14q of Fig. 21, an example is shown of a case in which the center of the micro lens 40 (i.e. the line CL) deviates by -g in the X axis direction with respect to the center of the photoelectric conversion unit 41 (i.e. the line CS). In other words a second focus detection pixel 14q is shown with which it is possible to perform pupil splitting in an appropriate manner, if, due to an error in positional alignment or the like during the on-chip lens formation process, the micro lens 40 has suffered a displacement amount of -g in the direction of the X axis with respect to the photoelectric conversion unit 41. The width in the X axis direction of the light interception unit 44BQ of the second focus detection pixel 14q is wider than the width in the X axis direction of the light interception unit 42AS of the second focus detection pixel 14s, and moreover is also wider than the light interception unit 44AQ of the second focus detection pixel 15q that will be described hereinafter. And the position of the light interception unit 44BQ of the second focus detection pixel 14q is a position in which it covers the upper surface of the photoelectric conversion unit 41 more toward the right side (i.e. toward the +X axis direction) than the position (the line CL) that is toward the -X axis direction from the line CS by the displacement amount g. Due to this, pupil splitting can be performed in an appropriate manner in the state in which, in the second focus detection pixel 14q, the center of the micro lens 40 (i.e. the line CL) deviates by -g in the X axis direction with respect to the center (i.e. the line CS) of the photoelectric conversion unit 41.

If it is supposed that the width and the position in the X axis direction of the light interception unit 44BQ of the second focus detection pixel 14q are the same as those of the light interception unit 44BS of the second focus detection pixel 14s, then a portion of the focus detection ray bundle that has passed through the first pupil region 61 (refer to Fig. 5) (i.e. the light that is incident between the line CL of the photoelectric conversion unit 41 and the line CS) is not intercepted by the light interception unit 44BQ but becomes incident upon the photoelectric conversion unit 41, and accordingly it becomes impossible to perform pupil splitting in an appropriate manner.

However, as described above, by providing the light interception unit 44BQ of the second focus detection pixel 14q upon the upper surface of the photoelectric conversion unit more toward the right side (i.e. the +X axis direction) than the line CL, it is possible to perform pupil splitting in an appropriate manner, since only the focus detection ray bundle that has passed through the second pupil region 62 (refer to Fig. 5) is incident upon the photoelectric conversion unit 41.

In addition, as shown by way of example in Fig. 21, a second focus detection pixel 15q that is paired with the second focus detection pixel 14q is present in the pixel row 402Q. The width in the X axis direction of the light interception unit 44AQ of the second focus detection pixel 15q is narrower than the width of the light interception unit 44AS of the second focus detection pixel 15s, and moreover is narrower than the width of the light interception unit 44BQ of the second focus detection pixel 14q. The reason that the width of the light interception unit 44AQ is narrower than the width of the light interception unit 44BQ of the second focus detection pixel 15q which is paired therewith is in order to avoid any light other than the focus detection ray bundle that conveys the phase difference information from being incident upon the photoelectric conversion unit 41.

In addition to the above, the position in the X axis direction of the light interception unit 44AQ of the second focus detection pixel 15q of Fig. 21 is a position that covers the upper surface of the photoelectric conversion unit 41 more toward the left side (i.e. the -X axis direction) than a position that is spaced by the displacement amount g in the -X axis direction from the line CS. Due to this, the focus detection ray bundle that has passed through the first pupil region 61 (refer to Fig. 5) is incident upon the photoelectric conversion unit 41, so that it is possible to perform pupil splitting in an appropriate manner.

The second focus detection pixel 14p of Fig. 21 shows an example of a case in which the center of the micro lens 40 (i.e. the line CL) is deviated by +g in the X axis direction with respect to the center of the photoelectric conversion unit 41 (i.e. the line CS). In other words, this figure shows a second focus detection pixel 14p with which, in a case in which the micro lens 40 has suffered a displacement amount of +g in the direction of the X axis with respect to the photoelectric conversion unit 41 due to an error in positional alignment or the like during the on-chip lens formation process, pupil splitting can be performed in an appropriate manner. As shown in Fig. 21, the width in the X axis direction of the light interception unit 44BP of the second focus detection pixel 14p is narrower than the width in the X axis direction of the light interception unit 44BS of the second focus detection pixel 14s, and moreover is narrower than the width of the light interception unit 44AP of the second focus detection pixel 15p that will be described hereinafter. And the position of the light interception unit 44BP of the focus detection pixel 14p is a position that covers the upper surface of the photoelectric conversion unit 41 more toward the right side (i.e. the +X axis direction) than a position (the line CL) that is spaced by the displacement amount g in the +X axis direction from the line CS. Due to this, it is possible to perform pupil splitting in an appropriate manner in a state in which, in the second focus detection pixel 14p, the center of the micro lens 40 (i.e. the line CL) has deviated by +g in the X axis direction with respect to the center of the photoelectric conversion unit 41 (i.e. the line CS).

If it is supposed that the width and the position in the X axis direction of the light interception unit 44BP of the second focus detection pixel 14p are the same as those of the light interception unit 44BS of the second focus detection pixel 14s, then a portion of the focus detection ray bundle that has passed through the second pupil region 62 (refer to Fig. 5) (i.e. the light that is incident between the line CL of the photoelectric conversion unit 41 and the line CS) comes to be intercepted by the light interception unit 44BP, and accordingly it becomes impossible to perform pupil splitting in an appropriate manner.

However, as described above, by providing the light interception unit 44BP of the second focus detection pixel 14p upon the upper surface of the photoelectric conversion unit more toward the right side (i.e. the +X axis direction) than the line CL, it is possible to perform pupil splitting in an appropriate manner, since the focus detection ray bundle that has passed through the second pupil region 62 (refer to Fig. 5) is incident upon the photoelectric conversion unit 41.

In addition, as shown by way of example in Fig. 21, the second focus detection pixel 15p that is paired with the second focus detection pixel 14p is present in the pixel row 402P. The width in the X axis direction of the light interception unit 44AP of the second focus detection pixel 15p is broader than the width of the light interception unit 44AS of the second focus detection pixel 15s, and moreover is broader than that of the light interception unit 44BP of the second focus detection pixel 14p.

In addition to the above, the position in the X axis direction of the light interception unit 44AP of the second focus detection pixel 15p is a position that covers the upper surface of the photoelectric conversion unit 41 more toward the left side (i.e. the -X axis direction) than a position that is spaced by the displacement amount g in the +X axis direction from the line CS. Due to this, only the focus detection ray bundle that has passed through the first pupil region 61 (refer to Fig. 5) is incident upon the photoelectric conversion unit 41, so that it is possible to perform pupil splitting in an appropriate manner.

As explained above, in the second focus detection pixels 14 of Fig. 21 (14p, 14s, and 14q), the widths and the positions in the X axis direction of the light interception units 44AP, 44AS, and 44AQ are different. In a similar manner, in the second focus detection pixels 15 of Fig. 21 (15p, 15s, and 15q), the widths and the positions in the X axis direction of the light interception units 44BP, 44BS, and 44BQ are different.

From among the groups of second focus detection pixels 14, 15 of Fig. 21, the focus detection unit 21a of the body control unit 21 selects a plurality of pairs of second focus detection pixels 14, 15 ((14p, 15p), or (14s, 15s), or (14q, 15q)), on the basis of the state of deviation in the X axis direction between the centers of the micro lenses 40 and the centers of the pixels (i.e. of the photoelectric conversion units 41).

As described above, information specifying the deviations between the centers of the micro lenses 40 and the centers of the pixels is stored in the body control unit 41 of the camera body 2.

For example, on the basis of the information specifying deviations stored in the body control unit 21, the focus detection unit 21a selects a plurality of the pairs of second focus detection pixels (14s, 15s) from among the groups of second focus detection pixels 14, 15 if the amount of deviation g in the X axis direction between the centers of the micro lenses 40 and the centers of the pixels (for example, the centers of the photoelectric conversion units 41) is not greater than a predetermined value.

Furthermore, if the amount of deviation g in the X axis direction between the centers of the micro lenses 40 and the centers of the pixels is greater than the predetermined value on the basis of the information specifying the deviations stored in the body control unit 21, the focus detection unit 21a selects, from among the groups of second focus detection pixels 14, 15, either a plurality of the pairs of second focus detection pixels (14q, 15q), or a plurality of the pairs of second focus detection pixels (14p, 15p), according to the direction of the deviation.

For the second focus detection pixels 14, 15, illustration and explanation for description of the positional relationships between the image 600 of the exit pupil 60 of the imaging optical system 31 and the pixels (i.e. the photoelectric conversion units) will be curtailed, but the feature that the image 600 is divided substantially symmetrically left and right by the light interception units of the second focus detection pixels 14, 15, and the feature that this symmetry is not destroyed even if there is some deviation of the centers of the micro lenses 40 described above in the +Y axis direction or in the -Y axis direction, are the same as in the case of the first focus detection pixels 11, 13 explained above with reference to Fig. 24.

It should be understood that while, in Fig. 21, three pixel groups made up from the plurality of first focus detection pixels 11, 13 were shown by way of example, there is no need for the number of such pixel groups to be three; for example, there might be two such groups, or five such groups.

In a similar manner, while three pixel groups made up from the plurality of second focus detection pixels 14, 15 were shown by way of example, there is no need for the number of such pixel groups to be three.

### The Case of Displacement in the Y Axis Direction

While, in the above explanation, the case of a deviation in the X axis direction between the centers of the micro lenses 40 and the centers of the pixels was explained, the same also holds for the case of a deviation in the Y axis direction. A plurality of focus detection pixels whose pupil splitting structures are shifted from one another in the Y axis direction may, for example, be provided at positions corresponding to the focusing areas 101-4 through 101-11 of Fig. 2. As described in the third variant embodiment of the first embodiment, focus detection pixels are disposed in the Y axis direction in the focusing areas 101-4 through 110-11 that perform focus detection for a photographic subject that bears a horizontal pattern. In this manner, the pupil splitting structure of the plurality of focus detection pixels is shifted in the Y axis direction for detecting phase difference in the Y axis direction.

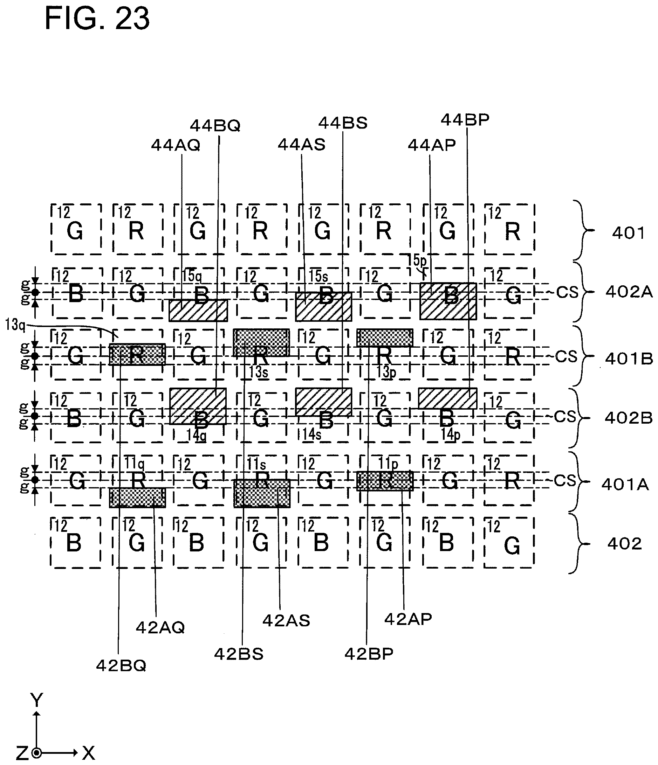

Fig. 23 is an enlarged view of a part of a pixel array that is provided in a position corresponding to the focusing areas 101-4 through 101-11 of the image sensor 22. In Fig. 23, to structures that are the same as ones of Fig. 3 (relating to the first embodiment) the same reference symbols are appended, and the micro lenses 40 are omitted. In a similar manner to the case with Fig. 3, each of the pixels in this image sensor 22 is provided with one or another of three color filters having different spectral sensitivities: R (red), G (green), and B (blue).

According to Fig. 23, the image sensor 22 comprises: imaging pixels 12 that are R pixels, G pixels, or B pixels; first focus detection pixels 11p, 11s, and 11q that are disposed to replace some of the R imaging pixels 12; first focus detection pixels 13p, 13s, and 13q that are disposed to replace some others of the R imaging pixels 12; second focus detection pixels 14p, 14s, and 14q that are disposed to replace some of the B imaging pixels 12; and second focus detection pixels 15p, 15s, and 15q that are disposed to replace some others of the B imaging pixels 12.

### The First Focus Detection Pixels

In the example of Fig. 23, three first focus detection pixels 11p, 11s, and 11q are provided as first focus detection pixels 11. Moreover, three first focus detection pixels 13p, 13s, and 13q are provided as first focus detection pixels 13. The first focus detection pixels 11p, 11s, and 11q are disposed in a pixel row 401A. And the first focus detection pixels 13p, 13s, and 13q are disposed in a pixel row 401B.

A plurality of pairs of the first focus detection pixels 11p, 13p are disposed in the column direction (i.e. the Y axis direction). Moreover, a plurality of pairs of the first focus detection pixels 11s, 13s are disposed in the column direction (i.e. the Y axis direction). And a plurality of pairs of the first focus detection pixels 11q, 13q are disposed in the column direction (i.e. the Y axis direction). In the present embodiment, the plurality of pairs of the first focus detection pixels 11p, 13p, the plurality of pairs of the first focus detection pixels 11s, 13s, and the plurality of pairs of the first focus detection pixels 11p, 13p each will be referred to as a group of first focus detection pixels 11, 13.

It should be understood that the pair-to-pair intervals between the plurality of pairs of the first focus detection pixels (11p, 13p), (11s, 13s), or (11q, 13q) may be constant, or may be different.

The positions and the widths in the Y axis direction of the respective reflective units 42AP, 42AS, and 42AQ of the first focus detection pixels 11p, 11s, and 11q (in other words, their areas in the XY plane) are different. It will be sufficient if at least one of the positions and the widths in the X axis direction of the reflective units 42AP, 42AS, and 42AQ is different. It would also be acceptable for the areas of each of the reflective units 42AP, 42AS, and 42AQ to be different.

Moreover, the positions and the widths in the Y axis direction of the respective reflective units 42BP, 42BS, and 42BQ of the first focus detection pixels 13p, 13s, and 13q (in other words, their areas in the XY plane) are different. It will be sufficient if at least one of the positions and the widths in the X axis direction of the reflective units 42BP, 42BS, and 42BQ is different. It would also be acceptable for the areas of each of the reflective units 42BP, 42BS, and 42BQ to be different.

The reason why as shown in Fig. 23, a plurality of focus detection pixels the positions of whose pupil splitting structures are different are provided was explained with reference to Fig. 21. In other words, this is because sometimes it may happen that, due to positional errors and so on in this on-chip lens formation process, a slight deviation in the Y axis direction may occur between the center of a completed micro lens 40 and the center of its corresponding pixel upon the first substrate 111 (for example, the center of the photoelectric conversion unit 41). Since this deviation typically occurs in common for all of the pixels, accordingly, if for example the center of the micro lens 40 of one of the pixels deviates by just the length g in the +Y axis direction with respect to the center of its pixel, then, in a similar manner, deviations in the +Y axis direction of the length g will occur for the other pixels.

In this example if, in a plurality of the pairs of the first focus detection pixels (11s, 13s), the centers of the micro lenses 40 and the centers of the pixels (for example, their photoelectric conversion units 41) are in agreement with one another (i.e. are not deviated from one another), then it is arranged for these pixel pairs to be employed for pupil splitting. Furthermore if, in a plurality of the pairs of the first focus detection pixels (11p, 13p) or in a plurality of the pairs of the first focus detection pixels (11q, 13p), the centers of the micro lenses 40 and the centers of the pixels (for example, their photoelectric conversion units 41) are not in agreement with one another (i.e. a deviation between them is present), then it is arranged for these pixel pairs to be employed for pupil splitting.

A case will now be discussed, in relation to the first focus detection pixel 11q of Fig. 23, in which the center of the micro lens 40 (i.e. the line CL) is displaced by -g in the direction of the Y axis with respect to the center of the photoelectric conversion unit 41 (i.e. the line CS). That is, a first focus detection pixel 11q is shown, with which it is possible to perform pupil splitting in an appropriate manner, in a case in which, due to an error in positional alignment or the like during the on-chip lens formation process, the micro lens 40 has been formed with a displacement amount of -g in the direction of the Y axis with respect to the photoelectric conversion unit 41. The width in the Y axis direction of the reflective unit 42AQ of the first focus detection pixel 11q is narrower than the width in the Y axis direction of the reflective unit 42AS of the first focus detection pixel 11s, and is the same as the width of the reflective unit 42BQ of the first focus detection pixel 13q, as will be described hereinafter. The position of the reflective unit 42AQ of the focus detection pixel 11q is a position that covers the lower surface of the photoelectric conversion unit 41 more on the lower side (i.e. toward the -Y axis direction) than the position (the line CL) that is in the -Y axis direction from the line CS by the displacement amount g. Due to this, the first focus detection pixel 11q is capable of performing pupil splitting in an appropriate manner in the state in which the center (i.e. the line CL) of the micro lens 40 is deviated by -g in the Y axis direction with respect to the center of the photoelectric conversion unit 41 (i.e. the line CS).

Moreover, as shown by way of example in Fig. 23, a first focus detection pixel 13q is present in the pixel row 401B that is paired with the first focus detection pixel 11q. The width in the Y axis direction of the reflective unit 42BQ of the first focus detection pixel 13q is narrower than the width of the reflective unit 42BS of the first focus detection pixel 13s, and is the same as the width of the reflective unit 42AQ of the first focus detection pixel 11q. The fact that the width of the reflective unit 42BQ is the same as the width of the reflective unit 42AQ of the first focus detection pixel 11q is in order to avoid any light other than the focus detection ray bundle that carries the focus difference information from being reflected by the reflective unit 42BQ and being again incident upon the photoelectric conversion unit 41 for a second time.

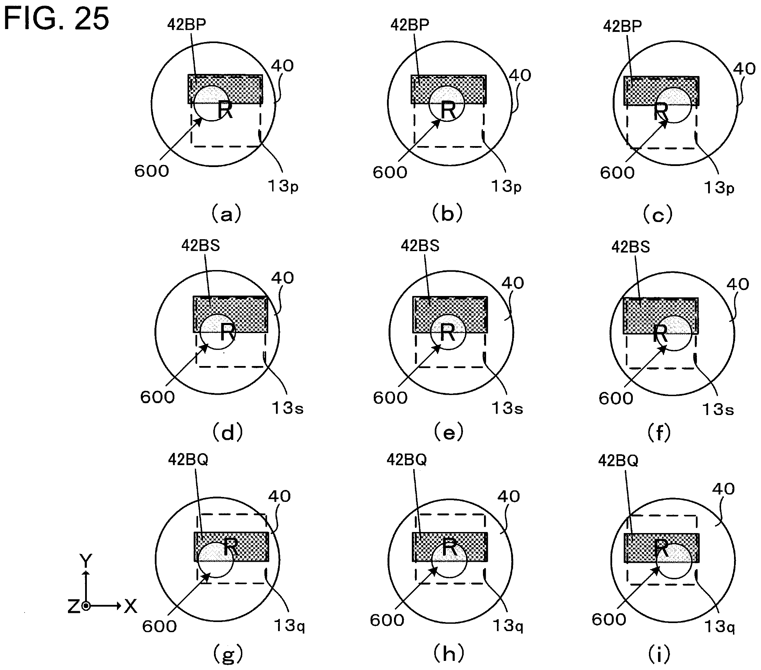

In addition to the above, the position in the Y axis direction of the reflective unit 42BQ of the first focus detection pixel 13q of Fig. 23 is a position that covers the lower surface of the photoelectric conversion unit 41 more to the upper side (i.e. the +Y axis direction) than the position that is shifted by the displacement amount g in the -Y axis direction from the line CS. Due to this, it is possible for pupil splitting to be performed in an appropriate manner, in a similar manner to the case when the center of the micro lens 40 and the center of the pixel are deviated from one another in the X axis direction. To give a specific example, as will be explained hereinafter with reference to Fig. 25(h), the image 600 of the exit pupil 600 of the imaging optical system 31 is divided substantially symmetrically up and down by the reflective unit 42BQ of the second focus detection pixel 13q.

A case will now be discussed, in relation to the first focus detection pixel 11p of Fig. 23, in which the center of the micro lens 40 (i.e. the line CL) is displaced by +g in the direction of the Y axis with respect to the center of the photoelectric conversion unit 41 (i.e. the line CS). That is, a first focus detection pixel 11p is shown which is capable of performing pupil splitting in an appropriate manner, in a case in which, due to an error in positional alignment or the like during the on-chip lens formation process, the micro lens 40 has suffered a displacement amount of +g in the direction of the Y axis with respect to the photoelectric conversion unit 41. The width in the Y axis direction of the reflective unit 42AP of the first focus detection pixel 11p is narrower than the width in the Y axis direction of the reflective unit 42AS of the first focus detection pixel 11s, and is the same as the width of the reflective unit 42BP of the first focus detection pixel 13p, as will be described hereinafter. The position of the reflective unit 42AP of the focus detection pixel 11p is a position that covers the lower surface of the photoelectric conversion unit 41 more on the lower side (i.e. the -Y axis direction) than the position (i.e. the line CL) corresponding to the displacement amount g in the +Y axis direction from the line CS. Due to this, the first focus detection pixel 11p is capable of performing pupil splitting in an appropriate manner in the state in which the center (i.e. the line CL) of the micro lens 40 is deviated by +g in the Y axis direction with respect to the center of the photoelectric conversion unit 41 (i.e. the line CS).

Moreover, as shown in Fig. 23, a first focus detection pixel 13p that is paired with the first focus detection pixel 11p is present in the pixel row 401B. The width in the Y axis direction of the reflective unit 42BP of this first focus detection pixel 13p is narrower than the width of the reflective unit 42BS of the first focus detection pixel 13s, and is the same as the width of the reflective unit 42AP of the first focus detection pixel 11p. The fact that the width of the reflective unit 42BP is the same as the width of the reflective unit 42AP of the first focus detection pixel 11p which is in the pairwise relationship therewith is in order to avoid any light other than the focus detection ray bundle that carries the focus difference information from being reflected by the reflective unit 42BP and being again incident upon the photoelectric conversion unit 41 for a second time.

In addition to the above, the position in the Y axis direction of the reflective unit 42BP of the first focus detection pixel 13p is a position that covers the lower surface of the photoelectric conversion unit 41 more to the upper side (i.e. the +Y axis direction) than a position which is shifted by the displacement amount g in the +Y axis direction from the line CS. Due to this, pupil splitting is performed in an appropriate manner, in a similar manner to the case in which the center of the micro lens 40 and the center of the pixel are displaced from one another in the X axis direction.

As described above, the positions and the widths in the Y axis direction of the respective reflective units 42AP, 42AS, and 42AQ of the first focus detection pixels 11 of Fig. 23 (11p, 11s, and 11q) are different. In a similar manner, the positions and the widths in the Y axis direction of the respective reflective units 42BP, 42BS, and 42BQ of the first focus detection pixels 13 (13p, 13s, and 13q) are different.

From among the groups of first focus detection pixels 11, 13 of Fig. 23, the focus detection unit 21a of the body control unit 41 selects a plurality of pairs of first focus detection pixels 11, 13 ((11p, 13p), or (11s, 13s), or (11q, 13q)) on the basis ofthe state of deviation in the Y axis direction between the centers of the micro lenses 40 and the centers of the pixels (i.e. of the photoelectric conversion units 41).

As described above, information relating to the deviations is stored in the body control unit 21 of the camera body 2.

Examples of the first focus detection pixel 13 will now be explained with reference to Fig. 25. Fig. 25(a) through Fig. 25(i) are figures showing examples of images 600 of the exit pupil 60 of the imaging optical system 31 as projected upon the first focus detection pixel 13 by its micro lens 40. The center of the image 600 of the exit pupil 60 agrees with the center of the micro lens 40. When the center of the micro lens 40 deviates with respect to the center of the pixel (i.e. the center of its photoelectric conversion unit 41), the position of the image 600 deviates from the center of the pixel (i.e. from the center of the photoelectric conversion unit 41).

It should be understood that, in Fig. 25, in order clearly to show the positional relationship between the image 600 of the exit pupil 60 and the pixel (i.e. the photoelectric conversion unit 41), the exit pupil image 600 is shown when the aperture of the photographic optical system 31 is narrowed down to a small aperture.

In Fig. 25(a), the center of the micro lens 40 is deviated with respect to the center of the second focus detection pixel 13s toward the -X axis direction and also toward the +Y axis direction. And, in Fig. 25(b), the center of the micro lens 40 agrees with the center of the first focus detection pixel 13s in the X axis direction but is deviated with respect thereto toward the +Y axis direction. Moreover, in Fig. 25(c), the center of the micro lens 40 is deviated with respect to the center of the first focus detection pixel 13s toward the +X axis direction and also toward the +Y axis direction.

In Fig. 25(d), the center of the micro lens 40 is deviated with respect to the center of the first focus detection pixel 13s toward the -X axis direction but agrees with the center thereof in the Y axis direction. In Fig. 25(e), the center of the micro lens 40 agrees with the center of the first focus detection pixel 13s in the X axis direction and also in the Y axis direction. And in Fig. 25(f), the center of the micro lens 40 is deviated with respect to the center of the first focus detection pixel 13s toward the +X axis direction but agrees with the center thereof in the Y axis direction.

Furthermore, in Fig. 25(g), the center of the micro lens 40 is deviated with respect to the center of the first focus detection pixel 13q toward the -X axis direction and also toward the -Y axis direction. And, in Fig. 25(h), the center of the micro lens 40 agrees with the center of the first focus detection pixel 13q in the X axis direction but is deviated with respect thereto toward the -Y axis direction. Moreover, in Fig. 25(i), the center of the micro lens 40 is deviated with respect to the center of the first focus detection pixel 13q toward the +X axis direction and toward the -Y axis direction.

For example, if the amount of deviation g of the center of the micro lens 40 with respect to the center of the pixel (i.e. of its photoelectric conversion unit 41) exceeds a predetermined value in the -Y axis direction, then the focus detection unit 21a selects the first focus detection pixel 13q and the first focus detection pixel 11q that is paired with that first focus detection pixel 13q. According to Fig. 25(h) which shows the first focus detection pixel 13q, the image 600 is divided substantially symmetrically up and down, due to the reflective unit 42BQ of the first focus detection pixel 13q. This symmetry is not destroyed even if the center of the micro lens 40 described above deviates in the +X axis direction as shown in Fig. 25(i) or in the -X axis direction as shown in Fig. 25(g).

Yet further, if the amount of deviation g in the Y axis direction of the center of the micro lens 40 with respect to the center of the pixel (i.e. of its photoelectric conversion unit 41) does not exceed the predetermined value, then the focus detection unit 21a selects the first focus detection pixel 13s and the first focus detection pixel 11s that is paired with that first focus detection pixel 13s. In this case, according to Fig. 25(e) which shows the first focus detection pixel 13s, the image 600 is divided substantially symmetrically up and down, due to the reflective unit 42BS of the first focus detection pixel 13s. This symmetry is not destroyed even if the center of the micro lens 40 described above deviates in the +X axis direction as shown in Fig. 25(f) or in the -X axis direction as shown in Fig. 25(d).

Even further, if the amount of deviation g of the center of the micro lens 40 with respect to the center of the pixel (i.e. of its photoelectric conversion unit 41) exceeds the predetermined value in the +Y axis direction, then the focus detection unit 21a selects the first focus detection pixel 11p and the first focus detection pixel 13p that is paired with that first focus detection pixel 11p. And, according to Fig. 25(b) which shows the first focus detection pixel 13p, the image 600 is divided substantially symmetrically up and down, due to the reflective unit 42BP of the first focus detection pixel 13p. This symmetry is not destroyed even if the center of the micro lens 40 described above deviates in the +X axis direction as shown in Fig. 25(c) or in the -X axis direction as shown in Fig. 25(a).

Although illustration and explanation are curtailed, the same remarks hold for the first focus detection pixels 11 as for the first focus detection pixels 13 described above.

### The Second Focus Detection Pixels

In the example of Fig. 23, three second focus detection pixels 14p, 14s, and 14q are provided as second focus detection pixels 14. Moreover, three second focus detection pixels 15p, 15s, and 15q are provided as second focus detection pixels 15. The second focus detection pixels 14p, 14s, and 14q are disposed in a pixel row 402B. And the second first focus detection pixels 15p, 15s, and 15q are disposed in a pixel row 402A.

A plurality of pairs of the second focus detection pixels 14p, 15p are disposed in the column direction (i.e. the Y axis direction). Moreover, a plurality of pairs of the second focus detection pixels 14s, 15s are disposed in the column direction (i.e. the Y axis direction). And a plurality of pairs of the second focus detection pixels 14q, 15q are disposed in the column direction (i.e. the Y axis direction). In a similar manner to the case with the first focus detection pixels 11, 13, the plurality of pairs of the second focus detection pixels 14p, 15p, the plurality of pairs of the second focus detection pixels 14s, 15s, and the plurality of pairs of the second focus detection pixels 14p, 15p each will be referred to as a group of second focus detection pixels 14, 15.

It should be understood that the pair-to-pair intervals between the plurality of pairs of the second focus detection pixels (14p, 15p), (14s, 15s), or (14q, 15q) may be constant, or may be different.

The positions and the widths of the respective light interception units 44BP, 44BS, and 44BQ of the second focus detection pixels 14p, 14s, and 11q (in other words, their areas in the XY plane) are different. It will be sufficient if at least one of the positions in the X axisdirection, the widths in the X axis direction, and the areas of the reflective units 44BP, 44BS, and 44BQ is different.

Moreover, the positions and the widths of the respective light interception units 44AP, 44AS, and 44AQ of the second focus detection pixels 15p, 15s, and 15q (in other words, their areas in the XY plane) are different. It will be sufficient if at least one of the positions in the X axisdirection, the widths in the X axis direction, and the areas of the reflective units 44AP, 44AS, and 44AQ is different.

In this example, it is arranged to employ the plurality of pairs of second focus detection pixels (14s, 15s) for pupil splitting when the centers of the micro lenses 40 and the centers of the pixels (for example the photoelectric conversion units 41) agree with one another (i.e. when there is no deviation between them). Furthermore, it is arranged to employ the plurality of pairs of second focus detection pixels (14p, 15p) or the plurality of pairs of second focus detection pixels (14q, 15q) for pupil splitting when the centers of the micro lenses 40 and the centers of the pixels (for example the photoelectric conversion units 41) do not agree with one another (i.e. when there is some deviation between them).

For the second focus detection pixel 14q of Fig. 23, an example is shown of a case in which the center of the micro lens 40 (i.e. the line CL) deviates by -g in the Y axis direction with respect to the center of the photoelectric conversion unit 41 (i.e. the line CS). In other words a second focus detection pixel 14q is shown with which it is possible to perform pupil splitting in an appropriate manner, if, due to an error in positional alignment or the like during the on-chip lens formation process, the micro lens 40 has suffered a displacement amount of -g in the direction of the Y axis with respect to the photoelectric conversion unit 41. The width in the Y axis direction of the light interception unit 44BQ of the second focus detection pixel 14q is wider than the width in the Y axis direction of the light interception unit 42AS of the second focus detection pixel 14s, and moreover is also broader than the light interception unit 44AQ of the second focus detection pixel 15q that will be described hereinafter. And the position of the light interception unit 44BQ of the second focus detection pixel 14q is a position in which it covers the upper surface of the photoelectric conversion unit 41 more toward the upper side (i.e. toward the +Y axis direction) than the position (the line CL) that is toward the -Y axis direction from the line CS by the displacement amount g. Due to this, pupil splitting can be performed in an appropriate manner in the state in which, in the second focus detection pixel 14q, the center of the micro lens 40 (i.e. the line CL) deviates by -g in the Y axis direction with respect to the center (i.e. the line CS) of the photoelectric conversion unit 41.

In addition, as shown by way of example in Fig. 23, a second focus detection pixel 15q that is paired with the second focus detection pixel 14q is present in the pixel row 402A. The width in the Y axis direction of the light interception unit 44AQ of the second focus detection pixel 15q is narrower than the width of the light interception unit 44AS of the second focus detection pixel 15s, and moreover is narrower than that of the light interception unit 44BQ of the second focus detection pixel 14q. The reason that the width of the light interception unit 44AQ is narrower than the width of the light interception unit 44BQ of the second focus detection pixel 15q which is paired therewith is in order to avoid any light other than the focus detection ray bundle that conveys the phase difference information from being incident upon the photoelectric conversion unit 41.

In addition to the above, the position in the Y axis direction of the light interception unit 44AQ of the second focus detection pixel 15q of Fig. 23 is a position that covers the upper surface of the photoelectric conversion unit 41 more toward the lower side (i.e. the -Y axis direction) than a position that is spaced by the displacement amount g in the -Y axis direction from the line CS. Due to this, it is possible to perform pupil splitting in an appropriate manner, in a similar manner to the case in which the center of the micro lens 40 and the center of the pixel are displaced from one another in the X axis direction.

The second focus detection pixel 14p of Fig. 23 shows an example of a case in which the center of the micro lens 40 (i.e. the line CL) is deviated by +g in the Y axis direction with respect to the center of the photoelectric conversion unit 41 (i.e. the line CS). In other words, this figure shows a second focus detection pixel 14p with which, in a case in which, due to an error in positional alignment or the like during the on-chip lens formation process, the micro lens 40 has suffered a displacement amount of +g in the direction of the Y axis with respect to the photoelectric conversion unit 41, pupil splitting can be performed in an appropriate manner. As shown in Fig. 23, the width in the Y axis direction of the light interception unit 44BP of the second focus detection pixel 14p is narrower than the width in the Y axis direction of the light interception unit 44BS of the second focus detection pixel 14s, and moreover is narrower than the width of the light interception unit 44AP of the second focus detection pixel 15p that will be described hereinafter. And the position of the light interception unit 44BP of the focus detection pixel 14p is a position that covers the upper surface of the photoelectric conversion unit 41 more toward the upper side (i.e. the +Y axis direction) than a position (the line CL) that is spaced by the displacement amount g in the +Y axis direction from the line CS. Due to this, it is possible to perform pupil splitting in an appropriate manner in a state in which, in the second focus detection pixel 14p, the center of the micro lens 40 (i.e. the line CL) has deviated by +g in the Y axis direction with respect to the center of the photoelectric conversion unit 41 (i.e. the line CS).

In addition, as shown by way of example in Fig. 23, a second focus detection pixel 15p that is paired with the second focus detection pixel 14p is present in the pixel row 402A. The width in the Y axis direction of the light interception unit 44AP of the second focus detection pixel 15p is broader than the width of the light interception unit 44AS of the second focus detection pixel 15s, and moreover is broader than that of the light interception unit 44BP of the second focus detection pixel 14p.

In addition to the above, the position in the Y axis direction of the light interception unit 44AP of the second focus detection pixel 15p is a position that covers the upper surface of the photoelectric conversion unit 41 more toward the lower side (i.e. the - Y axis direction) than a position that is spaced by the displacement amount g in the +Y axis direction from the line CS. Due to this, it is possible to perform pupil splitting in an appropriate manner, in a similar manner to the case in which the center of the micro lens 40 and the center of the pixel are displaced from one another in the X axis direction.

As explained above, in the second focus detection pixels 14 of Fig. 23 (14p, 14s, and 14q), the widths and the positions in the Y axis direction of the light interception units 44AP, 44AS, and 44AQ are different. In a similar manner, in the second focus detection pixels 15 (15p, 15s, and 15q), the widths and the positions in the Y axis direction of the light interception units 44BP, 44BS, and 44BQ are different.

From among the groups of second focus detection pixels 14, 15 of Fig. 23, the focus detection unit 21a of the body control unit 21 selects a plurality of pairs of second focus detection pixels 14, 15 ((14p, 15p), or (14s, 15s), or (14q, 15q)), on the basis of the state of deviation in the Y axis direction between the centers of the micro lenses 40 and the centers of the pixels (i.e. of the photoelectric conversion units 41).

As described above, information specifying the deviations between the centers of the micro lenses 40 and the centers of the pixels is stored in the body control unit 41 of the camera body 2.

For example, on the basis of the information specifying deviations stored in the body control unit 21, the focus detection unit 21a selects a plurality of the pairs of second focus detection pixels (14s, 15s) from among the groups of second focus detection pixels 14, 15 if the amount of deviation g in the Y axis direction between the centers of the micro lenses 40 and the centers of the pixels (for example, the centers of the photoelectric conversion units 41) is not greater than a predetermined value.

Furthermore, if the amount of deviation g in the Y axis direction between the centers of the micro lenses 40 and the centers of the pixels is greater than the predetermined value, then, on the basis of the information specifying the deviations stored in the body control unit 21, the focus detection unit 21a selects, from among the groups of second focus detection pixels 14, 15, either a plurality of the pairs of second focus detection pixels (14q, 15q), or a plurality of the pairs of second focus detection pixels (14p, 15p), according to the direction of the deviation.

For the second focus detection pixels 14, 15, illustration and explanation for description of the positional relationships between the image 600 of the exit pupil 60 of the imaging optical system 31 and the pixels (i.e. the photoelectric conversion units) will be curtailed, but the feature that the image 600 is divided substantially symmetrically up and down by the light interception units of the second focus detection pixels 14, 15, and the feature that this symmetry is not destroyed even if there is some deviation of the centers of the micro lenses 40 described above in the +X axis direction or in the -X axis direction, are the same as in the case of the first focus detection pixels 11, 13 explained above with reference to Fig. 25.

It should be understood that while, in Fig. 23, three pixel groups made up from the plurality of first focus detection pixels 11, 13 were shown by way of example, there is no need for the number of such pixel groups to be three; for example, there might be two such groups, or five such groups.

In a similar manner, while three pixel groups made up from the plurality of second focus detection pixels 14, 15 were shown by way of example, there is no need for the number of such pixel groups to be three.

Furthermore, the magnitudes of the displacement amounts g of the pupil splitting structures of Figs. 21 and 23 (i.e. of the reflective units 42A, 42B in the case of the first focus detection pixels 11, 13, and of the light interception units 44B, 44A in the case of the second focus detection pixels 14, 15) shown by way of example in the explanation of this embodiment are exaggerated in the figures as compared to their actual magnitudes.

According to the second embodiment as explained above, the following operations and effects are obtained.
(1) The image sensor 22 comprises the plurality of first focus detection pixels 11, 13 that have the micro lenses 40, the photoelectric conversion units 41 that receive ray bundles that have passed through the imaging optical system 31 via the micro lenses 40, and the reflective units 42A, 42B that reflect portions of the ray bundles that have passed through the micro lenses 40 back to the photoelectric conversion units 41. And the plurality of first focus detection pixels 11, 13 include groups of first focus detection pixels 11, 13 in which the positions of the reflective units 42A, 42B with respect to the photoelectric conversion units 41 are different (for example, the plurality of pairs of first focus detection pixels (11p, 13p), the plurality of pairs of first focus detection pixels (11s, 13s), and the plurality of pairs of first focus detection pixels (11p, 13q)). Due to this it is possible, for example, to obtain an image sensor 22 that is capable of selecting a plurality of pairs of the first focus detection pixels 11, 13 that are appropriate for focus detection from among the groups of first focus detection pixels 11, 13, and that is thus suitable for focus detection.
(2) The first group of first focus detection pixels 11, 13 includes the first focus detection pixels 11s, 13s in which the reflective units 42A, 42B are disposed in predetermined positions, and the first focus detection pixels 11p, 13p and the first and the first focus detection pixels 11q, 13q in which their reflective units 42A, 42B are respectively shifted toward positive and negative directions from those predetermined positions. Due to this, it is possible to obtain an image sensor 22 that is adapted for focus detection, and with which it is possible to select first focus detection pixels 11, 13 which are appropriate for focus detection, so that, if the centers of the micro lenses 40 are displaced in the X axis direction with respect to the centers of the pixels (i.e. of the photoelectric conversion units 41), then, for example, only the focus detection ray bundle that has passed through the first pupil region 61 (refer to Fig. 5) is reflected by the reflective unit 42B of the first focus detection pixel 13 and is incident again upon the photoelectric conversion unit 41 for a second time, while only the focus detection ray bundle that has passed through the second pupil region 62 (refer to Fig. 5) is reflected by the reflective unit 42A of the first focus detection pixel 11 and is incident again upon the photoelectric conversion unit 41 for a second time.
(3) In the first focus detection pixels 11s, 13s, for example, the reflective units 42AS, 42BS are disposed in positions that correspond to the prearranged central positions at which the centers of the micro lenses 40 and the centers of the pixels (for example, the photoelectric conversion units 41) agree with one another. Due to this, it becomes possible to avoid any negative influence being exerted upon focus detection, even if a deviation that has occurred during the on-chip lens formation process between the centers of the micro lenses 40 and the centers of the pixels (for example, the photoelectric conversion units 41) is present, either in the positive or the negative X axis direction.
(4) Each of the first focus detection pixels 11s, 13s, the first focus detection pixels 11p, 13p, and the first focus detection pixels 11q, 13q includes a first focus detection pixel 13 having a reflective unit 42B that, among first and second ray bundles that have passed through the first and second pupil regions 61, 62 of the exit pupil 60 of the imaging optical system 31, reflects a first ray bundle that has passed through its photoelectric conversion unit 41, and a first focus detection pixel 11 having a reflective unit 42A that reflects a second ray bundle that has passed through its photoelectric conversion unit 41. Due to this, it is possible to provide, to the image sensor 22, each of the first focus detection pixels 11s, 13s that constitute a pair, the first focus detection pixels 11p, 13p that constitute a pair, and the first focus detection pixels 11q, 13q that constitute a pair.
(5) In each of the first focus detection pixels 11s, 13s, the first focus detection pixels 11p, 13p, and the first focus detection pixels 11q, 13q, the position at which the exit pupil 60 of the imaging optical system 31 is divided into the first and second pupil regions 61, 62 is different. Due to this, it is possible to obtain an image sensor 22 with which it is possible to select first focus detection pixels 11, 13 constituting a pair so that pupil splitting can be performed in an appropriate manner, and which is thus particularly suitable for focus detection.
(6) In each of the first focus detection pixels 11s, 13s, the first focus detection pixels 11p, 13p, and the first focus detection pixels 11q, 13q, the width of the respective reflective unit 42AP, 42AS, and 42AQ and the width of the respective reflective unit 42BP, 42BS, and 42BQ are equal. Due to this, it is possible to prevent any light other than the appropriate focus detection ray bundle, which carries the phase difference information, from being reflected and from again being incident upon the photoelectric conversion unit 41.
(7) The plurality of first focus detection pixels of the image sensor 22 include groups of first focus detection pixels 11, 13 that include at least: the pixel row 401S in which are arranged the first focus detection pixels 11s and 13s whose respective reflective units 42AS, 42BS are respectively positioned, with respect to their photoelectric conversion units 41, in a first position and in a second position corresponding to the centers of those photoelectric conversion units 41 (i.e. their lines CS); and the pixel row 401Q in which are arranged the first focus detection pixels 11q and 13q whose respective reflective units 42AQ, 42BQ are respectively positioned, with respect to their photoelectric conversion units 41, in a third position and in a fourth position that are deviated by -g in the X axis direction with respect to the centers of those photoelectric conversion units 41 (i.e. their lines CS). And, among the first and second ray bundles that have passed through the first and second pupil regions 61, 62 of the exit pupil 60 of the imaging optical system 31, the reflective unit 42BS of the first focus detection pixel 13s reflects the first ray bundle that has passed through its photoelectric conversion unit 41, and the reflective unit 42AS of the first focus detection pixel 11s reflects the second ray bundle that has passed through its photoelectric conversion unit 41. Furthermore, among the first and second ray bundles that have passed through the first and second pupil regions 61, 62 of the exit pupil 60 of the imaging optical system 31, the reflective unit 42BQ of the first focus detection pixel 13q reflects the first ray bundle that has passed through its photoelectric conversion unit 41, and the reflective unit 42AQ of the first focus detection pixel 11q reflects the second ray bundle that has passed through its photoelectric conversion unit 41.
   Due to this, it is possible to perform focus detection in an appropriate manner by employing those first focus detection pixels 11, 13 from the groups of first focus detection pixels 11, 13 that are suitable for focus detection.
(8) The groups of first focus detection pixels 11, 13 further includes the pixel row 401P in which are arranged the first focus detection pixels 11p and 13p whose respective reflective units 42AP, 42BP are respectively positioned, with respect to their photoelectric conversion units 41, in a fifth position and in a sixth position that are deviated by +g in the X axis direction with respect to the centers of those photoelectric conversion units 41 (i.e. their lines CS). And, among the first and second ray bundles that have passed through the first and second pupil regions 61, 62 of the exit pupil 60 of the imaging optical system 31, the reflective unit 42BP of the first focus detection pixel 13p reflects the first ray bundle that has passed through its photoelectric conversion unit 41, and the reflective unit 42AP of the first focus detection pixel 11p reflects the second ray bundle that has passed through its photoelectric conversion unit 41. Due to this, it is possible to perform focus detection in an appropriate manner by employing those first focus detection pixels 11, 13 from among the first focus detection pixels (11p, 13p), (11s, 13s), and (11q, 13q) that are suitable for focus detection.
(9) The pixel row 401Q and the pixel row 401P described above are arranged side by side with respect to the pixel row 401S in the direction (the Y axis direction) that intersects with the direction in which the first focus detection pixels 11s and 13s are arranged (i.e. the X axis direction). Due to this, as compared to a case in which the pixel row 401Q and the pixel row 401P are disposed in positions that are apart from the pixel row 401S, among the first focus detection pixels (11p, 13p), (11s, 13s), and (11q, 13q), the occurrence of erroneous focus detection becomes more difficult, and it is possible to enhance the accuracy of focus detection.
(10) In the first focus detection pixels 11s, 13s, their respective reflective units 42AS, 42BS are disposed in the first and second positions corresponding to the centers of their photoelectric conversion units 41 (i.e. to the lines CS); in the first focus detection pixels 11q, 13q, their respective reflective units 42AQ, 42BQ are disposed in the third and fourth positions that are deviated by -g in the X axis direction (i.e. in the direction in which the first focus detection pixels 11s and 13s are arrayed) with respect to the centers of their photoelectric conversion units 41 (i.e. the lines CS); and, in the first focus detection pixels 11p, 13p, their respective reflective units 42AP, 42BP are disposed in the fifth and sixth positions that are deviated by +g in the X axis direction (i.e. in the direction in which the first focus detection pixels 11s and 13s are arrayed) with respect to the centers of their photoelectric conversion units 41 (i.e. the lines CS). Due to this, whether a deviation between the centers of the micro lenses 40 and the centers of the pixels (for example, their photoelectric conversion units 41) that has occurred during the on-chip formation process is in the positive or in the negative X axis direction, it still becomes possible to prevent any negative influence being exerted upon focus detection.

### The First Variant Embodiment of Embodiment 2

As in the second embodiment, provision of a plurality of focus detection pixels the positions of whose pupil splitting structures (in the case of the first focus detection pixels 11, 13, the reflective units 42A, 42B, and in the case of the second focus detection pixels 14, 15, the light interception units 44B, 44A) are deviated from one another in the X axis direction and in the Y axis direction is effective, even when the directions of the light incident upon the micro lenses 40 of the image sensor 22 are different.

Generally, by contrast to the fact that the light that has passed through the exit pupil 60 of the imaging optical system 31 in the central portion of the region 22a of the image sensor 22a is incident almost vertically, in the peripheral portions that are positioned more toward the exterior than the central portion of the region 22a described above (where the image height is greater than in the central portion), the light is incident slantingly. Due to this fact, the light is incident slantingly upon the micro lenses 40 of the focus detection pixels that are provided at positions corresponding to the focusing area 101-1 and to the focusing areas 101-3 through 101-11, i.e. corresponding to the focusing areas other than the focusing area 101-2 that corresponds to the central portion of the region 22a.

When the light is incident slantingly upon one of the micro lenses 40, even if no deviation is occurring between the center of the micro lens 40 and the center of the photoelectric conversion unit 41 behind it, sometimes it may happen that pupil splitting cannot be performed in an appropriate manner, since deviation of the position of the image 600 of the exit pupil 60 occurs with respect to the pupil splitting structure (in the case of the first focus detection pixels 11, 13, the reflective units 42A, 42B, and in the case of the second focus detection pixels 14, 15, the light interception units 44B, 44A).

Therefore, in this first variant embodiment of the second embodiment, even if the light is incident slantingly upon the micro lens 40, focus detection pixels are selected the positions of whose pupil splitting structures (in the case of the first focus detection pixels 11, 13, the reflective units 42A, 42B, and in the case of the second focus detection pixels 14, 15, the light interception units 44B, 44A) are displaced with respect to the centers of the pixels in the X axis direction and/or the Y axis direction, so that pupil splitting is performed in an appropriate manner in this state. In concrete terms, the focus detection unit 21a of the body control unit 21 selects first focus detection pixels 11, 13 that correspond to the image height from among the groups of first focus detection pixels 11, 13 the positions of whose reflective units 42A, 42B with respect to their photoelectric conversion units 41 are different (for example, a plurality of pairs of the first focus detection pixels (11p, 13p), or a plurality of pairs of the first focus detection pixels (11s, 13s), or a plurality of pairs of the first focus detection pixels (11q, 13q)). Moreover, the focus detection unit 21a selects second focus detection pixels 14, 15 that correspond to the image height from among the groups of second focus detection pixels 14, 15 the positions of whose light interception units 44A, 44B with respect to their photoelectric conversion units 41 are different (for example, a plurality of pairs of the second focus detection pixels (14p, 15p), or a plurality of pairs of the second focus detection pixels (14s, 15s), or a plurality of pairs ofthe second focus detection pixels (14q, 15q)).

It should be understood that the image heights at the positions corresponding to the focusing areas of Fig. 2 are already known as design information.

### 1. When the Focus Detection Pixels are Arranged in the Y Axis Direction

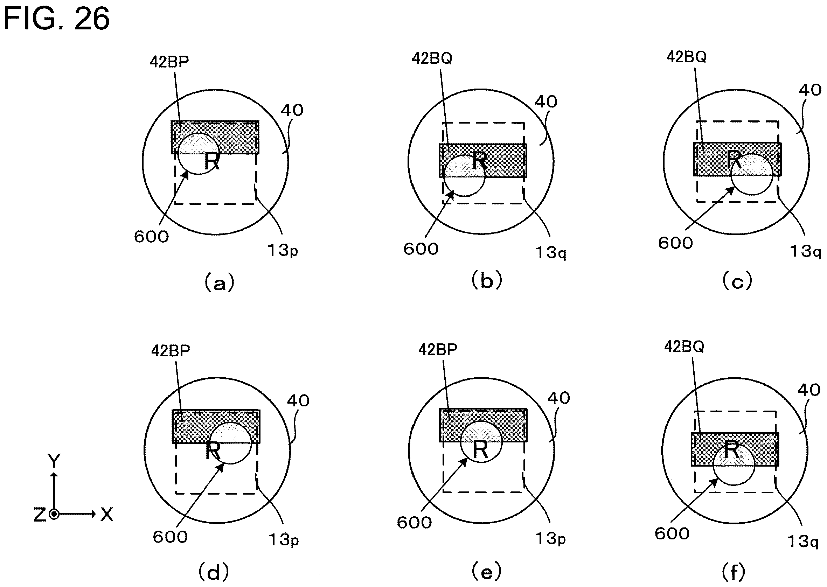

For example, with a first focus detection pixel 13 that is provided in a position corresponding to the focusing area 101-8 of Fig. 2, the image 600 of the exit pupil 60 of the imaging optical system 31 deviates so as to be separated from the central portion of the region 22a of the image sensor 22 toward some orientation (for example, toward the upward and leftward direction in the XY plane). In this case, as shown by way of example in Fig. 26(a), if a first focus detection pixel 13p is employed whose reflective unit 42BP is shifted in the +Y axis direction as compared to the first focus detection pixel 13s, then it is possible to perform pupil splitting in an appropriate manner in a state in which the image 600 is deviated from the center of the first focus detection pixel 13p. According to Fig. 26(a), the image 600 is split substantially symmetrically up and down by the reflective unit 42BP of the first focus detection pixel 13p.

For example, with a first focus detection pixel 13 that is provided in a position corresponding to the focusing area 101-9 of Fig. 2, the image 600 of the exit pupil 60 of the imaging optical system 31 deviates in the downward and leftward direction in the XY plane, for example. In this case, as shown by way of example in Fig. 26(b), if a first focus detection pixel 13q is employed whose reflective unit 42BQ is shifted in the -Y axis direction as compared to the first focus detection pixel 13s, then it is possible to perform pupil splitting in an appropriate manner in a state in which the image 600 is deviated from the center of the first focus detection pixel 13q. According to Fig. 26(b), the image 600 is split substantially symmetrically up and down by the reflective unit 42BQ of the first focus detection pixel 13q.

And, for example, with a first focus detection pixel 13 that is provided in a position corresponding to the focusing area 101-11 of Fig. 2, the image 600 of the exit pupil 60 of the imaging optical system 31 deviates in the downward and rightward direction in the XY plane, for example. In this case, as shown by way of example in Fig. 26(c), if a first focus detection pixel 13q is employed whose reflective unit 42BQ is shifted in the -Y axis direction as compared to the first focus detection pixel 13s, then it is possible to perform pupil splitting in an appropriate manner in a state in which the image 600 is deviated from the center of the first focus detection pixel 13q. According to Fig. 26(c), the image 600 is split substantially symmetrically up and down by the reflective unit 42BQ of the first focus detection pixel 13q.

Furthermore, for example, with a first focus detection pixel 13 that is provided in a position corresponding to the focusing area 101-10 of Fig. 2, the image 600 of the exit pupil 60 of the imaging optical system 31 deviates in the upward and rightward direction in the XY plane, for example. In this case, as shown by way of example in Fig. 26(d), if a first focus detection pixel 13p is employed whose reflective unit 42BP is shifted in the +Y axis direction as compared to the first focus detection pixel 13s, then it is possible to perform pupil splitting in an appropriate manner in a state in which the image 600 is deviated from the center of the first focus detection pixel 13p. According to Fig. 26(d), the image 600 is split substantially symmetrically up and down by the reflective unit 42BP of the first focus detection pixel 13p.

Yet further, for example, with a first focus detection pixel 13 that is provided in a position corresponding to the focusing area 101-1 of Fig. 2, the image 600 of the exit pupil 60 of the imaging optical system 31 deviates in the upward direction in the XY plane, for example. In this case, as shown by way of example in Fig. 26(e), if a first focus detection pixel 13p is employed whose reflective unit 42BP is shifted in the +Y axis direction as compared to the first focus detection pixel 13s, then it is possible to perform pupil splitting in an appropriate manner in a state in which the image 600 is deviated from the center of the first focus detection pixel 13p. According to Fig. 26(e), the image 600 is split substantially symmetrically up and down by the reflective unit 42BP of the first focus detection pixel 13p.

Still further, for example, with a first focus detection pixel 13 that is provided in a position corresponding to the focusing area 101-3 of Fig. 2, the image 600 of the exit pupil 60 of the imaging optical system 31 deviates in the downward direction in the XY plane, for example. In this case, as shown by way of example in Fig. 26(f), if a first focus detection pixel 13q is employed whose reflective unit 42BQ is shifted in the -Y axis direction as compared to the first focus detection pixel 13s, then it is possible to perform pupil splitting in an appropriate manner in a state in which the image 600 is deviated from the center of the first focus detection pixel 13q. According to Fig. 26(f), the image 600 is split substantially symmetrically up and down by the reflective unit 42BQ of the first focus detection pixel 13q.

In the above explanation, the first focus detection pixels 13 (13p, 13q) were explained with reference to Fig. 26 by taking the focusing areas 101-1 3, and 8 through 11 as examples, when the focus detection pixels were arranged along the Y axis direction, in other words in the vertical direction. And the same holds for the first focus detection pixels 11 (11p, 11q), although illustration and explanation thereof are curtailed.

Moreover, although illustration and explanation thereof are curtailed, the same also holds for the second focus detection pixels 14 (14p, 14q) and 15 (15p, 15q) when they are arranged along the Y axis direction, as well as for the first focus detection pixels 13 (13p, 13q) and for the first focus detection pixels 11 (11p, 11q).

### 2. When the Focus Detection Pixels are Arranged in the X Axis Direction

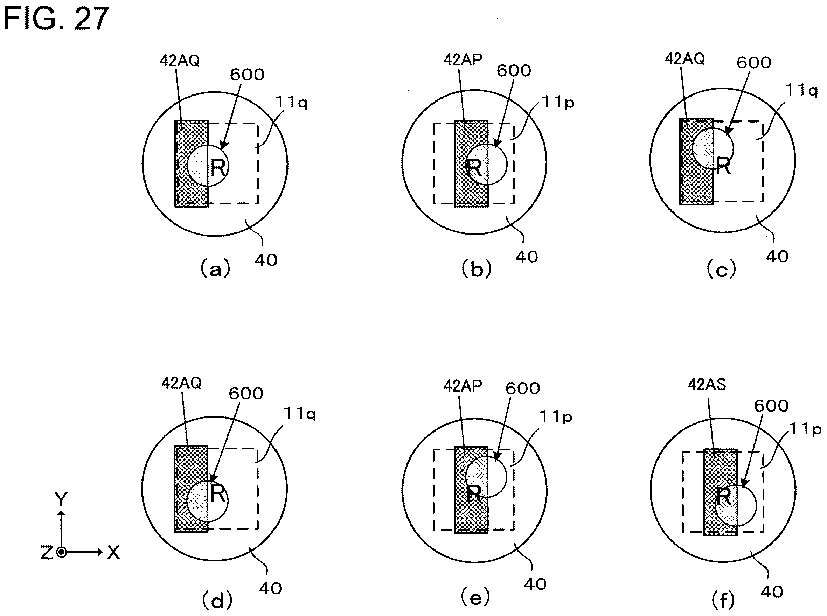

For example, with a first focus detection pixel 11 that is provided in a position corresponding to the focusing area 101-4 of Fig. 2, the image 600 of the exit pupil 60 of the imaging optical system 31 deviates so as to be separated from the central portion of the region 22a of the image sensor 22 in some orientation (for example, in the leftward direction in the XY plane). In this case, as shown by way of example in Fig. 27(a), if a first focus detection pixel 11q is employed whose reflective unit 42AQ is shifted in the -X axis direction as compared to the first focus detection pixel 11s, then it is possible to perform pupil splitting in an appropriate manner in a state in which the image 600 is deviated from the center of the first focus detection pixel 11q. According to Fig. 27(a), the image 600 is split substantially symmetrically left and right by the reflective unit 42AQ of the first focus detection pixel 11q.

And, for example, with a first focus detection pixel 11 that is provided in a position corresponding to the focusing area 101-7 of Fig. 2, the image 600 of the exit pupil 60 of the imaging optical system 31 deviates in the rightward direction in the XY plane, for example. In this case, as shown by way of example in Fig. 27(b), if a first focus detection pixel 11p is employed whose reflective unit 42AP is shifted in the +X axis direction as compared to the first focus detection pixel 11s, then it is possible to perform pupil splitting in an appropriate manner in a state in which the image 600 is deviated from the center of the first focus detection pixel 11p. According to Fig. 27(b), the image 600 is split substantially symmetrically left and right by the reflective unit 42AP of the first focus detection pixel 11p.

Moreover, for example, with a first focus detection pixel 11 that is provided in a position corresponding to the focusing area 101-8 of Fig. 2, the image 600 of the exit pupil 60 of the imaging optical system 31 deviates in the upward and leftward direction in the XY plane, for example. In this case, as shown by way of example in Fig. 27(c), if a first focus detection pixel 11q is employed whose reflective unit 42AQ is shifted in the -X axis direction as compared to the first focus detection pixel 11s, then it is possible to perform pupil splitting in an appropriate manner in a state in which the image 600 is deviated from the center of the first focus detection pixel 11q. According to Fig. 27(c), the image 600 is split substantially symmetrically left and right by the reflective unit 42AQ of the first focus detection pixel 11q.

Furthermore, for example, with a first focus detection pixel 11 that is provided in a position corresponding to the focusing area 101-9 of Fig. 2, the image 600 of the exit pupil 60 of the imaging optical system 31 deviates in the downward and leftward direction in the XY plane, for example. In this case as well, as shown by way of example in Fig. 27(d), if a first focus detection pixel 11q is employed whose reflective unit 42AQ is shifted in the -X axis direction as compared to the first focus detection pixel 11s, then it is possible to perform pupil splitting in an appropriate manner in a state in which the image 600 is deviated from the center of the first focus detection pixel 11q. According to Fig. 27(d), the image 600 is split substantially symmetrically left and right by the reflective unit 42AQ of the first focus detection pixel 11q.

Yet further, for example, with a first focus detection pixel 11 that is provided in a position corresponding to the focusing area 101-10 of Fig. 2, the image 600 of the exit pupil 60 of the imaging optical system 31 deviates in the upward and rightward direction in the XY plane, for example. In this case as well, as shown by way of example in Fig. 27(e), if a first focus detection pixel 11p is employed whose reflective unit 42AP is shifted in the +X axis direction as compared to the first focus detection pixel 11s, then it is possible to perform pupil splitting in an appropriate manner in a state in which the image 600 is deviated from the center of the first focus detection pixel 11p. According to Fig. 27(e), the image 600 is split substantially symmetrically left and right by the reflective unit 42AP of the first focus detection pixel 11p.

Even further, for example, with a first focus detection pixel 11 that is provided in a position corresponding to the focusing area 101-11 of Fig. 2, the image 600 of the exit pupil 60 of the imaging optical system 31 deviates in the downward and rightward direction in the XY plane, for example. In this case as well, as shown by way of example in Fig. 27(f), if a first focus detection pixel 11p is employed whose reflective unit 42AP is shifted in the +X axis direction as compared to the first focus detection pixel 11s, then it is possible to perform pupil splitting in an appropriate manner in a state in which the image 600 is deviated from the center of the first focus detection pixel 11p. According to Fig. 27(f), the image 600 is split substantially symmetrically left and right by the reflective unit 42AP of the first focus detection pixel 11p.

In the above explanation, the first focus detection pixels 11 (11p, 11q) were explained with reference to Fig. 27 by taking the focusing areas 101-4, 7, and 8 through 11 as examples, when the focus detection pixels were arranged along the X axis direction, in other words in the horizontal direction. And the same holds for the first focus detection pixels 13 (13p, 13q), although illustration and explanation thereof are curtailed.

Moreover, although illustration and explanation thereof are curtailed, the same also holds for the second focus detection pixels 14 (14p, 14q) and 15 (15p, 15q) when they are arranged along the X axis direction, as well as for the first focus detection pixels 11 (11p, 11q) and for the first focus detection pixels 13 (13p, 13q).

According to the first variant embodiment of the second embodiment as explained above, even if light is incident slantingly upon the micro lenses 40, it still becomes possible to choose focus detection pixels the positions of whose pupil splitting structures (in the case of the first focus detection pixels 11, 13, the reflective units 42A, 42B, and in the case of the second focus detection pixels 14, 15, the light interception units 44B, 44A) are displaced in the X axis direction and in the Y axis direction with respect to the centers of the pixels, so that pupil splitting can be performed in an appropriate manner in this state.

In other words, it is possible to obtain an image sensor 22 that is capable of employing focus detection pixels that are appropriate for focus detection, among the groups of focus detection pixels for which the presence or absence of a displacement amount g and the direction of that displacement differ, and that is therefore suitable for focus detection.

### The Second Variant Embodiment of Embodiment 2

As described above, with the focus detection pixels that are provided in positions corresponding to the focusing area 101-1 and to the focusing areas 101-3 through 101-11, the greater is the image height, the more slantingly is light incident upon their micro lenses 40. Therefore, it would also be acceptable to increase or decrease the displacement amount g by which their pupil splitting structures (in the case of the first focus detection pixels 11, 13, the reflective units 42A, 42B, and in the case of the second focus detection pixels 14, 15, the light interception units 44B, 44A) are displaced in the X axis direction and in the Y axis direction with respect to the centers of their pixels, so that the amount g becomes greater the higher is the image height, and becomes smaller the lower is the image height, according to requirements.

### 1. When Located in the Central Portion of the Region 22a of the Image sensor 22

At the central portion of the region 22a, the image height is low. Due to this, scaling for a displacement amount g is not required for a position corresponding to the focusing area 101-2 that is positioned at the central portion of the region 22a of the image sensor 22. Accordingly, for the first focus detection pixels 11, 13 that are provided in positions corresponding to the focusing area 101-2, in a similar manner to the case for the second embodiment, taking, for example, the positions of the first focus detection pixels 11s, 13s of Fig. 21 as reference positions, a plurality of first focus detection pixels are provided with the positions of their respective pupil splitting structures (i.e. their reflective units 42A, 42B) shifted in the -X axis direction and in the +X axis direction with respect to those reference positions.

Moreover, for the second focus detection pixels 14, 15 that are provided in positions corresponding to the focusing area 101-2 as well, in a similar manner to the case for the second embodiment, taking, for example, the positions of the second focus detection pixels 14s, 15s of Fig. 21 as reference positions, a plurality of second focus detection pixels are provided with the positions of their respective pupil splitting structures (i.e. their light interception units 44B, 44A) shifted in the -X axis direction and in the +X axis direction with respect to those reference positions.

### 2. When Located at a Peripheral Portion Positioned Remote from the Central Portion of the Region 22a of the Image sensor 22 (the Image Height is Greater than at the Central Portion)

### (2-1) When the Focus Detection pixels are Arranged along the X Axis Direction

At the peripheral portions of the region 22a, the more remote the position is from the central portion, the greater is the image height. When focus detection pixels are arranged along the X axis direction, the greater the X axis component of the image height is, the more easily can a negative influence be experienced due to the light being incident slantingly upon the micro lens 40. However, in the positions corresponding to the focusing areas 101-1 and 101-3 of Fig. 2 the X axis component of the image height does not change, as compared to the central portion of the region 22a. Due to this, for the positions corresponding to the focusing areas 101-1 and 101-3, scaling for a displacement amount g in the X axis direction is not required.

Furthermore, in a case in which the focus detection pixels are arranged along the X axis direction, a negative influence cannot easily be exerted by the light that is slantingly incident upon the micro lens 40 even if the Y axis component of the image height becomes high, so that it is possible to perform pupil splitting in an appropriate manner, as shown by way of example in Figs. 24(b) and 24(h). Due to this, for positions corresponding to the focusing areas 101-1 and 101-3, scaling for a displacement amount g in the Y axis direction is not required.

Accordingly, in a similar manner to the case in the second embodiment, for the first focus detection pixels 11, 13 that are provided at positions corresponding to the focusing areas 101-1 and 101-3, for example, the positions of the first focus detection pixels 11s, 13s of Fig. 21 are taken as being reference positions, and a plurality of first focus detection pixels are provided with the positions of their respective pupil splitting structures (i.e. the reflective units 42A, 42B) being shifted in the -X axis direction and in the +X axis direction with respect to those reference positions.

And, in a similar manner, for the second focus detection pixels 14, 15 that are provided at positions corresponding to the focusing areas 101-1 and 101-3, for example, the positions of the second focus detection pixels 14s, 15s of Fig. 21 are taken as being reference positions, and a plurality of second focus detection pixels are provided with the positions of their respective pupil splitting structures (i.e. the light interception units 44B, 44A) being shifted in the -X axis direction and in the +X axis direction with respect to those reference positions.

### (2-2) When the Focus Detection pixels are Arranged along the Y Axis Direction

At the peripheral portions of the region 22a, the more remote the position is from the central portion, the greater is the image height. When focus detection pixels are arranged along the Y axis direction, the greater is the Y axis component of the image height, the more easily can a negative influence be experienced due to the light being incident slantingly upon the micro lens 40. Thus since, in the positions corresponding to the focusing areas 101-8 and 101-10 of Fig. 2, the Y axis component of the image height is great as compared to the central portion of the region 22a, accordingly scaling is performed with a displacement amount g in the Y axis direction for the positions corresponding to the focusing areas 101-8 and 101-10.

On the other hand, in a case in which the focus detection pixels are arranged along the Y axis direction, a negative influence cannot easily be exerted upon the light that is slantingly incident upon the micro lens 40 even if the X axis component of the image height becomes high, so that it is possible to perform pupil splitting in an appropriate manner, as shown by way of example in Figs. 25(a) and 25(c). Due to this, for positions corresponding to the focusing areas 101-8 and 101-10, scaling for a displacement amount g in the X axis direction is not required.

Accordingly, for the first focus detection pixels 11, 13 that are provided at positions corresponding to the focusing areas 101-8 and 101-10, the positions of the pupil splitting structures (i.e. of the reflective units 42A, 42B) having any arbitrary displacement amount are taken as being reference positions, and a plurality of first focus detection pixels are provided with the positions of their respective pupil splitting structures (i.e. the reflective units 42A, 42B) being shifted in the -Y axis direction and in the +Y axis direction with respect to those reference positions.

And, in a similar manner, for the second focus detection pixels 14, 15 that are provided at positions corresponding to the focusing areas 101-8 and 101-10, the positions of the pupil splitting structures (i.e. of the light interception units 44B, 44A) having any arbitrary displacement amount are taken as being reference positions, and a plurality of second focus detection pixels are provided with the positions of their respective pupil splitting structures (i.e. the light interception units 44B, 44A) being shifted in the -Y axis direction and in the +Y axis direction with respect to those reference positions.

Since the Y axis component of the image height at the positions corresponding to the focusing areas 101-9 and 101-11 in Fig. 2 is high as compared to the central portion of the region 22a, accordingly scaling is performed with a displacement amount g in the Y axis direction for the positions corresponding to the focusing areas 101-9 and 101-11.

As described above, in a case in which the focus detection pixels are arranged along the Y axis direction, it is difficult for light that is incident slantingly upon the micro lenses 40 to exert any negative influence even if the X axis component of the image height becomes high, and it is possible to perform pupil splitting in an appropriate manner, as shown by way of example in Figs. 25(g) and 25(i). Due to this, there is no requirement to perform scaling with any displacement amount g in the X axis direction for the positions corresponding to the focusing areas 101-9 and 101-11.

Accordingly, for the first focus detection pixels 11, 13 that are provided at positions corresponding to the focusing areas 101-9 and 101-11, the positions of the pupil splitting structures (i.e. of the reflective units 42A, 42B) having any arbitrary displacement amount are taken as being reference positions, and a plurality of first focus detection pixels are provided with the positions of their respective pupil splitting structures (i.e. the reflective units 42A, 42B) being shifted in the -Y axis direction and in the +Y axis direction with respect to those reference positions.

And, in a similar manner, for the second focus detection pixels 14, 15 that are provided at positions corresponding to the focusing areas 101-9 and 101-11, the positions of the pupil splitting structures (i.e. of the light interception units 44B, 44A) having any arbitrary displacement amount are taken as being reference positions, and a plurality of second focus detection pixels are provided with the positions of their respective pupil splitting structures (i.e. the light interception units 44B, 44A) being shifted in the -Y axis direction and in the +Y axis direction with respect to those reference positions.

With the positions corresponding to the focusing areas 101-4 through 101-7 of Fig. 2, the Y axis component of the image height does not change as compared to the central portion of the region 22a. Due to this, there is no requirement to perform scaling with any displacement amount g in the Y axis direction for the positions corresponding to the focusing areas 101-4 through 101-7.

Furthermore, in a case in which the focus detection pixels are arranged along the Y axis direction, a negative influence cannot easily be exerted by the light that is slantingly incident upon the micro lens 40 even if the X axis component of the image height becomes high, so that it is possible to perform pupil splitting in an appropriate manner, as shown by way of example in Figs. 25(d) and 24(f). Due to this, for positions corresponding to the focusing areas 101-4 through 101-7, scaling for a displacement amount g in the X axis direction is not required.

Accordingly, in a similar manner to the case in the second embodiment, for the first focus detection pixels 11, 13 that are provided at positions corresponding to the focusing areas 101-4 through 101-7, for example, the positions of the first focus detection pixels 11s, 13s of Fig. 23 are taken as being reference positions, and a plurality of first focus detection pixels are provided with the positions of their respective pupil splitting structures (i.e. the reflective units 42A, 42B) being shifted in the -Y axis direction and in the +Y axis direction with respect to those reference positions.

And, in a similar manner, for the second focus detection pixels 14, 15 that are provided at positions corresponding to the focusing areas 101-4 through 101-7, for example, the positions of the second focus detection pixels 14s, 15s of Fig. 23 are taken as being reference positions, and a plurality of second focus detection pixels are provided with the positions of their respective pupil splitting structures (i.e. the light interception units 44B, 44A) being shifted in the -Y axis direction and in the +Y axis direction with respect to those reference positions.

According to this second variant embodiment of Embodiment 2, the following operations and effects may be obtained.
(1) In this image sensor 22, the first focus detection pixels 11s, 13s, the first focus detection pixels 11p, 13p, and the first focus detection pixels 11q, 13q are disposed in a region (i.e. at a position corresponding to a focusing area) where the image height is greater than at the center of an image capture region upon which the ray bundle that has passed through the imaging optical system 31 is incident, and moreover, if the first and second pupil regions 61, 62 of the exit pupil 60 of the imaging optical system 31 are in line along the X axis direction, then, depending upon the magnitude of the component of the image height in the X axis direction, the predetermined positions described above of the reflective units 42AS, 42BS of the first focus detection pixels 11s, 13s are made to be different. Due to this, it is possible to obtain an image sensor 22 with which, even if light is incident slantingly upon the micro lenses 40, it is possible to select first focus detection pixels 11, 13 the positions of whose pupil splitting structures (for example, the reflective units 42A, 42B) are displaced in the X axis direction with respect to the centers of the pixels (for example, the photoelectric conversion units 41), so that pupil splitting can be performed in an appropriate manner in this state, and accordingly this image sensor is suitable for focus detection.
(2) The first focus detection pixels 11s, 13s, the first focus detection pixels 11p, 13p, and the first focus detection pixels 11q, 13q are disposed in a region (i.e. at a position corresponding to a focusing area) where the image height is greater than at the center of an image capture region upon which the ray bundle that has passed through the imaging optical system 31 is incident, and moreover, if the first and second pupil regions 61, 62 of the exit pupil 60 of the imaging optical system 31 are in line along the Y axis direction, then, depending upon the magnitude of the component of the image height in the Y axis direction, the predetermined positions described above of the reflective units 42AS, 42BS of the first focus detection pixels 11s, 13s are made to be different. Due to this, for the Y axis direction as well, in a similar manner to the case of the X axis direction, it is possible to obtain an image sensor 22 with which it is possible to select first focus detection pixels 11, 13 the positions of whose pupil splitting structures (i.e. the reflective units 42A, 42B) are displaced in the Y axis direction with respect to the centers of the pixels, and accordingly this image sensor is suitable for focus detection.
(3) The focus detection device of the camera 1 comprises: the image sensor 22; the image generation unit 21b that, on the basis of information about the positional deviation of the micro lenses 40 and the photoelectric conversion units 41, selects one or another group of focus detection pixels from among the plurality of groups of the first focus detection pixels 11s, 13s, the first focus detection pixels 11p, 13p, and the first focus detection pixels 11q, 13q; and the image generation unit 21 that performs focus detection for the imaging optical system 31 on the basis of the focus detection signals of the focus detection pixels that have been selected by the image generation unit 21b. Due to this, it is possible to perform focus detection in an appropriate manner on the basis of the focus detection signals from the first focus detection pixels 11, 13 by which pupil splitting has been suitably performed.
(4) Since it is arranged for the image generation unit 21b of the focus detection device of the camera 1 to perform the selection described above on the basis of the image height, accordingly, even if the angle at which the light is slantingly incident upon the micro lenses 40 varies according to the image height, it still becomes possible to select first focus detection pixels 11, 13 the positions of whose pupil splitting structures (i.e. the reflective units 42A, 42B) are deviated in the X axis direction and/or in the Y axis direction with respect to the centers of the pixels, so that pupil splitting can be performed in an appropriate manner. Accordingly, it is possible to perform focus detection in an appropriate manner.

### The Third Variant Embodiment of Embodiment 2

The provision of a plurality of focus detection pixels in which the positions of the pupil splitting structures (in the case of the first focus detection pixels 11, 13, the reflective units 42A, 42B, and in the case of the second focus detection pixels 14, 15, the light interception units 44B, 44A) are displaced in the X axis direction and/or the Y axis direction is also appropriate, as in the second embodiment, if an interchangeable lens 3 of a different type is employed.

For example, if a wide angle lens is employed as the interchangeable lens 3, then, as compared to the case of a standard lens, the position of the exit pupil 60 as seen from the image sensor 22 is closer. As described in connection with the first variant embodiment of the second embodiment, in the peripheral portion of the region 22a of the image sensor 22 that is more toward the exterior than its central portion (the image height is larger than in the central portion), the light that has passed through the exit pupil 60 of the imaging optical system 31 is incident slantingly. Thus, as compared with the case of a standard lens, this becomes more prominent with a wide angle lens the position of whose exit pupil is closer.

For the reason described above, even if, at the peripheral portion of the region 22a of the image sensor 22, there is no deviation between the centers of the micro lenses 40 and the centers of the photoelectric conversion units 41 which are behind them, since the position of the image 600 of the exit pupil 60 with respect to the pupil splitting structure (in the case of the first focus detection pixels 11, 13, the reflective units 42A, 42B, and in the case of the second focus detection pixels 14, 15, the light interception units 44B, 44A) becomes different according to whether the position of the exit pupil 60 of the imaging optical system 31 is close or is distant, accordingly, in some cases, it becomes impossible to perform pupil splitting in an appropriate manner.

Thus, in the third variant embodiment of the second embodiment, even when light is incident slantingly upon the micro lenses 40, so that pupil splitting can be performed in an appropriate manner in this state, focus detection pixels are selected the positions of whose pupil splitting structures (in the case of the first focus detection pixels 11, 13, the reflective units 42A, 42B, and in the case of the second focus detection pixels 14, 15, the light interception units 44B, 44A) with respect to the centers of their pixels are displaced in the X axis direction and/or in the Y axis direction.

In concrete terms, on the basis of information related to the position of the exit pupil 60 of the imaging optical system, the focus detection unit 21a of the body control unit 21 selects first focus detection pixels 11, 13 from among the groups of first focus detection pixels 11, 13 as for example shown in Figs. 21 and 23 (for example, the plurality of pairs of the first focus detection pixels (11p, 13p), the plurality of pairs of the first focus detection pixels (11s, 13s), and the plurality of pairs of the first focus detection pixels (11q, 13q)). Moreover, on the basis of information related to the position of the exit pupil 60 of the imaging optical system, the focus detection unit selects second focus detection pixels 14, 15 from among the groups of second focus detection pixels 14, 15 as for example shown in Figs. 21 and 23 (for example, the plurality of pairs of the second focus detection pixels (14p, 15p), the plurality of pairs of the second focus detection pixels (14s, 15s), and the plurality of pairs of the second focus detection pixels (14q, 15q)).

The information related to the position of the exit pupil 60 is recorded in the lens memory 33 of the interchangeable lens 3, as described above. The focus detection unit 21a of the body control unit 21 selects the first focus detection pixels 11, 13 and the second focus detection pixels 14, 15 described above by employing this information related to the position of the exit pupil 60 transmitted from the interchangeable lens 3.

According to this third variant embodiment of Embodiment 2, the following operations and effects may be obtained. Specifically, it is arranged for the image generation unit 21b of the focus detection device of the camera 1 to select first focus detection pixels 11, 13 whose photoelectric conversion units 41 and reflective units 42A, 42B are in predetermined positional relationships, on the basis of the position of the exit pupil 60 of the imaging optical system with respect to the image sensor 22, from among the plurality of groups of the first focus detection pixels 11, 13 (for example, the plurality of pairs of the first focus detection pixels (11p, 13p), the plurality of pairs of the first focus detection pixels (11s, 13s), and the plurality of pairs of the first focus detection pixels (11q, 13q)). Due to this, even if the angles at which light is incident slantingly upon the micro lenses 40 vary according to the position of the exit pupil 60, it still becomes possible to select first focus detection pixels 11, 13 the positions of whose pupil splitting structures (i.e. the reflective units 42A, 42B) with respect to the centers of their pixels are displaced in the X axis direction and/or the Y axis direction, so that pupil splitting can be performed properly in this situation. Accordingly, it is possible to perform focus detection in an appropriate manner.

### The Fourth Variant Embodiment of Embodiment 2

It would also be acceptable to determine the widths in the X axis direction and in the Y axis direction (in other words, the areas in the XY plane) of the respective reflective units 42AP and 42BP, the reflective units 42AS and 42BS, and the reflective units 42AQ and 42BQ of the first focus detection pixels 11p, 11s, 11q (13p, 13s, 13q) in the following manner.

### The case of displacement in the X axis direction

The case of the reflective unit 42BQ of the first focus detection pixel 13q will now be explained as an example. In this fourth variant embodiment of the second embodiment, the feature of difference from Fig. 21 is that the width in the X axis direction of the reflective unit 42BQ of the first focus detection pixel 13q is made to be wider than the width of the reflective unit 42AQ of the first focus detection pixel 11q which is paired therewith. And the position of the reflective unit 42BQ is a position that covers the lower surface of the photoelectric conversion unit 41 more toward the right side (i.e. toward the +X axis direction) than a position that is displaced by an amount g in the -X axis direction from the line CS.

The reason why the width of the reflective unit 42BQ (in other words, its area in the XY plane) is made to be wider than the width of the reflective unit 42AQ of the first focus detection pixel 11q which is paired therewith, is so as to ensure that light that has passed through the photoelectric conversion unit 41 more toward the right side (i.e. toward the +X axis direction) than a position displaced by an amount g in the -X axis direction from the line CS should be again incident upon the photoelectric conversion unit 41 for a second time.

In a similar manner, the case of the reflective unit 42AP of the first focus detection pixel 11p will now be explained. In this fourth variant embodiment of the second embodiment, the feature of difference from Fig. 21 is that the width in the X axis direction of the reflective unit 42AP of the first focus detection pixel 11p is made to be wider than the width of the reflective unit 42BP of the first focus detection pixel 13p which is paired therewith. And the position of the reflective unit 42AP is a position that covers the lower surface of the photoelectric conversion unit 41 more toward the left side (i.e. toward the - X axis direction) than a position that is displaced by an amount g in the +X axis direction from the line CS.

The reason why the width of the reflective unit 42AP (in other words, its area in the XY plane) is made to be wider than the width of the reflective unit 42BP of the first focus detection pixel 13p which is paired therewith, is so as to ensure that light that has passed through the photoelectric conversion unit 41 more toward the left side (i.e. toward the -X axis direction) than a position displaced by an amount g in the +X axis direction from the line CS should be again incident upon the photoelectric conversion unit 41 for a second time.

### The case of displacement in the Y axis direction

The case of the reflective unit 42BQ of the first focus detection pixel 13q will now be explained as an example. In this fourth variant embodiment of the second embodiment, the feature of difference from Fig. 23 is that the width in the Y axis direction of the reflective unit 42BQ of the first focus detection pixel 13q is made to be wider than the width of the reflective unit 42AQ of the first focus detection pixel 11q which is paired therewith. And the position of the reflective unit 42BQ is a position that covers the lower surface of the photoelectric conversion unit 41 more toward the upper side (i.e. toward the +Y axis direction) than a position that is displaced by an amount g in the -Y axis direction from the line CS.

The reason why the width of the reflective unit 42BQ (in other words, its area in the XY plane) is made to be wider than the width of the reflective unit 42AQ of the first focus detection pixel 11q which is paired therewith, is so as to ensure that light that has passed through the photoelectric conversion unit 41 more toward the upper side (i.e. toward the +Y axis direction) than a position displaced by an amount g in the -Y axis direction from the line CS should be again incident upon the photoelectric conversion unit 41 for a second time.

In a similar manner, the case of the reflective unit 42AP of the first focus detection pixel 11p will now be explained. In this fourth variant embodiment of the second embodiment, the feature of difference from Fig. 23 is that the width in the Y axis direction of the reflective unit 42AP of the first focus detection pixel 11p is made to be wider than the width of the reflective unit 42BP of the first focus detection pixel 13p which is paired therewith. And the position of the reflective unit 42AP is a position that covers the lower surface of the photoelectric conversion unit 41 more toward the lower side (i.e. toward the -Y axis direction) than a position that is displaced by an amount g in the +Y axis direction from the line CS.

The reason why the width of the reflective unit 42AP (in other words, its area in the XY plane) is made to be wider than the width of the reflective unit 42BP of the first focus detection pixel 13p which is paired therewith, is so as to ensure that light that has passed through the photoelectric conversion unit 41 more toward the lower side (i.e. toward the -Y axis direction) than a position displaced by an amount g in the +Y axis direction from the line CS should be again incident upon the photoelectric conversion unit 41 for a second time.

In the above explanation, an example of a configuration for the image sensor 22 in which first focus detection pixels 11 (13) having a reflective type pupil splitting structure are replaced for some of the R imaging pixels 12 and in which second focus detection pixels 14 (15) having a light interception type pupil splitting structure are replaced for some of the B imaging pixels 12, and an example of a configuration in which first focus detection pixels 11 (13) having a reflective type pupil splitting structure are replaced for some of the G imaging pixels 12 and in which second focus detection pixels 14 (15) having a light interception type pupil splitting structure are replaced for some of the B imaging pixels 12, and so on have been explained. It would also be acceptable to change, as appropriate, the arrangement of which of the imaging pixels 12 of which color, i.e. R, G, or B, are to be replaced by the first focus detection pixels 11 (13) and the second focus detection pixels 14 (15).

For example, it would be acceptable to arrange to provide a configuration in which first focus detection pixels 11 (13) having a reflective type pupil splitting structure are replaced for some of the R imaging pixels 12 and in which second focus detection pixels 14 (15) having a light interception type pupil splitting structure are replaced both for some of the B imaging pixels 12 and also for some of the G imaging pixels 12. Moreover, it would be acceptable to arrange to provide a configuration in which first focus detection pixels 11 (13) having a reflective type pupil splitting structure are replaced both for some of the R imaging pixels 12 and also for some of the G imaging pixels 12, and in which second focus detection pixels 14 (15) having a light interception type pupil splitting structure are replaced for some of the B imaging pixels 12; and configurations other than those described as examples above would also be acceptable.

Furthermore, in the above explanation, a case was described by way of example in which, along with imaging pixels 12, first focus detection pixels 11 (13) having a reflective type pupil splitting structure and second focus detection pixels 14 having a interception type pupil splitting structure were provided to the image sensor 22. Instead of this, it would also be acceptable to provide a structure for the image sensor 22 in which, without any second focus detection pixels 14 (15) being included in the image sensor 22, there were included imaging pixels 12 and first focus detection pixels 11 (13) having a reflective type pupil splitting structure. In this case, it would also be acceptable to change, as appropriate, the configuration of which of the imaging pixels 12 of which color, i.e. R, G, or B, are to be replaced by the first focus detection pixels 11 (13).

For example, it would also be possible to provide a structure in which first focus detection pixels 11 (13) having a reflective type pupil splitting structure are replaced for some of the R imaging pixels 12 and for some of the G imaging pixels 12, while none of the B pixels are employed for phase difference detection. In this case, all of the B pixels would be imaging pixels 12. Furthermore, it would also be possible to provide a structure in which first focus detection pixels 11 (13) having a reflective type pupil splitting structure are replaced for some of the R imaging pixels 12, while none of the B pixels and none of the G pixels are employed for phase difference detection. In this case, all of the B pixels and all of the G pixels would be imaging pixels 12. Yet further, it would also be possible to provide a structure in which first focus detection pixels 11 (13) having a reflective type pupil splitting structure are replaced for some of the G imaging pixels 12, while none of the B pixels and none of the R pixels are employed for phase difference detection. In this case, all of the B pixels and all of the R pixels would be imaging pixels 12. It should be understood that configurations other than those described as examples above would also be acceptable.

Image sensors and focus detection devices of the following types are included in the second embodiment and the variant embodiments of the second embodiment described above.
(1) An image sensor, including a plurality of pixels 11p, 11s, 11q (13p, 13s, 13q) each including: a photoelectric conversion unit 41 that photoelectrically converts incident light and generates electric charge; a reflective unit 42A (42B) that reflects light that has passed through the above described photoelectric conversion unit 41 back to the above described photoelectric conversion unit 41; and an output unit 106 that outputs electric charge generated by the above described photoelectric conversion unit 41; wherein the positions of the reflective units 42AP, 42AS, 42AQ (42BP, 42BS, 42BQ) respectively possessed by the above described plurality of pixels 11p, 11s, 11q (13p, 13s, 13q) vary.
(2) The image sensor as in (1), wherein the positions with respect to the above described photoelectric conversion units 41 of the reflective units 42AP, 42AS, 42AQ (42BP, 42BS, 42BQ) respectively possessed by the above described plurality of pixels 11p, 11s, 11q (13p, 13s, 13q) vary.
(3) The image sensor as in (2), wherein the positions with respect to the above described photoelectric conversion units 41 of the reflective units 42AP, 42AS, 42AQ (42BP, 42BS, 42BQ) respectively possessed by the above described plurality of pixels 11p, 11s, 11q (13p, 13s, 13q) in a plane intersecting the direction of light incidence (for example, the XY plane) vary.
(4)The image sensor as in (2) or (3), wherein the positions with respect to the above described photoelectric conversion units 41 of the reflective units 42AP, 42AS, 42AQ (42BP, 42BS, 42BQ) respectively possessed by the above described plurality of pixels 11p, 11s, 11q (13p, 13s, 13q) vary according to their positions upon the above described image sensor (for example, their distances from the center of the image formation surface (i.e. according to the image heights).
(5) The image sensor as in (1), wherein: each of the above described plurality of pixels 11p, 11s, 11q (13p, 13s, 13q) includes a micro lens 40; and the positions with respect to the optical axes (the lines CL) of the above described micro lenses 40 of the reflective units 42AP, 42AS, 42AQ (42BP, 42BS, 42BQ) respectively possessed by the above described plurality of pixels 11p, 11s, 11q (13p, 13s, 13q) vary.
(6) The image sensor as in (5), wherein the reflective unit respectively possessed by each of the above described plurality of pixels is provided in a position so that it reflects light incident slantingly with respect to the optical axis of the above described micro lens toward the above described photoelectric conversion unit.
(7) The image sensor as in (5) or (6), wherein the position of the reflective unit 42AP, 42AS, 42AQ (42BP, 42BS, 42BQ) respectively possessed by each of the above described plurality of pixels 11p, 11s, 11q (13p, 13s, 13q) with respect to the optical axis (the line CL) of the above described micro lens 40 varies upon the plane (for example, the XY plane) intersecting the direction of light incidence.
(8) The image sensor as in any one of (5) through (7), wherein the position of the reflective unit 42AP, 42AS, 42AQ (42BP, 42BS, 42BQ) respectively possessed by each of the above described plurality of pixels 11p, 11s, 11q (13p, 13s, 13q) with respect to the optical axis (the line CL) of the above described micro lens 40 varies according to its position upon the above described image sensor (for example, according to its distance from the center of the image formation surface (i.e. the image height)).
(9) The image sensor as in (1), wherein each of the above described plurality of pixels 11p, 11s, 11q (13p, 13s, 13q) includes a micro lens 40, and the distances of the above described reflective units 42AP, 42AS, 42AQ (42BP, 42BS, 42BQ) respectively possessed by each of the above described plurality of pixels 11p, 11s, 11q (13p, 13s, 13q) from the optical axes (the lines CL) of the above described micro lenses 40 are mutually different.
(10) The image sensor as in (9), wherein the distances of the above described reflective units 42AP, 42AS, 42AQ (42BP, 42BS, 42BQ) respectively possessed by each of the above described plurality of pixels 11p, 11s, 11q (13p, 13s, 13q) from the optical axes (the lines CL) of the above described micro lenses 40 upon the plane (for example, the XY plane) intersecting the direction of light incidence vary.
(11) The image sensor as in (9) or (10), wherein the distances of the above described reflective units 42AP, 42AS, 42AQ (42BP, 42BS, 42BQ) respectively possessed by each of the above described plurality of pixels 11p, 11s, 11q (13p, 13s, 13q) from the optical axes (the lines CL) of the above described micro lenses 40 vary according to their positions upon the above described image sensor (for example, according to their distances from the center of the image formation surfaces (i.e. the image height)).
(12) The image sensor as in any one of (1) through (11), wherein the areas of the above described reflective units 42AP, 42AS, 42AQ (42BP, 42BS, 42BQ) respectively possessed by each of the above described plurality of pixels 11p, 11s, 11q (13p, 13s, 13q) are the same.
(13) The image sensor as in any one of (1) through (12), wherein the areas of the above described reflective units 42AP, 42AS, 42AQ (42BP, 42BS, 42BQ) respectively possessed by each of the above described plurality of pixels 11p, 11s, 11q (13p, 13s, 13q) are different.
(14) The image sensor as in any one of (1) through (13), wherein the above described output unit 106 possessed by each of the above described plurality of pixels 11p, 11s, 11q (13p, 13s, 13q) is provided remote from the optical path along with light that has passed through the above described photoelectric conversion unit 41 is incident upon the above described reflective unit 42AP, 42AS, 42AQ (42BP, 42BS, 42BQ). Due to this, the balance of the amounts of electric charge generated by the above described plurality of pixels 11p, 11s, 11q (13p, 13s, 13q) is preserved, so that it is possible to perform pupil-split type phase difference detection with good accuracy.
(15) The image sensor as in any one of (1) through (14), further including the FD region 47 that accumulates electric charge generated by the above described photoelectric conversion unit 41, and wherein the above described output unit 106 includes a transfer transistor that transfers electric charge to the above described FD region 47. Since, due to this, the transfer transistor is provided remote from the optical path of the incident light, accordingly the balance of the amounts of electric charge generated by the above described plurality of pixels 11p, 11s, 11q (13p, 13s, 13q) is preserved. And, due to this, it is possible to perform pupil-split type phase difference detection with good accuracy.
(16) The image sensor as in (15), wherein the above described output unit 106 includes an electrode 48 of the above described transfer transistor. Since, due to this, the gate electrode of the transfer transistor is disposed remote from the optical path of incident light, accordingly the balance of the amounts of electric charge generated by the above described plurality of pixels 11p, 11s, 11q (13p, 13s, 13q) is preserved. And, due to this, it is possible to perform pupil-split type phase difference detection with good accuracy.
(17) The image sensor as in any one of (1) through (14), wherein the above described output unit 106 functions as a discharge unit that discharges electric charge generated by the above described photoelectric conversion unit 41. In other words, the above described output unit 106 could also include a reset transistor that discharges the electric charge that has been generated. Since, due to this, the reset transistor is disposed remote from the optical path of incident light, accordingly the balance of the amounts of electric charge generated by the above described plurality of pixels 11p, 11s, 11q (13p, 13s, 13q) is preserved. And, due to this, it is possible to perform pupil-split type phase difference detection with good accuracy.
(18) The image sensor as in any one of (1) through (14), further including an FD region 47 that accumulates electric charge generated by the above described photoelectric conversion unit 41, and wherein the above described output unit 106 outputs a signal based upon the voltage of the above described FD region 47. In other words, the above described output unit 106 could also include an amplification transistor or a selection transistor. Since, due to this, the amplification transistor or the selection transistor is disposed remote from the optical path of incident light, accordingly the balance of the amounts of electric charge generated by the above described plurality of pixels 11p, 11s, 11q (13p, 13s, 13q) is preserved. And, due to this, it is possible to perform pupil-split type phase difference detection with good accuracy.
(19) An image sensor including a plurality of pixels each including: a photoelectric conversion unit that photoelectrically converts incident light and generates electric charge; a reflective unit that reflects light that has passed through the above described photoelectric conversion unit back to the above described photoelectric conversion unit; and an output unit that is provided remote from the optical path along which light that has passed through the above described photoelectric conversion unit is incident upon the above described reflective unit, and that outputs electric charge generated by the above described photoelectric conversion unit.
(20) A focus adjustment device, including: an image sensor as in any of (1) through (19); and a lens control unit 32 that adjusts the focused position of the image formation optical system 31 from a signal based upon electric charge outputted from the above described output unit 106.
(21) An image sensor including: a first pixel 11 including a first photoelectric conversion unit 41 that photoelectrically converts light that has passed through a first micro lens 40 and generates electric charge, a first reflective unit 42A, provided at a first distance from the optical axis (the line CL) of the above described first micro lens 40 in a direction that intersects that optical axis, and that reflects light that has passed through the above described first photoelectric conversion unit 41 back to the above described first photoelectric conversion unit 41, and a first output unit 106 that outputs electric charge generated by the above described first photoelectric conversion unit 41; and a second pixel 13 including a second photoelectric conversion unit 41 that photoelectrically converts light that has passed through a second micro lens 40 and generates electric charge, a second reflective unit 42B provided at a second distance, that is different from the above described first distance, from the optical axis of the above described second micro lens 40 in a direction intersecting that optical axis, and that reflects light that has passed through the above described second photoelectric conversion unit 41 back to the above described second photoelectric conversion unit 41, and a second output unit 106 that outputs electric charge generated by second photoelectric conversion unit 41.
(22) The image sensor as in (21), wherein the above described first reflective unit 42A is provided at the above described first distance from the optical axis (the line CL) of the above described first micro lens 40 in a plane (for example, the XY plane) that intersects the direction of light incidence, and the above described second reflective unit 42B is provided at the above described second distance from the optical axis (the line CL) of the above described second micro lens 40 in a plane (for example, the XY plane) that intersects the direction of light incidence.
(23) The image sensor as in (21) or (22), wherein the center of the above described first reflective unit 42A is provided at the above described first distance from the optical axis (the line CL) of the above described first micro lens 40; and the center of the above described second reflective unit 42B is provided at the above described second distance from the optical axis (the line CL) of the above described second micro lens 40.
(24) The image sensor as in any one of (21) through (23), wherein the above described first reflective unit is provided in a position in which it reflects light incident at a first angle with respect to the optical axis of the above described first micro lens toward the above described first photoelectric conversion unit, and the above described second reflective unit is provided in a position in which it reflects light incident at a second angle, different from the above described first angle, with respect to the optical axis of the above described second micro lens toward the above described second photoelectric conversion unit.
(25) An image sensor, including: a first pixel 11 including a first photoelectric conversion unit 41 that photoelectrically converts incident light and generates electric charge, a first reflective unit 42A, provided at a first distance from the center of the above described first photoelectric conversion unit 41, that reflects light that has passed through the above described first photoelectric conversion unit 41 back to the above described first photoelectric conversion unit 41, and a first output unit 106 that outputs electric charge generated by the above described first photoelectric conversion unit 41; and a second pixel 13 including a second photoelectric conversion unit 41 that photoelectrically converts incident light and generates electric charge, a second reflective unit 42B, provided at a second distance, different from the above described first distance, from the center of the above described second photoelectric conversion unit 41, that reflects light that has passed through the above described second photoelectric conversion unit 41 back to the above described second photoelectric conversion unit 41, and a second output unit 106 that outputs electric charge generated by the above described second photoelectric conversion unit 41.
(26) The image sensor as in (25), wherein the above described first reflective unit 42A is provided at the above described first distance from the center of the above described first photoelectric conversion unit 41 in a plane (for example, the XY plane) intersecting the direction of light incidence, and the above described second reflective unit 42B is provided at the above described second distance from the center of the above described second photoelectric conversion unit 41 in that plane (for example, the XY plane) intersecting the direction of light incidence.
(27) The image sensor as in (25) or (26), wherein the center of the above described first reflective unit 42A is provided at the above described first distance from the center of the above described first photoelectric conversion unit 41, and the center of the above described second reflective unit 42B is provided at the above described second distance from the center of the above described second photoelectric conversion unit 41.
(28) The image sensor as in any one of (22) through (27), wherein the above described first distance and the above described second distance differ according to their positions upon the above described image sensor (for example, their distances from the center of its image formation surface (i.e. the image height)).
(29) The image sensor as in any one of (22) through (28), wherein the difference between the above described first distance of the first pixel 11 of the center of the above described image sensor and the above described second distance of the above described second pixel 13 is smaller than the difference between the above described first distance of the above described first pixel 11 of the edge of the above described image sensor and the above described second distance of the above described second pixel 13.
(30) The image sensor as in any one of (22) through (29), wherein the above described first output unit 106 is provided remote from the optical path along which light that has passed through the above described first photoelectric conversion unit 41 is incident upon the above described first reflective unit 42A, and the above described second output unit 106 is provided remote from the optical path along which light that has passed through the above described second photoelectric conversion unit is incident upon the above described second reflective unit 42B. Due to this, the balance of the amounts of electric charge generated by the first pixel 11 and the second pixel 13 is preserved, so that it is possible to perform pupil-split type phase difference detection with good accuracy.
(31) The image sensor as in any one of (22) through (30), wherein: the above described first reflective unit 41A is provided in a region toward a first direction among regions subdivided by a line in a plane (for example, the XY plane) intersecting the direction in which light is incident and parallel to a line passing through the center of the above described first photoelectric conversion unit 41; the above described first output unit 106 is provided in the above described region toward the above described first direction among the above described regions subdivided by the above described line in the above described plane (for example, the XY plane) intersecting the direction in which light is incident and parallel to the above described line passing through the center of the above described first photoelectric conversion unit 41; the above described second reflective unit 42B is provided in a region toward a second direction among regions subdivided by a line in a plane (for example, the XY plane) intersecting the direction in which light is incident and parallel to a line passing through the center of the above described second photoelectric conversion unit 41; and the above described second output unit 106 is provided in the above described region toward the above described second direction among the above described regions subdivided by the above described line in the above described plane (for example, the XY plane) intersecting the direction in which light is incident and parallel to the above described line passing through the center of the above described second photoelectric conversion unit 41. Since, in the first pixel 11 and the second pixel 13, the output units 106 and the reflective units 42A (42B) are provided in regions toward the same direction (in other words, are all provided within the optical path of the output units 106), accordingly it is possible to preserve the balance of the amounts of electric charge generated by the first pixel 11 and the second pixel 13. Due to this, it is possible to perform pupil-split type phase difference detection with good accuracy.
(32) The image sensor as in any one of (22) through (30), wherein: the above described first reflective unit 42A is provided in a region toward a first direction among regions subdivided by a line in a plane (for example, the XY plane) intersecting the direction in which light is incident and parallel to a line passing through the center of the above described first photoelectric conversion unit 41; the above described first output unit 106 is provided in a region in the direction opposite to the above described first direction among the above described regions subdivided by the above described line in the above described plane (for example, the XY plane) intersecting the direction in which light is incident and parallel to the above described line passing through the center of the above described first photoelectric conversion unit 41; the above described second reflective unit 42B is provided in a region toward a second direction among regions subdivided by a line in a plane (for example, the XY plane) intersecting the direction in which light is incident and parallel to a line passing through the center of the above described second photoelectric conversion unit 41; and the above described second output unit 106 is provided in a region toward the above described first direction among regions subdivided by the above described line in the above described plane (for example, the XY plane) intersecting the direction in which light is incident and parallel to the above described line passing through the center of the above described second photoelectric conversion unit 41. Since, in the first pixel 11 and the second pixel 13, the reflective unit 42A and the output unit 106, and the reflective unit 42B and the output unit 106, are provided in regions on opposite sides (in other words, are all provided remote from the optical path of the output units 106), accordingly it is possible to preserve the balance of the amounts of electric charge generated by the first pixel 11 and the second pixel 13. Due to this, it is possible to perform pupil-split type phase difference detection with good accuracy.
(33) The image sensor as in any one of (22) through (32), wherein the above described first pixel 11 includes a first accumulation unit (the FD region 47) that accumulates electric charge generated by the above described first photoelectric conversion unit 41, the above described second pixel 13 includes a second accumulation unit (the FD region 47) that accumulates electric charge generated by the above described second photoelectric conversion unit 41, the above described first output unit 106 includes a first transfer unit (i.e. a transfer transistor) that transfers electric charge to the above described first accumulation unit (the FD region 47), and the above described second output unit 106 inludes a second transfer unit (i.e. a transfer transistor) that transfers electric charge to the above described second accumulation unit (the FD region 47). Due to this, it is possible to preserve the balance of the amounts of electric charge generated by the first pixel 11 and the second pixel 13 in either case, i.e. when the transfer transistors are disposed upon the optical paths along which light is incident or when the transfer transistors are disposed remote from the optical paths along which light is incident. And, due to this, it is possible to perform pupil-split type phase difference detection with good accuracy.
(34) The image sensor as in (33), wherein the above described first output unit 106 includes an electrode 48 of the above described first transfer unit, and the above described second output unit 106 includes an electrode 48 of the above described second transfer unit. Due to this, it is possible to preserve the balance of the amounts of electric charge generated by the first pixel 11 and the second pixel 13 in either case, i.e. when the gate electrodes of the transfer transistors are disposed upon the optical paths along which light is incident or when the gate electrodes of the transfer transistors are disposed remote from the optical paths along which light is incident. And, due to this, it is possible to perform pupil-split type phase difference detection with good accuracy.
(35) The image sensor as in any one of (22) through (32), wherein the above described first output unit 106 functions as a discharge unit that discharges electric charge generated by the above described first photoelectric conversion unit 41, and the above described second output unit 106 functions as a discharge unit that discharges electric charge generated by the above described second photoelectric conversion unit 41. In other words, the above described first and second output units 106 could also include reset transistors that discharge the electric charges that have been generated. Due to this, it is possible to preserve the balance of the amounts of electric charge generated by the first pixel 11 and the second pixel 13 in either case, i.e. when the reset transistors are disposed upon the optical paths along which light is incident or when the reset transistors are disposed remote from the optical paths along which light is incident. And, due to this, it is possible to perform pupil-split type phase difference detection with good accuracy.
(36) The image sensor as in any one of (22) through (32), wherein: the above described first pixel 11 includes a first accumulation unit (the FD region 47) that accumulates electric charge generated by the above described first photoelectric conversion unit 41; the above described second pixel 13 includes a second accumulation unit (the FD region 47) that accumulates electric charge generated by the above described second photoelectric conversion unit 41; the above described first output unit 106 outputs a signal based upon the voltage of the above described first accumulation unit (the FD region 47); and the above described second output unit 106 outputs a signal based upon the voltage of the above described second accumulation unit (the FD region 47). In other words, the above described first and second output units 106 may include amplification transistors or selection transistors. Due to this, it is possible to preserve the balance of the amounts of electric charge generated by the first pixel 11 and the second pixel 13 in either case, i.e. when the amplification transistors and the selection transistors are disposed upon the optical paths along which light is incident or when the amplification transistors and the selection transistors are disposed remote from the optical paths along which light is incident. And, due to this, it is possible to perform pupil-split type phase difference detection with good accuracy.
(37) The image sensor as in any one of (22) through (36), wherein the area of the above described first reflective unit 42A is the same as the area of the above described second reflective unit 42B.
(38) The image sensor as in any one of (22) through (36), wherein the area of the above described first reflective unit 42A and the area of the above described second reflective unit 42B are different.
(39) An image sensor, including: a first pixel including a first photoelectric conversion unit that photoelectrically converts light that has passed through a first micro lens and generates electric charge, a first reflective unit that reflects light that has passed through the above described first photoelectric conversion unit back to the above described first photoelectric conversion unit, and a first output unit that is provided remote from the optical path along which light that has passed through the above described first photoelectric conversion unit is incident upon the above described first reflective unit, and that outputs electric charge generated by the above described first photoelectric conversion unit; and a second pixel including a second photoelectric conversion unit that photoelectrically converts light that has passed through a second micro lens and generates electric charge, a second reflective unit that reflects light that has passed through the above described second photoelectric conversion unit back to the above described second photoelectric conversion unit, and a second output unit that is provided remote from the optical path along which light that has passed through the above described second photoelectric conversion unit is incident upon the above described second reflective unit, and that outputs electric charge generated by the above described second photoelectric conversion unit.
(40) A focus adjustment device including an image sensor as in any one of (22) through (39), and a lens control unit 32 that adjusts the focused position of an imaging optical system 31 on the basis of a signal based upon electric charge outputted from the above described first output unit 106, and a signal based upon electric charge outputted from the above described second output unit 106.

Furthermore, image sensors and focus detection devices of the following types are also included in the second embodiment and in the variant embodiments of the second embodiment.
(1) An image sensor, including a plurality of pixels 11p, 11s, 11q (13p, 13s, 13q) each including: a photoelectric conversion unit 41 that photoelectrically converts incident light and generates electric charge; a reflective unit 42AP, 42AS, 42AQ that reflects light that has passed through the above described photoelectric conversion unit 41 back to the above described photoelectric conversion unit 41; and an output unit 106 that outputs electric charge generated by the above described photoelectric conversion unit 41; wherein the areas of the reflective units 42AP, 42AS, 42AQ (42BP, 42BS, 42BQ) respectively possessed by the above described plurality of pixels 11p, 11s, 11q (13p, 13s, 13q) vary.
(2) The image sensor as in (1), wherein, in a plane (for example, the XY plane) intersecting the direction of light incidence, the areas of the reflective units 42AP, 42AS, 42AQ (42BP, 42BS, 42BQ) respectively possessed by the above described plurality of pixels 11p, 11s, 11q (13p, 13s, 13q) vary.
(3) The image sensor as in (1) or (2), wherein the areas of the reflective units 42AP, 42AS, 42AQ (42BP, 42BS, 42BQ) respectively possessed by the above described plurality of pixels 11p, 11s, 11q (13p, 13s, 13q) vary according to their positions upon the above described image sensor (for example, according to their distances from the center of its image formation surface (i.e. the image height)).
(4) An image sensor, including a plurality of pixels each including: a photoelectric conversion unit that photoelectrically converts incident light and generates electric charge; a reflective unit that reflects light that has passed through the above described photoelectric conversion unit back to the above described photoelectric conversion unit; and an output unit that outputs electric charge generated by the above described photoelectric conversion unit; wherein the widths in a direction intersecting the direction of light incidence of the reflective units respectively possessed by the above described plurality of pixels vary.
(5) The image sensor as in (4), wherein the widths of the reflective units respectively possessed by the above described plurality of pixels vary according to their positions upon the above described image sensor.
(6) The image sensor as in any one of (1) through (5), wherein the positions with respect to the above described photoelectric conversion units 41 in a plane (for example, the XY plane) intersecting the direction of light incidence of the reflective units 42AP, 42AS, 42AQ (42BP, 42BS, 42BQ) respectively possessed by the above described plurality of pixels 11p, 11s, 11q (13p, 13s, 13q) vary.
(7) The image sensor as in any one of (1) through (5), wherein the positions with respect to the above described photoelectric conversion units 41 in a plane (for example, the XY plane) intersecting the direction of light incidence of the reflective units 42AP, 42AS, 42AQ (42BP, 42BS, 42BQ) respectively possessed by the above described plurality of pixels 11p, 11s, 11q (13p, 13s, 13q) are the same.
(8) The image sensor as in any one of (1) through (5), wherein each of the above described plurality of pixels 11p, 11s, 11q (13p, 13s, 13q) includes a micro lens 40, and the positions with respect to the optical axes (the lines CL) of the above described micro lenses 40 in a plane (for example, the XY plane) intersecting the direction of light incidence of the reflective units 42AP, 42AS, 42AQ (42BP, 42BS, 42BQ) respectively possessed by the above described plurality of pixels 11p, 11s, 11q (13p, 13s, 13q) vary.
(9) The image sensor as in any one of (1) through (5), wherein each of the above described plurality of pixels 11p, 11s, 11q (13p, 13s, 13q) includes a micro lens 40, and the positions with respect to the optical axes (the lines CL) of the above described micro lenses 40 in a plane (for example, the XY plane) intersecting the direction of light incidence of the reflective units 42AP, 42AS, 42AQ (42BP, 42BS, 42BQ) respectively possessed by the above described plurality of pixels 11p, 11s, 11q (13p, 13s, 13q) are the same.
(10) The image sensor as in any one of (1) through (5), wherein each of the above described plurality of pixels 11p, 11s, 11q (13p, 13s, 13q) includes a micro lens 40, and the distances from the optical axes (the lines CL) of the above described micro lenses 40 in a plane intersecting the direction of light incidence of the reflective units 42AP, 42AS, 42AQ (42BP, 42BS, 42BQ) respectively possessed by the above described plurality of pixels 11p, 11s, 11q (13p, 13s, 13q) vary.
(11) The image sensor as in any one of (1) through (5), wherein each of the above described plurality of pixels 11p, 11s, 11q (13p, 13s, 13q) includes a micro lens 40, and the distances from the optical axes (the lines CL) of the above described micro lenses 40 in a plane (for example, the XY plane) intersecting the direction of light incidence of the reflective units 42AP, 42AS, 42AQ (42BP, 42BS, 42BQ) respectively possessed by the above described plurality of pixels 11p, 11s, 11q (13p, 13s, 13q) are the same.
(12) A focus adjustment device, including: an image sensor as in any one of (1) through (11), and a lens control unit 32 that adjusts the focused position of the imaging optical system 31 from a signal based upon electric charge outputted from the above described output unit 106.
(13) An image sensor, including: a first pixel 11 including: a first photoelectric conversion unit 41 that photoelectrically converts incident light and generates electric charge; a first reflective unit 42A, having a first area, that reflects light that has passed through the above described first photoelectric conversion unit back to the above described first photoelectric conversion unit; and a first output unit 106 that outputs electric charge generated by the above described first photoelectric conversion unit 41; and a second pixel including: a second photoelectric conversion unit 41 that photoelectrically converts incident light and generates electric charge; a second reflective unit 42B, having a second area different from the above described first area, that reflects light that has passed through the above described second photoelectric conversion unit 41 back to the above described second photoelectric conversion unit 41; and a second output unit that outputs electric charge generated by photoelectric conversion by the above described second photoelectric conversion unit of light reflected by the above described second reflective unit.
(14) The image sensor as in (13), wherein the above described first reflective unit 42A has the above described first area in a plane (for example, the XY plane) intersecting the direction of light incidence, and the above described second reflective unit 42B has the above described second area in a plane intersecting the direction of light incidence.
(15) The image sensor as in (13 or (14), wherein the above described first area and the above described second area differ according to their positions upon the above described image sensor (for example, their distances from the center of its image formation surface (i.e. the image height)).
(16) The image sensor as in any one of (13) through (15), wherein the difference between the above described first area of the above described first pixel 11 and the above described second area of the above described second pixel 13 at the center of the above described image sensor is smaller than the difference between the above described first area of the above described first pixel 11 and the above described second area of the above described second pixel 13 at the edge of the above described image sensor.
(17)The image sensor as in any one of (13) through (16), wherein: the above described first pixel 11 includes a first micro lens 40; the above described second pixel 13 includes a second micro lens 40; and the distance between the optical axis (the line CL) of the above described first micro lens 40 and the above described first reflective unit 42A is different from the distance between the optical axis (the line CL) of the above described second micro lens 40 and the above described second reflective unit 42B.
(18) An image sensor including: a first pixel including: a first photoelectric conversion unit that photoelectrically converts incident light and generates electric charge; a first reflective unit that is provided with a first width in a direction intersecting the direction of light incidence, and that reflects light that has passed through the above described first photoelectric conversion unit back to the above described first photoelectric conversion unit; and a first output unit that outputs electric charge generated by the above described first photoelectric conversion unit; and a second pixel including: a second photoelectric conversion unit that photoelectrically converts incident light and generates electric charge; a second reflective unit that is provided with a second width, which is different from the above described first width, in a direction intersecting the direction of light incidence, and that reflects light that has passed through the above described second photoelectric conversion unit back to the above described second photoelectric conversion unit; and a second output unit that outputs electric charge generated by the above described second photoelectric conversion unit by photoelectric conversion of light reflected by the above described second reflective unit.
(19) The image sensor as in (18), wherein the above described first pixel includes a first micro lens, the above described second pixel includes a second micro lens, the above described first reflective unit is provided with a width that reflects light incident at a first angle with respect to the optical axis of the above described first micro lens back toward the above described first photoelectric conversion unit, and the above described second reflective unit is provided with a width that reflects light incident at a second angle, which is different from the above described first angle, with respect to the optical axis of the above described second micro lens back toward the above described second photoelectric conversion unit.
(20) The image sensor as in any one of (13) through (15), wherein the above described first pixel includes a first micro lens, the above described second pixel includes a second micro lens, and the distance between the optical axis of the above described first micro lens and the above described first reflective unit is different from the distance between the optical axis of the above described second micro lens and the above described second reflective unit.
(21) The image sensor as in any one of (13) through (15), wherein the above described first pixel 11 includes a first micro lens 40, the above described second pixel 13 includes a second micro lens 40, and the distance between the optical axis (the line CL) of the above described first micro lens 40 and the above described first reflective unit 42A is the same as the distance between the optical axis (the line CL) of the above described second micro lens 40 and the above described second reflective unit 42B.
(22) The image sensor as in any one of (13) through (21), wherein the distance between the center of the above described first photoelectric conversion unit 41 and the above described first reflective unit 42A is different from the distance between the center of the above described second photoelectric conversion unit 41 and the above described second reflective unit 42B.
(23) The image sensor as in any one of (13) through (21), wherein the distance between the center of the above described first photoelectric conversion unit 41 and the above described first reflective unit 42A is the same as the distance between the center of the above described second photoelectric conversion unit 41 and the above described second reflective unit 42B.
(24) A focus adjustment device, including an image sensor as in any one of (13) through (23), and a lens control unit 32 that adjusts the focused position of an imaging optical system 31 on the basis of a signal based upon electric charge outputted from the above described first output unit 106 and a signal based upon electric charge outputted from the above described second output unit 106.

While various embodiments and variant embodiments have been explained above, the present invention is not to be considered as being limited to the details thereof. Other variations that are considered to come within the range of the technical concept of the present invention are also included within the scope of the present invention.

The content of the disclosure of the following application, upon which priority is claimed, is hereby installed herein by reference.

Japanese Patent Application 2016-194623 (filed on September 30, 2016).

### REFERENCE SIGNS LIST

1: camera
2: camera body
3: interchangeable lens
12: imaging pixel
11, 11s, 11p, 11q, 13, 13s, 13p, 13q: first focus detection pixels
14, 14s, 14p, 14q, 15, 15s, 15p, 15q: second focus detection pixels
21: body control unit
21a: focus detection unit
22: image sensor
31: imaging optical system
40: micro lens
41: photoelectric conversion unit
42A, 42AS, 42AP, 42AQ, 42B, 42BS, 42BP, 42BQ: reflective units
43: color filter
44A, 44AS, 44AP, 44AQ, 44B, 44BS, 44BP, 44BQ: light interception units
51, 52: optical characteristic adjustment layers
60: exit pupil
61: first pupil region
62: second pupil region
401, 401S, 401P, 401Q, 402, 402S, 402P, 402Q: pixel rows
CL: center line of micro lens
CS: center line of photoelectric conversion unit

## Claims

1. An image sensor, comprising a plurality of pixels each comprising:
a photoelectric conversion unit that photoelectrically converts incident light and generates electric charge;
a reflective unit that reflects light that has passed through the photoelectric conversion unit back to the photoelectric conversion unit; and
an output unit that outputs the electric charge generated by the photoelectric conversion unit, wherein:
a position of the reflective unit possessed by each of the plurality of pixels varies.

2. The image sensor according to claim 1, wherein:
the position of the reflective unit possessed by each of the plurality of pixels with respect to the photoelectric conversion unit varies.

3. The image sensor according to claim 2, wherein:
the position of the reflective unit possessed by each of the plurality of pixels with respect to the photoelectric conversion unit varies in a plane intersecting a direction of light incidence.

4. The imaging unit according to claim 2 or claim 3, wherein:
the position of the reflective unit possessed by each of the plurality of pixels with respect to the photoelectric conversion unit varies according to a position upon the image sensor.

5. The image sensor according to claim 1, wherein:
each of the plurality of pixels comprises a micro lens; and
the position of the reflective unit possessed by each of the plurality of pixels with respect to an optical axis of the micro lense varies.

6. The image sensor according to claim 5, wherein:
the reflective unit possessed by each of the plurality of pixels is provided in a position so that the reflective unit reflects incident light that is slanting with respect to the optical axis of the micro lens toward the photoelectric conversion unit.

7. The imaging unit according to claim 5 or claim 6, wherein:
the position of the reflective unit possessed by each of the plurality of pixels with respect to the optical axis of the micro lense varies upon a plane intersecting a direction of light incidence.

8. The image sensor according to any one of claims 5 through 7, wherein:
the position of the reflective unit possessed by each of the plurality of pixels with respect to the optical axis of the micro lens varies according to a position upon the image sensor.

9. The image sensor according to claim 1, wherein:
each of the plurality of pixels includes a micro lens; and
a distance of the reflective unit possessed by each of the plurality of pixels from the optical axis of the micro lense varies.

10. The image sensor according to claim 9, wherein:
the distance of the reflective unit possessed by each of the plurality of pixels from the optical axis of the micro lenses upon a plane intersecting the direction of light incidence varies.

11. The imaging unit according to claim 9 or claim 10, wherein:
the distance of the reflective unit possessed by each of the plurality of pixels from the optical axis of the micro lenses varies according to a position upon the image sensor.

12. The image sensor according to any one of claims 1 through 11, wherein:
an area of the reflective unit possessed by each of the plurality of pixels is the same.

13. The image sensor according to any one of claims 1 through 12, wherein:
an area of the reflective unit possessed by each of the plurality of pixels varies.

14. The image sensor according to any one of claims 1 through 13, wherein:
the output unit possessed by each of the plurality of pixels is provided outside an optical path along which light that has passed through the photoelectric conversion unit is incident upon the reflective unit.

15. The image sensor according to any one of claims 1 through 14, further comprising:
an accumulation unit that accumulates electric charge generated by the photoelectric conversion unit, wherein:
the output unit is a transfer unit that transfers electric charge to the accumulation unit.

16. The image sensor according to claim 15, wherein:
the output unit is an electrode of the transfer unit.

17. The image sensor according to any one of claims 1 through 14, wherein:
the output unit is a discharge unit that discharges electric charge generated by the photoelectric conversion unit.

18. The image sensor according to any one of claims 1 through 14, further comprising:
an accumulation unit that accumulates electric charge generated by the photoelectric conversion unit, wherein:
the output unit outputs a signal based upon a voltage of the accumulation unit.

19. An image sensor comprising a plurality of pixels each comprising:
a photoelectric conversion unit that photoelectrically converts incident light and generates electric charge;
a reflective unit that reflects light that has passed through the photoelectric conversion unit back to the photoelectric conversion unit; and
an output unit that is provided outside an optical path along which light that has passed through the photoelectric conversion unit is incident upon the reflective unit, and that outputs electric charge generated by the photoelectric conversion unit.

20. A focus adjustment device, comprising:
an image sensor according to any one of claims 1 through 19; and
an adjustment unit that adjusts a focused position of an imaging optical system from a signal based upon electric charge outputted from the output unit.

21. An image sensor comprising:
a first pixel including
a first photoelectric conversion unit that photoelectrically converts light that has passed through a first micro lens and generates electric charge,
a first reflective unit, provided at a first distance from an optical axis of the first micro lens in a direction that intersects the optical axis, and that reflects light that has passed through the first photoelectric conversion unit back to the first photoelectric conversion unit,
a first output unit that outputs electric charge generated by the first photoelectric conversion unit; and
a second pixel including
a second photoelectric conversion unit that photoelectrically converts light that has passed through a second micro lens and generates electric charge,
a second reflective unit provided at a second distance, that is different from the first distance, from an optical axis of the second micro lens in a direction intersecting the optical axis, and that reflects light that has passed through the second photoelectric conversion unit back to the second photoelectric conversion unit, and
a second output unit that outputs electric charge generated by the second photoelectric conversion unit.

22. The image sensor according to claim 21, wherein:
the first reflective unit is provided at the first distance from the optical axis of the first micro lens in a plane that intersects a direction of light incidence; and
the second reflective unit is provided at the second distance from the optical axis of the second micro lens in a plane that intersects a direction of light incidence.

23. The imaging unit according to claim 21 or claim 22, wherein:
a center of the first reflective unit is provided at the first distance from the optical axis of the first micro lens; and
a center of the second reflective unit is provided at the second distance from the optical axis of the second micro lens.

24. The image sensor according to any one of claims 21 through 23, wherein:
the first reflective unit is provided in a position in which the first reflective unit reflects light incident at a first angle with respect to the optical axis of the first micro lens toward the first photoelectric conversion unit; and
the second reflective unit is provided in a position in which the second reflective unit reflects light incident at a second angle, which is different from the first angle, with respect to the optical axis of the second micro lens toward the second photoelectric conversion unit.

25. An image sensor, comprising:
a first pixel including
a first photoelectric conversion unit that photoelectrically converts incident light and generates electric charge,
a first reflective unit, provided at a first distance from a center of the first photoelectric conversion unit, and that reflects light that has passed through the first photoelectric conversion unit back to the first photoelectric conversion unit, and
a first output unit that outputs electric charge generated by the first photoelectric conversion unit; and
a second pixel including
a second photoelectric conversion unit that photoelectrically converts incident light and generates electric charge,
a second reflective unit, provided at a second distance, which is different from the first distance, from a center of the second photoelectric conversion unit, and that reflects light that has passed through the second photoelectric conversion unit back to the second photoelectric conversion unit, and
a second output unit that outputs electric charge generated by the second photoelectric conversion unit.

26. The image sensor according to claim 25, wherein:
the first reflective unit is provided at the first distance from the center of the first photoelectric conversion unit in a plane intersecting a direction of light incidence; and
the second reflective unit is provided at the second distance from the center of the second photoelectric conversion unit in a plane intersecting a direction of light incidence.

27. The imaging unit according to claim 25 or claim 26, wherein:
a center of the first reflective unit is provided at the first distance from the center of the first photoelectric conversion unit; and
a center of the second reflective unit is provided at the second distance from the center of the second photoelectric conversion unit.

28. The image sensor according to any one of claims 22 through 27, wherein:
the first distance and the second distance differ according to a position upon the image sensor.

29. The image sensor according to any one of claims 22 through 28, wherein:
a difference between the first distance of the first pixel and the second distance of the second pixel at a center of the image sensor is smaller than a difference between the first distance of the first pixel and the second distance of the second pixel at an edge of the image sensor.

30. The image sensor according to any one of claims 22 through 29, wherein:
the first output unit is provided outside an optical path along which light that has passed through the first photoelectric conversion unit is incident upon the first reflective unit; and
the second output unit is provided outside an optical path along which light that has passed through the second photoelectric conversion unit is incident upon the second reflective unit.

31. The image sensor according to any one of claims 22 through 30, wherein:
the first reflective unit is provided in a region toward a first direction among regions subdivided by a line, which is parallel to a line passing through a center of the first photoelectric conversion unit, in a plane intersecting a direction in which light is incident;
the first output unit is provided in a region toward the first direction among the regions subdivided by the line, which is parallel to the line passing through the center of the first photoelectric conversion unit, in a plane intersecting a direction in which light is incident;
the second reflective unit is provided in a region toward a second direction among regions subdivided by a line, which is parallel to a line passing through a center of the second photoelectric conversion unit, in a plane intersecting a direction in which light is incident; and
the second output unit is provided in a region toward the second direction among the regions subdivided by the line, which is parallel to the line passing through the center of the second photoelectric conversion unit, in a plane intersecting a direction in which light is incident.

32. The image sensor according to any one of claims 22 through 30, wherein:
the first reflective unit is provided in a region toward a first direction among regions subdivided by a line, which is parallel to a line passing through a center of the first photoelectric conversion unit, in a plane intersecting a direction in which light is incident;
the first output unit is provided in a region in a direction opposite to the first direction among the regions subdivided by the line, which is parallel to the line passing through the center of the first photoelectric conversion unit, in a plane intersecting a direction in which light is incident;
the second reflective unit is provided in a region toward a second direction among regions subdivided by a line, which is parallel to a line passing through a center of the second photoelectric conversion unit, in a plane intersecting a direction in which light is incident and; and
the second output unit is provided in a region toward the first direction among the regions subdivided by the line, which is parallel to the line passing through the center of the second photoelectric conversion unit, in a plane intersecting a direction in which light is incident.

33. The image sensor according to any one of claims 22 through 32, wherein:
the first pixel comprises a first accumulation unit that accumulates electric charge generated by the first photoelectric conversion unit;
the second pixel comprises a second accumulation unit that accumulates electric charge generated by the second photoelectric conversion unit;
the first output unit is a first transfer unit that transfers electric charge to the first accumulation unit; and
the second output unit is a second transfer unit that transfers electric charge to the second accumulation unit.

34. The image sensor according to claim 33, wherein:
the first output unit is an electrode of the first transfer unit; and
the second output unit is an electrode of the second transfer unit.

35. The image sensor according to any one of claims 22 through 32, wherein:
the first output unit is a discharge unit that discharges electric charge generated by the first photoelectric conversion unit; and
the second output unit is a discharge unit that discharges electric charge generated by the second photoelectric conversion unit.

36. The image sensor according to any one of claims 22 through 32, wherein:
the first pixel comprises a first accumulation unit that accumulates electric charge generated by the first photoelectric conversion unit;
the second pixel comprises a second accumulation unit that accumulates electric charge generated by the second photoelectric conversion unit;
the first output unit outputs a signal based upon a voltage of the first accumulation unit; and
the second output unit outputs a signal based upon a voltage of the second accumulation unit.

37. The image sensor according to any one of claims 22 through 36, wherein:
an area of the first reflective unit is the same as an area of the second reflective unit.

38. The image sensor according to any one of claims 22 through 36, wherein:
an area of the first reflective unit and an area of the second reflective unit are different.

39. An image sensor, comprising:
a first pixel comprising
a first photoelectric conversion unit that photoelectrically converts light that has passed through a first micro lens and generates electric charge,
a first reflective unit that reflects light that has passed through the first photoelectric conversion unit back to the first photoelectric conversion unit, and
a first output unit that is provided outside an optical path along which light that has passed through the first photoelectric conversion unit is incident upon the first reflective unit, and that outputs electric charge generated by the first photoelectric conversion unit; and
a second pixel comprising
a second photoelectric conversion unit that photoelectrically converts light that has passed through a second micro lens and generates electric charge,
a second reflective unit that reflects light that has passed through the second photoelectric conversion unit back to the second photoelectric conversion unit, and
a second output unit that is provided outside an optical path along which light that has passed through the second photoelectric conversion unit is incident upon the second reflective unit, and that outputs electric charge generated by the second photoelectric conversion unit.

40. A focus adjustment device, comprising:
an image sensor according to any one of claims 21 through 39; and
an adjustment unit that adjusts a focused position of an imaging optical system based upon a signal based upon electric charge outputted from the first output unit, and a signal based upon electric charge outputted from the second output unit.
